# EUROPEAN PATENT SPECIFICATION

(11) **EP 4 398 698 B1**
(45) Date of publication and mention of the grant of the patent: **18.02.2026**
(21) Application number: 23218977.9
(22) Date of filing: 21.12.2023
(51) Int. Cl.: H10K 85/30, H10K 85/40, H10K 50/165, H10K 50/11, H10K 50/19

(54) **ORGANIC LIGHT-EMITTING DEVICE AND ELECTRONIC APPARATUS INCLUDING THE SAME**
ORGANISCHE LICHTEMITTIERENDE VORRICHTUNG UND ELEKTRONISCHE VORRICHTUNG DAMIT
DISPOSITIF ÉLECTROLUMINESCENT ORGANIQUE ET APPAREIL ÉLECTRONIQUE LE COMPRENANT

(30) Priority: 28.12.2022 KR 20220187752
(43) Date of publication of application: 10.07.2024
(73) Proprietor: Samsung Display Co., Ltd., Yongin-si, Gyeonggi-do 17113 (KR)
(72) Inventor: LEE, Sunghun, 16678 Suwon-si (KR); SIM, Myungsun, 16678 Suwon-si (KR); JUNG, Kijung, 16678 Suwon-si (KR); CHO, Yongsuk, 16678 Suwon-si (KR); CHOI, Jongwon, 16678 Suwon-si (KR); KOISHIKAWA, Yasushi, 16678 Suwon-si (KR); HONG, Sunghun, 16678 Suwon-si (KR)
(74) Representative: Elkington and Fife LLP

(56) References cited:
- DE-A1- 102022 113 418
- US-A1- 2011 210 323
- US-A1- 2020 313 098

## Description

### FIELD OF THE INVENTION

The present subject matter relates to an organic light-emitting device and an electronic apparatus including the same.

### BACKGROUND OF THE INVENTION

Organic light-emitting devices (OLEDs) are self-emissive devices, which have improved characteristics in terms of viewing angles, response time, brightness, driving voltage, and response speed. In addition, OLEDs can produce full-color images.

A typical organic light-emitting device includes an anode, a cathode, and an organic layer arranged between the anode and the cathode and including an emission layer. A hole transport region may be arranged between the anode and the emission layer, and an electron transport region may be arranged between the emission layer and the cathode. Holes provided from the anode may move toward the emission layer through the hole transport region, and electrons provided from the cathode may move toward the emission layer through the electron transport region. The holes and the electrons may then recombine in the emission layer to produce excitons. The excitons may transition from an excited state to a ground state, thus generating light. US2020/313098 A1 and DE102022113418 A1 disclose OLEDs comprising an organometallic compound having a silyl group in the light-emitting layer.

### SUMMARY OF THE INVENTION

Provided are an organic light-emitting device having a high luminescence efficiency, a high color purity, a long lifespan, and excellent processability, and an electronic apparatus including the organic light-emitting device.

Additional aspects will be set forth in part in the detailed description that follows and, in part, will be apparent from the detailed description, or may be learned by practice of the presented exemplary embodiments provided herein.

According to the invention,
a light-emitting device includes:
an anode, a cathode, and
an organic layer arranged between the anode and the cathode,
wherein the organic layer includes an emission layer and an n-doped layer,
the n-doped layer is arranged between the anode and the emission layer,
the emission layer includes at least one organometallic compound, and
the at least one organometallic compound includes at least one silyl group or at least one germyl group.

According to another aspect, an electronic apparatus includes the organic light-emitting device.

### BRIEF DESCRIPTION OF THE DRAWING

The above and other aspects, features, and advantages of certain exemplary embodiments will be more apparent from the following detailed description taken in conjunction with the FIGURE, which shows a schematic cross-sectional view of an organic light-emitting device according to one or more embodiments.

### DETAILED DESCRIPTION OF THE EMBODIMENTS

Reference will now be made in further detail to exemplary embodiments, examples of which are illustrated in the accompanying drawing, wherein like reference numerals refer to like elements throughout. In this regard, the present exemplary embodiments may have different forms and should not be construed as being limited to the detailed descriptions set forth herein. Accordingly, the exemplary embodiments are merely described in further detail below, and by referring to the figure, to explain certain aspects and features. As used herein, the term "and/or" includes any and all combinations of one or more of the associated listed items. Expressions such as "at least one of," when preceding a list of elements, modify the entire list of elements and do not modify the individual elements of the list.

The terminology used herein is for the purpose of describing one or more exemplary embodiments only and is not intended to be limiting. As used herein, the singular forms "a," "an," and "the" are intended to include the plural forms as well, unless the context clearly indicates otherwise. The term "or" means "and/or." It will be further understood that the terms "comprises" and/or "comprising," or "includes" and/or "including" when used in this specification, specify the presence of stated features, regions, integers, steps, operations, elements, and/or components, but do not preclude the presence or addition of one or more other features, regions, integers, steps, operations, elements, components, and/or groups thereof.

**It** will be understood that, although the terms first, second, third etc. may be used herein to describe various elements, components, regions, layers, and/or sections, these elements, components, regions, layers, and/or sections should not be limited by these terms. These terms are only used to distinguish one element, component, region, layer, or section from another element, component, region, layer, or section. Thus, a first element, component, region, layer, or section discussed below could be termed a second element, component, region, layer, or section without departing from the teachings of the present embodiments.

Exemplary embodiments are described herein with reference to cross section illustrations that are schematic illustrations of idealized embodiments. As such, variations from the shapes of the illustrations as a result, for example, of manufacturing techniques and/or tolerances, are to be expected. Thus, embodiments described herein should not be construed as limited to the particular shapes of regions as illustrated herein but are to include deviations in shapes that result, for example, from manufacturing. For example, a region illustrated or described as flat may, typically, have rough and/or nonlinear features. Moreover, sharp angles that are illustrated may be rounded. Thus, the regions illustrated in the figures are schematic in nature and their shapes are not intended to illustrate the precise shape of a region and are not intended to limit the scope of the present claims.

**It** will be understood that when an element is referred to as being "on" another element, it can be directly in contact with the other element or intervening elements may be present therebetween. **In** contrast, when an element is referred to as being "directly on" another element, there are no intervening elements present.

Unless otherwise defined, all terms (including technical and scientific terms) used herein have the same meaning as commonly understood by one of ordinary skill in the art to which this general inventive concept belongs. **It** will be further understood that terms, such as those defined in commonly used dictionaries, should be interpreted as having a meaning that is consistent with their meaning in the context of the relevant art and the present disclosure, and will not be interpreted in an idealized or overly formal sense unless expressly so defined herein.

"About" or "approximately" as used herein is inclusive of the stated value and means within an acceptable range of deviation for the particular value as determined by one of ordinary skill in the art, considering the measurement in question and the error associated with measurement of the particular quantity (i.e., the limitations of the measurement system). For example, "about" can mean within one or more standard deviations, or within ± 30%, 20%, 10%, 5% of the stated value.

As used herein, an "energy level" (e.g., a highest occupied molecular orbital (HOMO) energy level or a triplet (T₁) energy level) is expressed as an absolute value from a vacuum level. In addition, when the energy level is referred to as being "deep," "high," or "large," the energy level has a large absolute value based on "0 electron Volts (eV)" of the vacuum level, and when the energy level is referred to as being "shallow," "low," or "small," the energy level has a small absolute value based on "0 eV" of the vacuum level.

As used herein, when a molecular fragment is described as being a substituent or otherwise attached to another moiety, its name may be written as if it were a fragment (for example, phenyl, naphthyl, or the like) or as if it were the whole molecule (for example, benzene, naphthalene, or the like). It is to be understood that the nomenclature may be used interchangeably herein.

According to the invention, an organic light-emitting device includes an anode and a cathode, and an organic layer arranged between the anode and the cathode,
wherein the organic layer includes an emission layer and an n-doped layer,
the n-doped layer is arranged between the anode and the emission layer,
the emission layer includes at least one organometallic compound, and
the at least one organometallic compound includes at least one silyl group or at least one germyl group.

The organic light-emitting device may have an excellent luminescence efficiency, a long lifespan, and/or a high color purity.

In general, an organic light-emitting device including at least one organometallic compound including a silyl group and/or a germyl group may have an excellent luminescence efficiency and a high color purity, and may have excellent processability due to a low deposition temperature. However, as the silyl group and/or the germyl group are decomposed and the organometallic compound is degraded, the lifespan may drastically decrease.

Although not limited to a particular theory, it is assumed that the organometallic compound may be degraded because the silyl group and/or the germyl group is decomposed by a cation formed from an anode of an organic light-emitting device.

In the organic light-emitting device according to one or more embodiments, the cation formed from the anode may be effectively removed or suppressed by a free electron formed from an n-doped layer, thereby preventing the silyl group and/or the germyl group of the organometallic compound from becoming decomposed. Accordingly, by including the at least one organometallic compound including the silyl group and/or the germyl group in the emission layer, the organic light-emitting device may achieve a high luminescence efficiency, a high color purity, and excellent processability, and the degradation of the organometallic compound may be prevented or reduced, to provide a high luminescence efficiency and/or a long lifespan.

### Organometallic compound in emission layer

In one or more embodiments, the at least one organometallic compound may be represented by Formula 1:

Formula 1 M₁(Ln₁)ₙ₁(Ln₂)ₙ₂

wherein M₁ in Formula 1 may be a transition metal.

In one or more embodiments, M₁ in Formula 1 may be iridium, platinum, osmium, titanium, zirconium, hafnium, europium, terbium, thulium, or rhodium.

n1 in Formula 1 may be 1, 2, or 3.

n2 in Formula 1 may be 0, 1, or 2.

In one or more embodiments, in Formula 1, M₁ may be iridium, and a sum of n1 and n2 may be 3; or M₁ may be Pt and the sum of n1 and n2 may be 2.

Ln₁ in Formula 1 may be a ligand represented by Formula 1A: 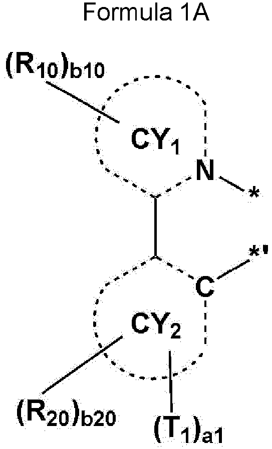 wherein * and *' each indicates a binding site to M₁ in Formula 1.

Ring CY₁ and ring CY₂ in Formula 1A may each independently be a C₅-C₃₀ carbocyclic group or a C₁-C₃₀ heterocyclic group.

T₁ in Formula 1A may be -Si(Q₁)(Q₂)(Q₃) or -Ge(Q₁)(Q₂)(Q₃).

a1 in Formula 1A may be 1, 2, 3, 4, or 5.

R₁₀ and R₂₀ in Formula 1A may each independently be hydrogen, deuterium, -F, -Cl, -Br, -I, -SF₅, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a substituted or unsubstituted C₁-C₆₀ alkyl group, a substituted or unsubstituted C₂-C₆₀ alkenyl group, a substituted or unsubstituted C₂-C₆₀ alkynyl group, a substituted or unsubstituted C₁-C₆₀ alkoxy group, a substituted or unsubstituted C₁-C₆₀ alkylthio group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₇-C₆₀ alkyl aryl group, a substituted or unsubstituted C₇-C₆₀ aryl alkyl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted C₁-C₆₀ heteroaryloxy group, a substituted or unsubstituted C₁-C₆₀ heteroarylthio group, a substituted or unsubstituted C₁-C₆₀ heteroaryloxy group, a substituted or unsubstituted C₁-C₆₀ heteroarylthio group, a substituted or unsubstituted monovalent non-aromatic condensed polycyclic group, a substituted or unsubstituted monovalent non-aromatic condensed heteropolycyclic group, -Si(Q₁)(Q₂)(Q₃), -Ge(Q₁)(Q₂)(Q₃), -C(=O)(Q₁), -S(=O)(Q₁), -S(=O)₂(Q₁), - N(Q₄)(Q₅), -B(Q₆)(Q₇), -P(Q₈)(Q₉), -P(=O)(Q₈)(Q₉), or -P(=S)(Q₈)(Q₉).

In one or more embodiments, R₁₀ and R₂₀ may each independently be hydrogen, deuterium, -F, a substituted or unsubstituted C₁-C₂₀ alkyl group, a substituted or unsubstituted C₃-C₁₀ cycloalkyl group, a substituted or unsubstituted C₁-C₁₀ heterocycloalkyl group, a substituted or unsubstituted C₆-C₁₀ aryl group, - Si(Q₁)(Q₂)(Q₃), or -Ge(Q₁)(Q₂)(Q₃).

In one or more embodiments, Ln₁ may be represented by one of Formulae 4-1 to 4-20: 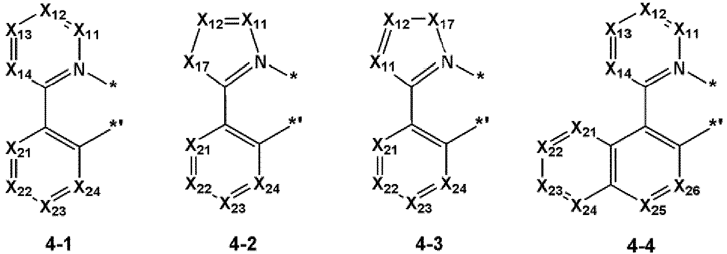 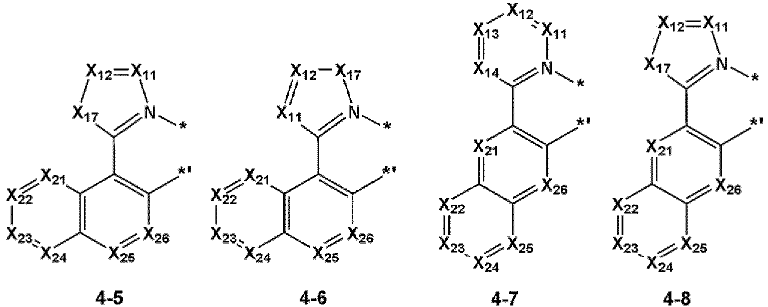 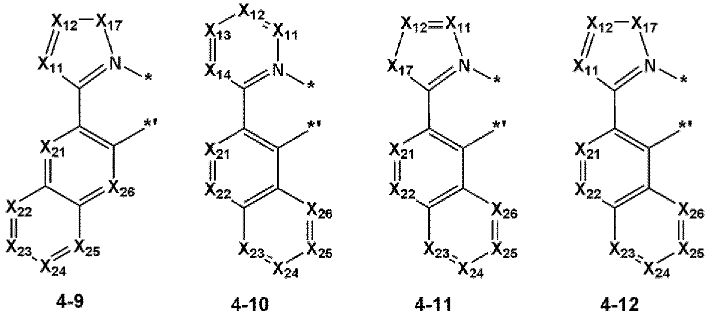 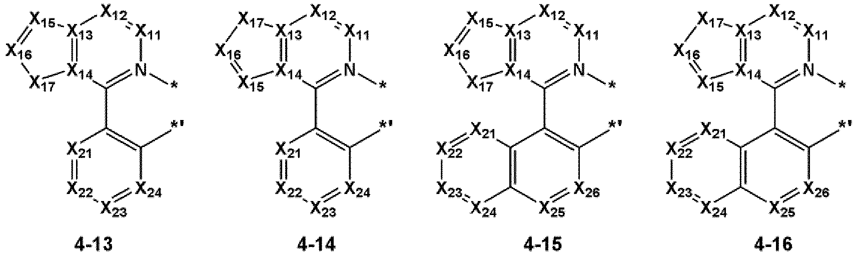 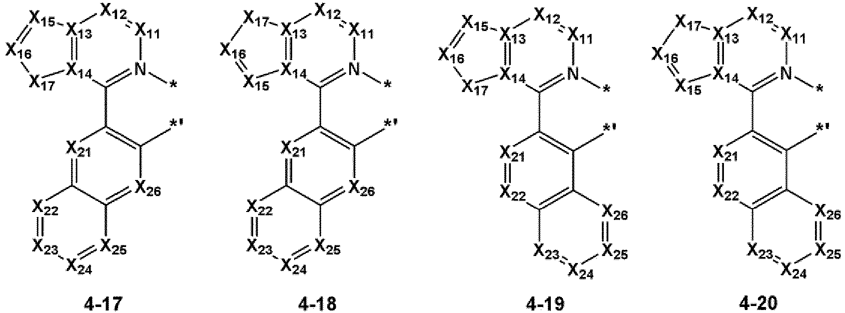
wherein, in Formulae 4-1 to 4-20,
X₁₁ may be C(R₁₁) or N, X₁₂ may be C(R₁₂) or N, X₁₃ in Formulae 4-1 to 4-12 may be C(R₁₃) or
N, and X₁₃ in Formulae 4-13 to 4-20 is C, X₁₄ in Formulae 4-1 to 4-12 may be C(R₁₄) or N, and X₁₄ in Formulae 4-13 to 4-20 is C,
X₁₅ may be C(R₁₅) or N, and X₁₆ may be C(R₁₆) or
N,
   X₁₇ may be O, S, C(R₁₇)(R₁₈), or N(R₁₇),
   X₂₁ may be C(T₁), C(R₂₁), or N, X₂₂ may be C(T₁), C(R₂₂), or N, X₂₃ may be C(T₁), C(R₂₃), or N, X₂₄ may be C(T₁), C(R₂₄), or N, X₂₅ may be C(T₁), C(R₂₅), or N, and X₂₆ may be C(T₁), C(R₂₆), or N,
   R₁₁ to R₁₈ may each be as described for R₁₀,
   R₂₁ to R₂₆ may be as described for R₂₀,
   at least one of X₂₁ to X₂₄ in Formulae 4-1 to 4-3, 4-13, and 4-14 may be C(T₁),
   at least one of X₂₁ to X₂₆ in Formulae 4-4 to 4-12 and 4-15 to 4-20 may be C(T₁),
   T₁ may be as described herein,
   two or more of R₁₁ to R₁₈, two or more of R₂₁ to R₂₆, or two or more of R₁₁ to R₁₈ and R₂₁ to R₂₆ may be optionally linked to each other to form a C₅-C₃₀ carbocyclic group that is unsubstituted or substituted with at least one R₁₀ₐ, or a C₁-C₃₀ heterocyclic group that is unsubstituted or substituted with at least one R₁₀ₐ, R₁₀ₐ may be as defined herein for R₁₀, and
   * and *' each indicate a binding site to a neighboring atom.

Two or more of a plurality of R₁₀ in Formula 1A may be optionally linked to each other to form a substituted or unsubstituted C₅-C₃₀ carbocyclic group or a substituted or unsubstituted C₁-C₃₀ heterocyclic group,
two or more of a plurality of R₂₀ in Formula 1A may be optionally linked to each other to form a substituted or unsubstituted C₅-C₃₀ carbocyclic group or a substituted or unsubstituted C₁-C₃₀ heterocyclic group, and
neighboring two or more of R₁₀ and R₂₀ in Formula 1A may optionally be linked to each other to form a substituted or unsubstituted C₅-C₃₀ carbocyclic group or a substituted or unsubstituted C₁-C₃₀ heterocyclic group.

b10 and b20 in Formula 1A may each independently be 1, 2, 3, 4, 5, 6, 7, 8, 9, or 10.

Ln₂ in Formula 1 may be an organic ligand.

In one or more embodiments, Ln₂ may be represented by at least one of Formulae 2A to 2C: 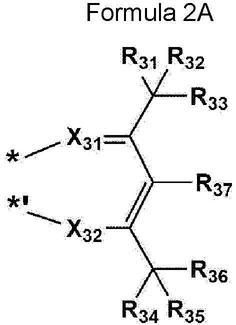 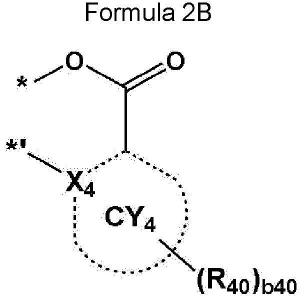 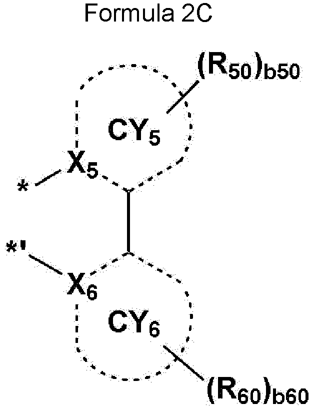 wherein, in Formulae 2A to 2C,
X₃₁ and X₃₂ may each independently be O or S,
X₄ to X₆ may each independently be C or N,
ring CY₄ to ring CY₆ may each independently be a C₅-C₃₀ carbocyclic group or a C₁-C₃₀ heterocyclic group,
R₃₁ to R₃₇, R₄₀, R₅₀, and R₆₀ may each independently be hydrogen, deuterium, -F, -Cl, -Br, -I, -SF₅, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a substituted or unsubstituted C₁-C₆₀ alkyl group, a substituted or unsubstituted C₂-C₆₀ alkenyl group, a substituted or unsubstituted C₂-C₆₀ alkynyl group, a substituted or unsubstituted C₁-C₆₀ alkoxy group, a substituted or unsubstituted C₁-C₆₀ alkylthio group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₇-C₆₀ alkyl aryl group, a substituted or unsubstituted C₇-C₆₀ aryl alkyl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted C₂-C₆₀ alkyl heteroaryl group, a substituted or unsubstituted C₂-C₆₀ heteroaryl alkyl group, a substituted or unsubstituted C₁-C₆₀ heteroaryloxy group, a substituted or unsubstituted C₁-C₆₀ heteroarylthio group, a substituted or unsubstituted monovalent non-aromatic condensed polycyclic group, a substituted or unsubstituted monovalent non-aromatic condensed heteropolycyclic group, -Si(Q₁)(Q₂)(Q₃), -Ge(Q₁)(Q₂)(Q₃), -C(=O)(Q₁), - S(=O)(Q₁), -S(=O)₂(Q₁), -N(Q₄)(Q₅), -B(Q₆)(Q₇), -P(Q₈)(Q₉), -P(=O)(Q₈)(Q₉), or -P(=S)(Q₈)(Q₉),
two or more of R₃₁ to R₃₇ may be optionally linked together to form a substituted or unsubstituted C₅-C₃₀ carbocyclic group or a substituted or unsubstituted C₁-C₃₀ heterocyclic group,
two or more of a plurality of R₄₀ may be optionally linked together to form a substituted or unsubstituted C₅-C₃₀ carbocyclic group or a substituted or unsubstituted C₁-C₃₀ heterocyclic group,
two or more of a plurality of R₅₀ may be optionally linked together to form a substituted or unsubstituted C₅-C₃₀ carbocyclic group or a substituted or unsubstituted C₁-C₃₀ heterocyclic group,
two or more of a plurality of R₆₀ may be optionally linked together to form a substituted or unsubstituted C₅-C₃₀ carbocyclic group or a substituted or unsubstituted C₁-C₃₀ heterocyclic group,
two or more of R₅₀ and R₆₀ may be optionally linked together to form a substituted or unsubstituted C₅-C₃₀ carbocyclic group or a substituted or unsubstituted C₁-C₃₀ heterocyclic group,
b40, b50, and b60 may each independently be 1, 2, 3, 4, 5, 6, 7, 8, 9, or 10, and
* and *' each indicate a binding site to M₁.

In one or more embodiments, Ln₂ may be represented by one of Formulae 21-1 to 21-4: 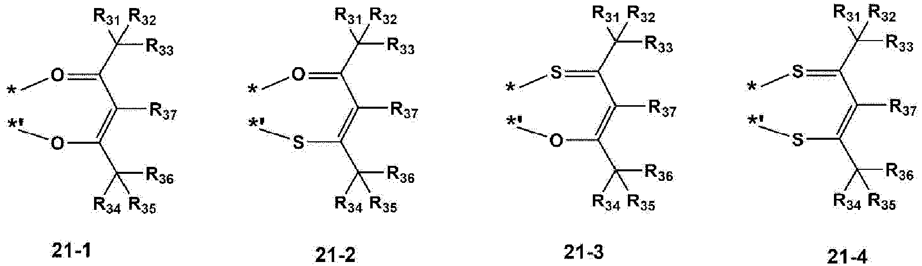 wherein, in Formulae 21-1 to 21-4,
R₃₁ to R₃₇ are as described herein, and
* and *' each indicate a binding site to M₁.

In one or more embodiments, Ln₂ may be represented by Formula 22-1: 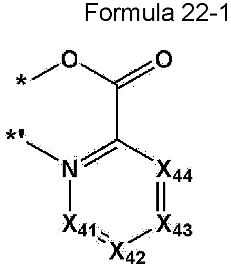 wherein, in Formula 22-1,
X₄₁ may be C(R₄₁) or N, X₄₂ may be C(R₄₂) or N, X₄₃ may be C(R₄₃) or N, and X₄₄ may be C(R₄₄) or N,
R₄₁ to R₄₄ may each independently be as described for R₄₀,
two or more of R₄₁ to R₄₄ may be optionally linked together to form a substituted or unsubstituted C₅-C₃₀ carbocyclic group or a substituted or unsubstituted C₁-C₃₀ heterocyclic group, and
* and *' each indicate a binding site to M₁.

In one or more embodiments, Ln₂ may be represented by Formula 23-1: 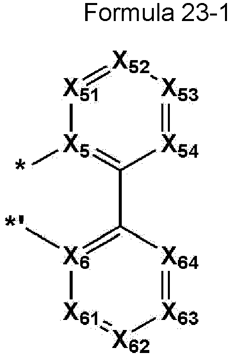 wherein, in Formula 23-1,
X₅₁ may be C(R₅₁) or N, X₅₂ may be C(R₅₂) or N, X₅₃ may be C(R₆₃) or N, and X₅₄ may be C(R₅₄) or N,
X₆₁ may be C(R₆₁) or N, X₆₂ may be C(R₆₂) or N, X₆₃ may be C(R₆₃) or N, and X₆₄ may be C(R₆₄) or N,
R₅₁ to R₅₄ may each independently be as described for R₅₀,
R₆₁ to R₆₄ may each independently be as described for R₆₀,
two or more of R₅₁ to R₅₄ may be optionally linked together to form a C₅-C₃₀ carbocyclic group unsubstituted or substituted with at least one R₁₀ₐ, or a C₁-C₃₀ heterocyclic group unsubstituted or substituted with at least one R₁₀ₐ,
two or more of R₆₁ to R₆₄ may be optionally linked together to form a C₅-C₃₀ carbocyclic group unsubstituted or substituted with at least one R₁₀ₐ, or a C₁-C₃₀ heterocyclic group unsubstituted or substituted with at least one R₁₀ₐ,
two or more of R₅₁ to R₅₄ and R₆₁ to R₆₄ may be optionally linked together to form a C₅-C₃₀ carbocyclic group unsubstituted or substituted with at least one R₁₀ₐ, or a C₁-C₃₀ heterocyclic group unsubstituted or substituted with at least one R₁₀ₐ, R₁₀ₐ may be as defined herein for R₁₀, and
* and *' each indicate a binding site to M₁.

In one or more embodiments, ring CY₁, ring CY₂, and ring CY₄ to ring CY₆ may each independently be i) a first ring, ii) a second ring, iii) a condensed ring group in which at least two first rings are condensed together, iv) a condensed ring group in which at least two second rings are condensed together, or v) a condensed ring group in which at least one first ring is condensed with at least one second ring,
wherein the first ring may be a cyclopentane group, a cyclopentene group, a furan group, a thiophene group, a pyrrole group, a silole group, a borole group, a phosphole group, a germole group, a selenophene group, an oxazole group, an oxadiazole group, an oxatriazole group, a thiazole group, a thiadiazole group, a thiatriazole group, a pyrazole group, an imidazole group, a triazole group, a tetrazole group, or an azasilole group, and
the second ring may be an adamantane group, a norbornane group, a norbornene group, a cyclohexane group, a cyclohexene group, a benzene group, a pyridine group, a pyrimidine group, a pyrazine group, a pyridazine group, or a triazine group.

**In** one or more embodiments, ring CY₁, ring CY₂, and ring CY₄ to ring CY₆ may each independently be a benzene group, a naphthalene group, an anthracene group, a phenanthrene group, a triphenylene group, a pyrene group, a chrysene group, a 1,2,3,4-tetrahydronaphthalene group, a benzothiophene group, a benzofuran group, an indole group, an indene group, a benzosilole group, a benzoborole group, a benzophosphole group, a benzoselenophene group, a benzogermole group, a dibenzothiophene group, a dibenzofuran group, a carbazole group, a fluorene group, a dibenzosilole group, a dibenzoborole group, a dibenzophosphole group, a dibenzoselenophene group, a dibenzogermole group, a dibenzothiophene 5-oxide group, a 9H-fluoren-9-one group, a dibenzothiophene 5,5-dioxide group, an azabenzothiophene group, an azabenzofuran group, an azaindole group, an azaindene group, an azabenzosilole group, an azabenzoborole group, an azabenzophosphole group, an azabenzoselenophene group, an azabenzogermole group, an azadibenzothiophene group, an azadibenzofuran group, an azacarbazole group, an azafluorene group, an azadibenzosilole group, an azadibenzoborole group, an azadibenzophosphole group, an azadibenzoselenophene group, an azadibenzogermole group, an azadibenzothiophene 5-oxide group, an aza-9H-fluoren-9-one group, an azadibenzothiophene 5,5-dioxide group, a pyridine group, a pyrimidine group, a pyrazine group, a pyridazine group, a triazine group, a quinoline group, an isoquinoline group, a benzoquinoline group, a benzoisoquinoline group, a furopyridine group, a benzofuropyridine group, a thienopyridine group, a benzothienopyridine group, a quinoxaline group, a quinazoline group, a phenanthroline group, a 5,6,7,8-tetrahydroisoquinoline group, a 5,6,7,8-tetrahydroquinoline group, an adamantane group, a norbornane group, or a norbornene group.

In one or more embodiments, ring CY₁, ring CY₂, and ring CY₄ to ring CY₆ may each independently be a benzene group, a naphthalene group, a phenanthrene group, a pyridine group, a pyrimidine group, a quinoline group, an isoquinoline group, a benzoquinoline group, a benzoisoquinoline group, a furanopyridine group, a benzofuropyridine group, a thienopyridine group, a benzothienopyridine group, a phthalazine group, a naphthyridine group, a quinoxaline group, or a quinazoline group.

In one or more embodiments, R₁₀, R₂₀, R₃₁ to R₃₇, R₄₀, R₅₀, and R₆₀ may each independently be:
hydrogen, deuterium, -F, -Cl, -Br, -I, -SF₅, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₂₀ alkyl group, a C₁-C₂₀ alkoxy group, or a C₁-C₂₀ alkylthio group;
a C₁-C₂₀ alkyl group, a C₁-C₂₀ alkoxy group, or a C₁-C₂₀ alkylthio group, each substituted with at least one of deuterium, -F, -Cl, -Br, -I, -SF₅, -CD₃, - CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₂₀ alkyl group, a deuterium-containing C₁-C₂₀ alkyl group, a fluorinated C₁-C₂₀ alkyl group, a cyclopentyl group, a cyclohexyl group, a cycloheptyl group, a cyclooctyl group, an adamantanyl group, a norbornenyl group, a cyclopentenyl group, a cyclohexenyl group, a cycloheptenyl group, a bicyclo[1.1.1]pentyl group, a bicyclo[2.1.1]hexyl group, a bicyclo[2.2.1]heptyl group (norbornanyl group), a bicyclo[2.2.2]octyl group, a (C₁-C₂₀ alkyl)cyclopentyl group, a (C₁-C₂₀ alkyl)cyclohexyl group, a (C₁-C₂₀ alkyl)cycloheptyl group, a (C₁-C₂₀ alkyl)cyclooctyl group, a (C₁-C₂₀ alkyl)adamantanyl group, a (C₁-C₂₀ alkyl)norbornenyl group, a (C₁-C₂₀ alkyl)cyclopentenyl group, a (C₁-C₂₀ alkyl)cyclohexenyl group, a (C₁-C₂₀ alkyl)cycloheptenyl group, a (C₁-C₂₀ alkyl)bicyclo[1.1.1]pentyl group, a (C₁-C₂₀ alkyl)bicyclo[2.1.1]hexyl group, a (C₁-C₂₀ alkyl)bicyclo[2.2.1]heptyl group, a (C₁-C₂₀ alkyl)bicyclo[2.2.2]octyl group, a silolanyl group, a phenyl group, a (C₁-C₂₀ alkyl)phenyl group, a biphenyl group, a terphenyl group, a naphthyl group, a 1,2,3,4-tetrahydronaphthyl group, a pyridinyl group, a pyrimidinyl group, or a combination thereof;
a cyclopentyl group, a cyclohexyl group, a cycloheptyl group, a cyclooctyl group, an adamantanyl group, a norbornenyl group, a cyclopentenyl group, a cyclohexenyl group, a cycloheptenyl group, a bicyclo[1.1.1]pentyl group, a bicyclo[2.1.1]hexyl group, a bicyclo[2.2.1]heptyl group, a bicyclo[2.2.2]octyl group, a silolanyl group, a phenyl group, a (C₁-C₂₀ alkyl)phenyl group, a biphenyl group, a terphenyl group, a naphthyl group, a 1,2,3,4-tetrahydronaphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, a benzoisothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, an imidazopyrimidinyl group, an azacarbazolyl group, an azadibenzofuranyl group, or an azadibenzothiophenyl group, each unsubstituted or substituted with at least one of deuterium, -F, -Cl, -Br, -I, -SF₅, -CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₂₀ alkyl group, a deuterium-containing C₁-C₂₀ alkyl group, a fluorinated C₁-C₂₀ alkyl group, a C₁-C₂₀ alkoxy group, a C₁-C₂₀ alkylthio group, a cyclopentyl group, a cyclohexyl group, a cycloheptyl group, a cyclooctyl group, an adamantanyl group, a norbornenyl group, a cyclopentenyl group, a cyclohexenyl group, a cycloheptenyl group, a bicyclo[1.1.1]pentyl group, a bicyclo[2.1.1]hexyl group, a bicyclo[2.2.1]heptyl group, a bicyclo[2.2.2]octyl group, a (C₁-C₂₀ alkyl)cyclopentyl group, a (C₁-C₂₀ alkyl)cyclohexyl group, a (C₁-C₂₀ alkyl)cycloheptyl group, a (C₁-C₂₀ alkyl)cyclooctyl group, a (C₁-C₂₀ alkyl)adamantanyl group, a (C₁-C₂₀ alkyl)norbornenyl group, a (C₁-C₂₀ alkyl)cyclopentenyl group, a (C₁-C₂₀ alkyl)cyclohexenyl group, a (C₁-C₂₀ alkyl)cycloheptenyl group, a (C₁-C₂₀ alkyl)bicyclo[1.1.1]pentyl group, a (C₁-C₂₀ alkyl)bicyclo[2.1.1]hexyl group, a (C₁-C₂₀ alkyl)bicyclo[2.2.1]heptyl group, a (C₁-C₂₀ alkyl)bicyclo[2.2.2]octyl group, a silolanyl group, a phenyl group, a (C₁-C₂₀ alkyl)phenyl group, a biphenyl group, a terphenyl group, a naphthyl group, a 1,2,3,4-tetrahydronaphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, a benzoisothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, an imidazopyrimidinyl group, an azacarbazolyl group, an azadibenzofuranyl group, an azadibenzothiophenyl group, or a combination thereof; or
-Si(Q₁)(Q₂)(Q₃), -Ge(Q₁)(Q₂)(Q₃), -C(=O)(Q₁), -S(=O)(Q₁), -S(=O)₂(Q₁), -N(Q₄)(Q₅), -B(Q₆)(Q₇), -P(Q₈)(Q₉), -P(=O)(Q₈)(Q₉), or -P(=S)(Q₈)(Q₉).

In one or more embodiments, R₁₀, R₂₀, R₃₁ to R₃₇, R₄₀, R₅₀, and R₆₀ may each independently be:
hydrogen, deuterium, -F, -Cl, -Br, -I, -SF₅, -CD₃, -CD₂H, -CDH₂, -CF₃, - CF₂H, -CFH₂, a C₁-C₆₀ alkyl group, a C₂-C₆₀ alkenyl group, a C₂-C₆₀ alkynyl group, a C₁-C₆₀ alkoxy group, or a C₁-C₆₀ alkylthio group; or
a group represented by one of Formulae 9-1 to 9-61, 9-201 to 9-244, 10-1 to 10-154, or 10-201 to 10-350: 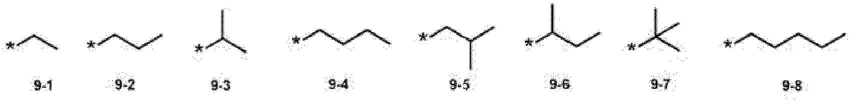 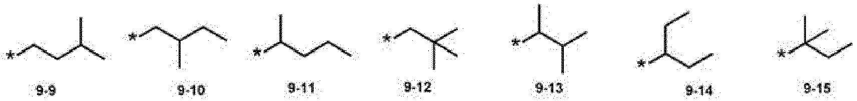 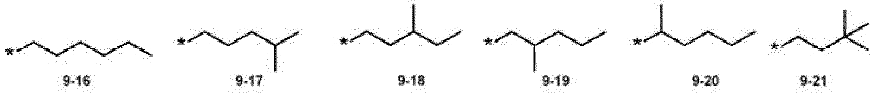 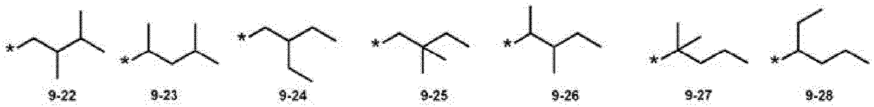 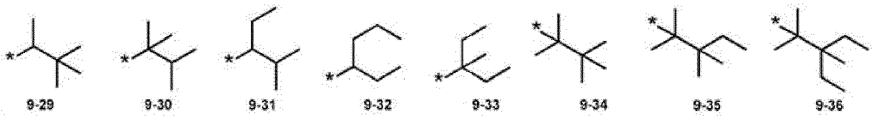 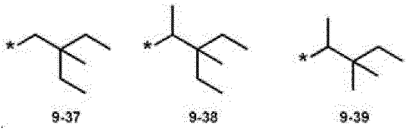 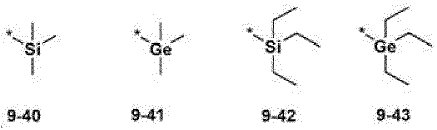 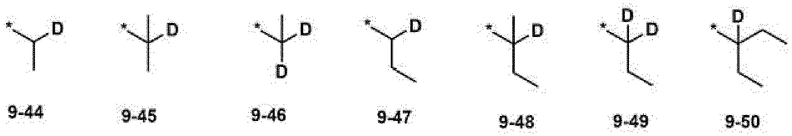 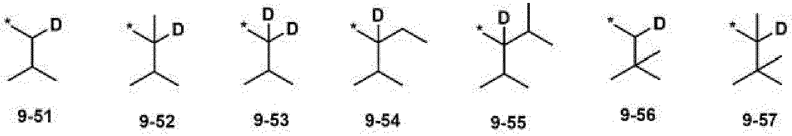 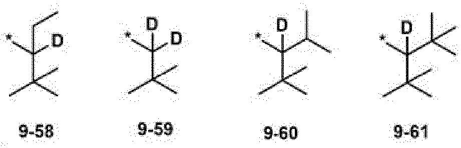 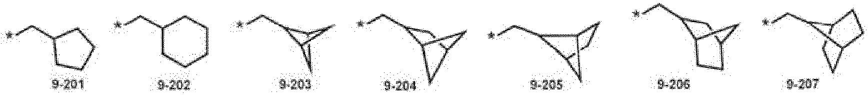 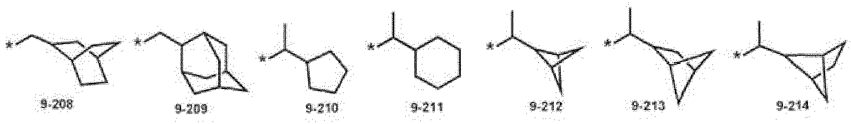 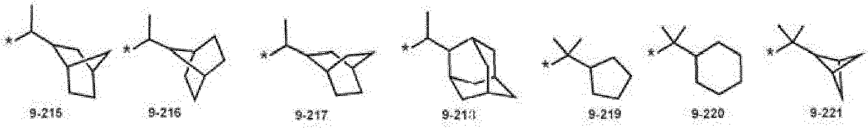 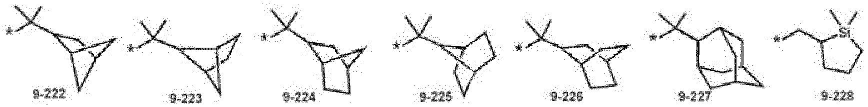 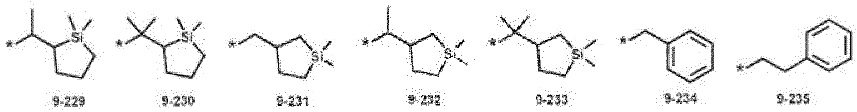 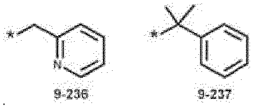 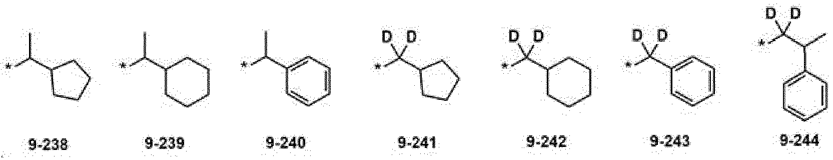 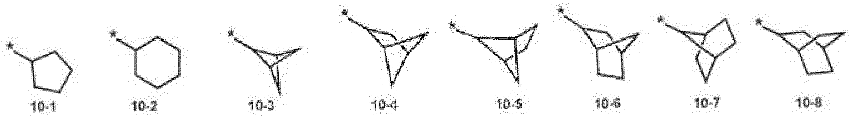 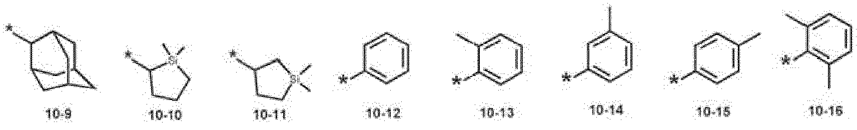 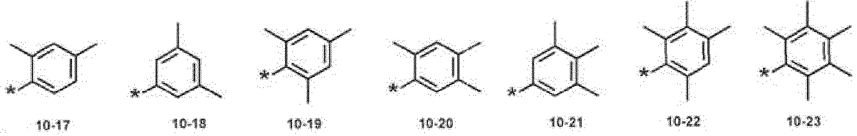 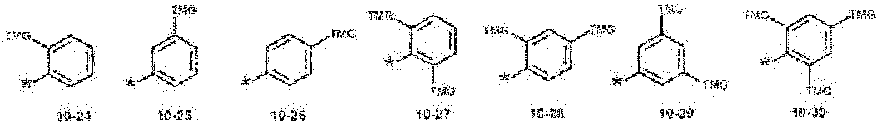 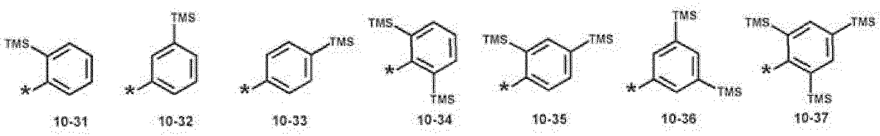 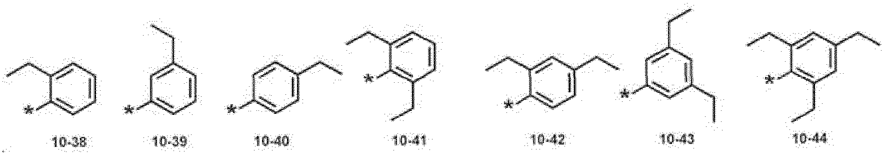 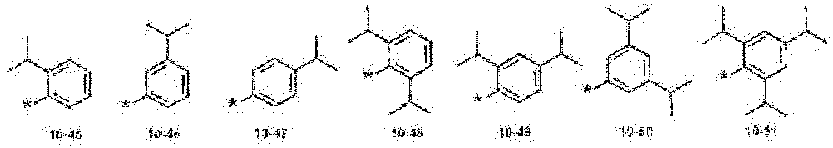 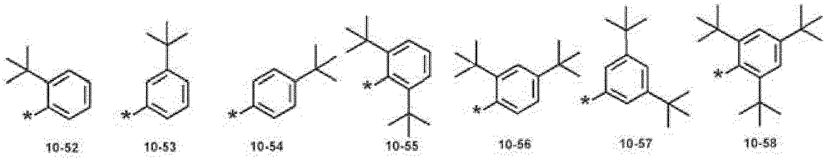 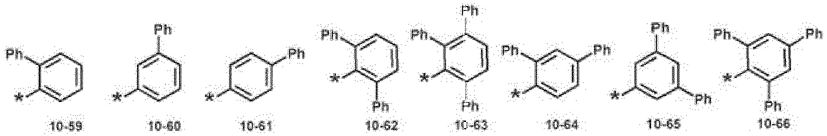 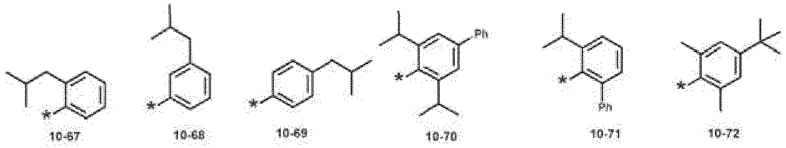 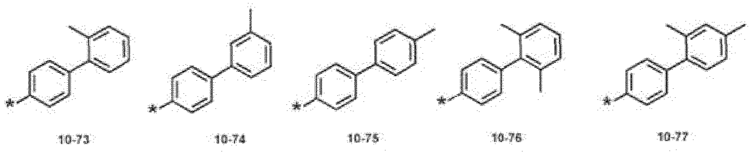 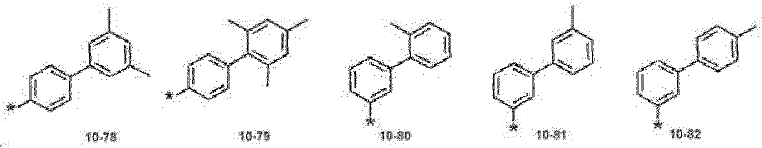 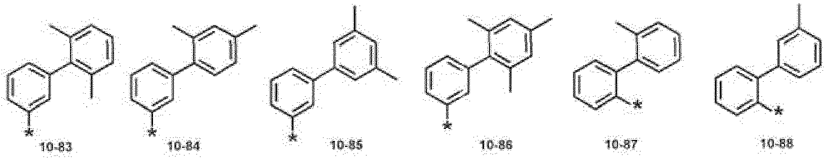 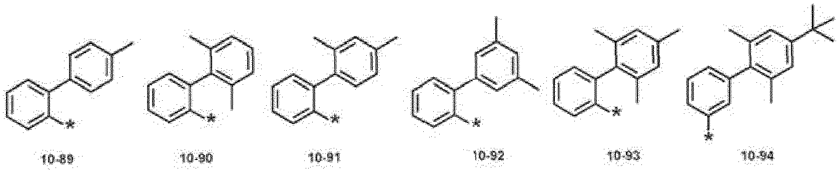 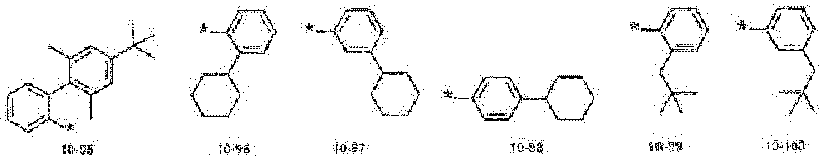 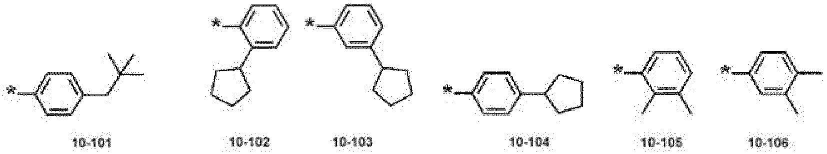 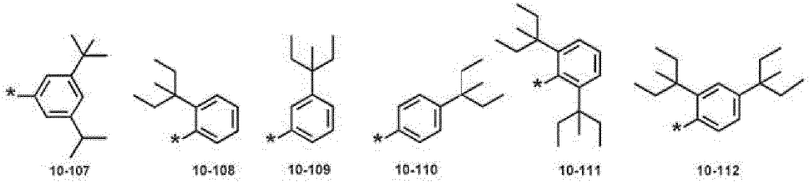 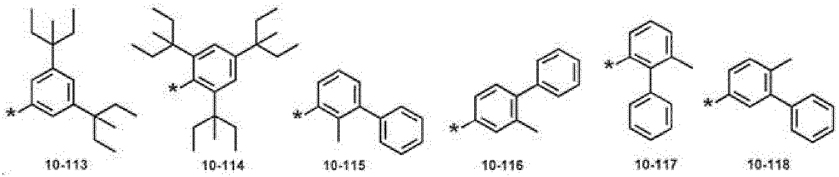 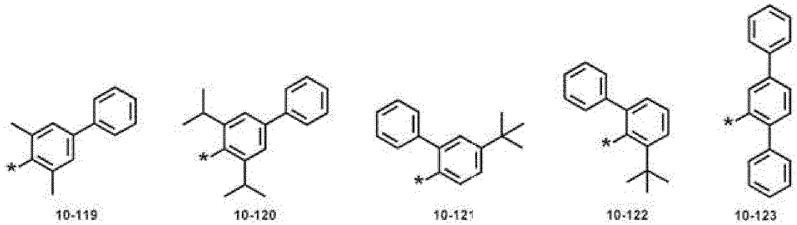 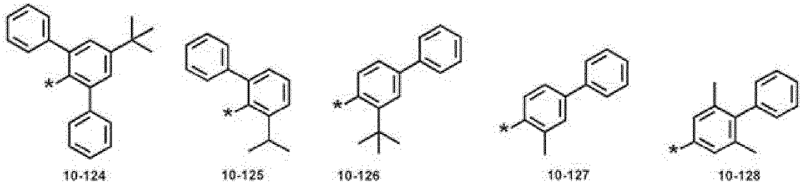 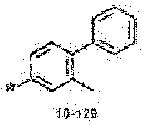 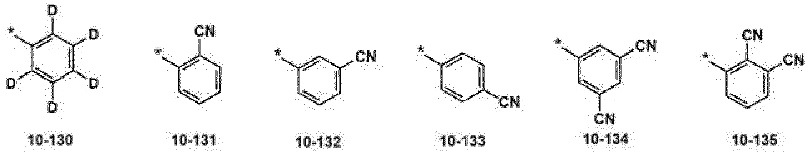 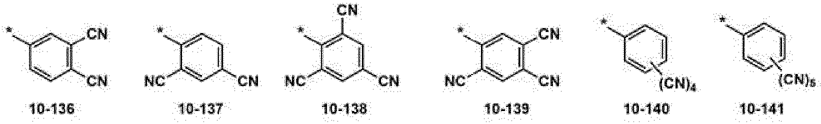 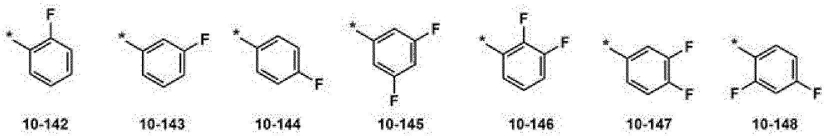 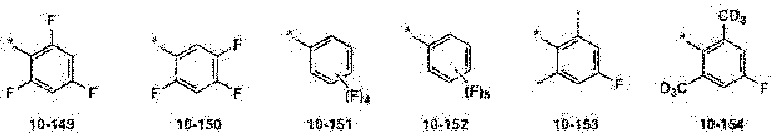 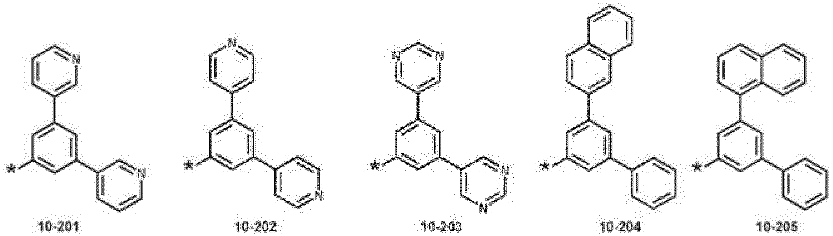 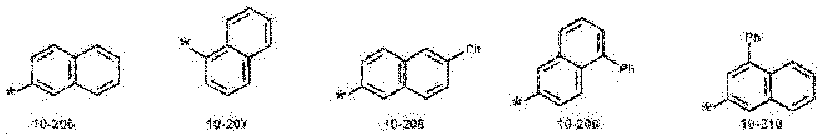 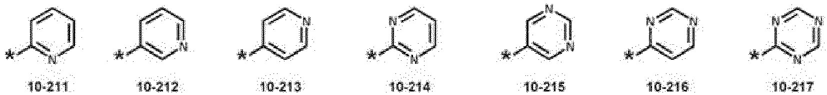 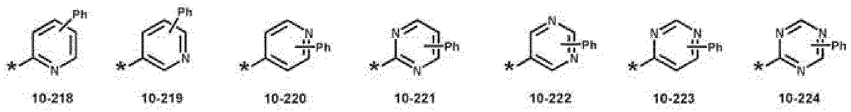 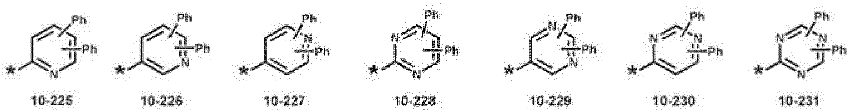 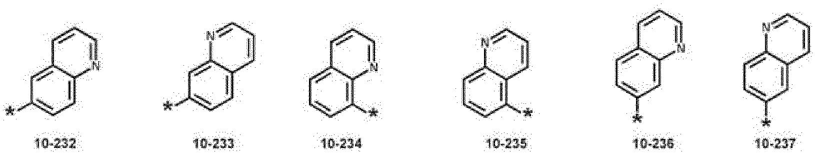 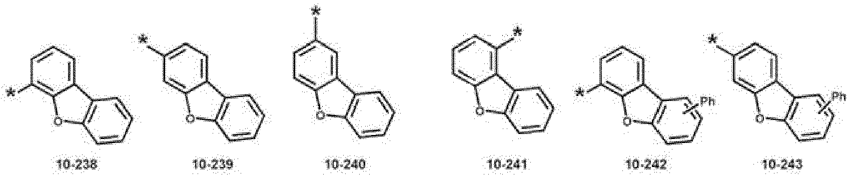 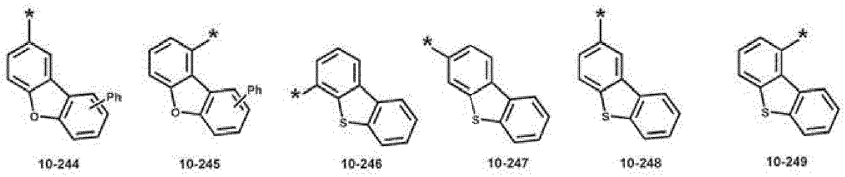 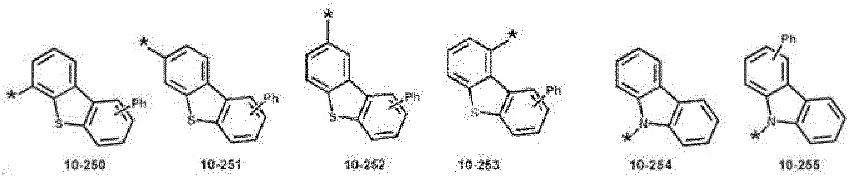 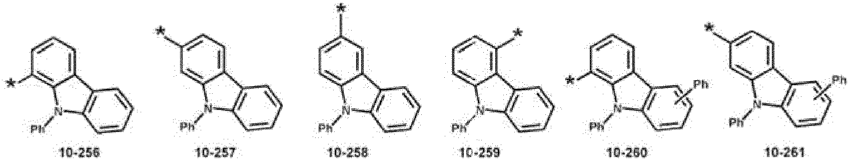 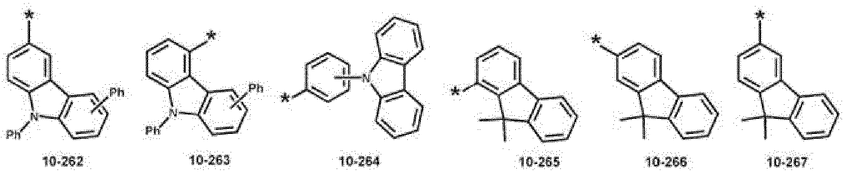 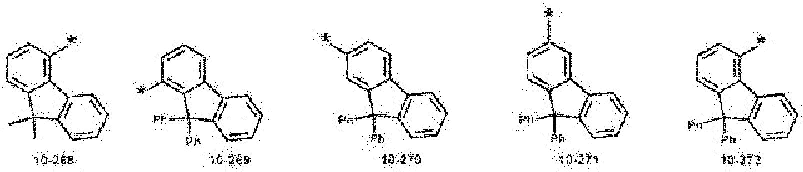 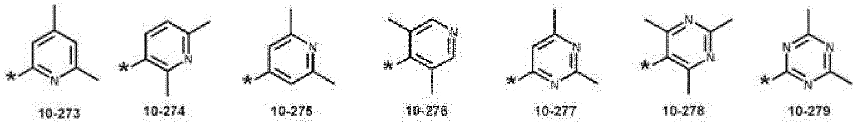 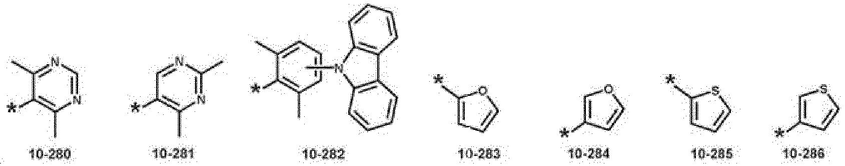 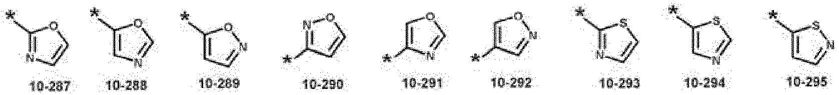 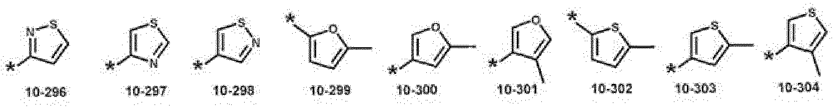 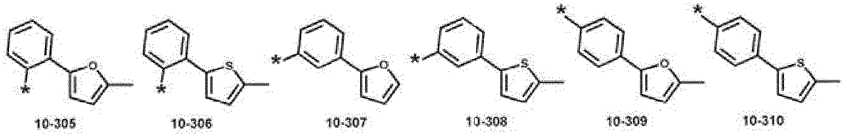 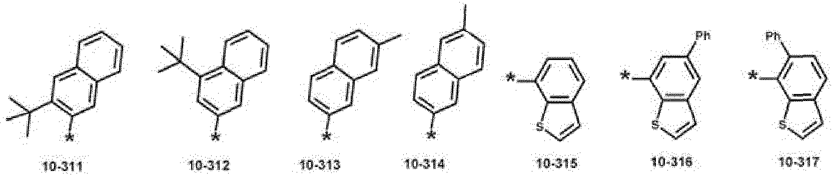 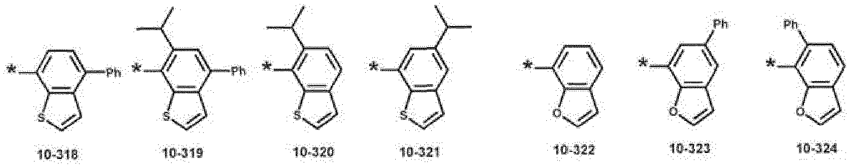 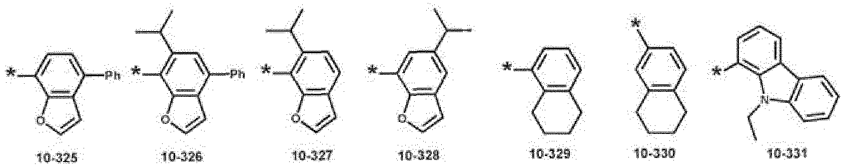 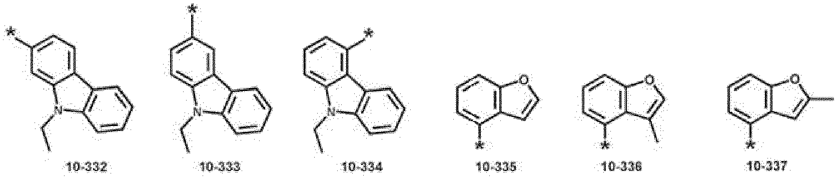 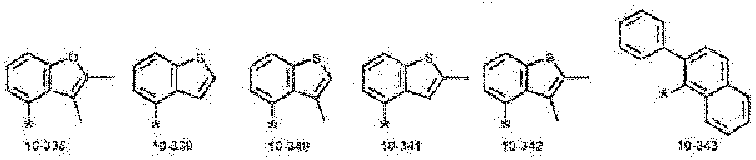 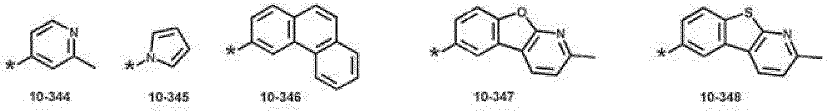 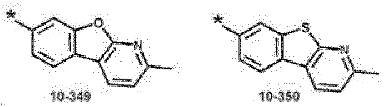
wherein, in Formulae 9-1 to 9-61, 9-201 to 9-244, 10-1 to 10-154, and 10-201 to 10-350, * represents a binding site to an adjacent atom, "Ph" represents a phenyl group, "TMS" represents a trimethylsilyl group, and "TMG" represents a trimethylgermyl group.

**In** one or more embodiments, two or more of a plurality of R₁₀; two or more of a plurality of R₂₀; two or more of R₃₁ to R₃₇; two or more of a plurality of R₄₀; two or more of a plurality of R₅₀; two or more of a plurality of R₆₀; and/or two or more of R₅₀ and R₆₀ may be optionally linked together via a single bond, a double bond, or a first linking group to form a C₅-C₃₀ carbocyclic group that is unsubstituted or substituted with at least one R₁₀ₐ, or a C₁-C₃₀ heterocyclic group that is unsubstituted or substituted with at least one R₁₀ₐ (for example, a fluorene group, a xanthene group, an acridine group, or the like, each unsubstituted or substituted with at least one R₁₀ₐ). R₁₀ₐ may be as described herein for R₁₀.

**In** one or more embodiments, two or more of R₁₁ to R₁₈; two or more of R₂₁ to R₂₆; two or more of R₃₁ to R₃₇; two or more of R₄₁ to R₄₄; two or more of R₅₁ to R₅₄, and/or two or more of R₆₁ to R₆₄ may be optionally linked together via a single bond, a double bond, or a first linking group to form a C₅-C₃₀ carbocyclic group that is unsubstituted or substituted with at least one R₁₀ₐ, or a C₁-C₃₀ heterocyclic group that is unsubstituted or substituted with at least one R₁₀ₐ (for example, a fluorene group, a xanthene group, an acridine group, or the like, each unsubstituted or substituted with at least one R₁₀ₐ). R₁₀ₐ may be as described herein for R₁₀.

The first linking group may be *-N(R₈)-*', *-B(R₈)-*', *-P(R₈)-*', *-C(R₈)(R₉)-*', *-Si(R₈)(R₉)-*', *-Ge(R₈)(R₉)-*', *-S-*', *-Se-*', *-O-*', *-C(=O)-*', *-S(=O)-*', *-S(=O)₂-*', *-C(R₈)=*', *=C(R₈)-*', *-C(R₈)=C(R₉)-*', *-C(=S)-*', or *-C=C-*', R₈ and R₉ may be as described for R₁₀, and each of * and *' indicates a binding site to a neighboring atom.

At least one substituent of the substituted C₅-C₃₀ carbocyclic group, the substituted C₁-C₃₀ heterocyclic group, the substituted C₁-C₆₀ alkyl group, the substituted C₂-C₆₀ alkenyl group, the substituted C₂-C₆₀ alkynyl group, the substituted C₁-C₆₀ alkoxy group, the substituted C₁-C₆₀ alkylthio group, the substituted C₃-C₁₀ cycloalkyl group, the substituted C₁-C₁₀ heterocycloalkyl group, the substituted C₃-C₁₀ cycloalkenyl group, the substituted C₁-C₁₀ heterocycloalkenyl group, the substituted C₆-C₆₀ aryl group, the substituted C₇-C₆₀ alkyl aryl group, the substituted C₇-C₆₀ aryl alkyl group, the substituted C₆-C₆₀ aryloxy group, the substituted C₆-C₆₀ arylthio group, the substituted C₁-C₆₀ heteroaryl group, the substituted C₂-C₆₀ alkyl heteroaryl group, the substituted C₂-C₆₀ heteroaryl alkyl group, the substituted C₁-C₆₀ heteroaryloxy group, the substituted C₁-C₆₀ heteroarylthio group, the substituted monovalent non-aromatic condensed polycyclic group, the substituted monovalent non-aromatic condensed heteropolycyclic group, the substituted C₃-C₁₀ cycloalkylene group, the substituted C₁-C₁₀ heterocycloalkylene group, the substituted C₃-C₁₀ cycloalkenylene group, the substituted C₁-C₁₀ heterocycloalkenylene group, the substituted C₆-C₆₀ arylene group, the substituted C₁-C₆₀ heteroarylene group, the substituted divalent non-aromatic condensed polycyclic group, and the substituted divalent non-aromatic condensed heteropolycyclic group may be:
deuterium, -F, -Cl, -Br, -I, -SF₅, -CD₃, -CD₂H, -CDH₂, -CF₃, -CF₂H, - CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, a C₁-C₆₀ alkoxy group, or a C₁-C₆₀ alkylthio group;
a C₁-C₆₀ alkyl group, a C₂-C₆₀ alkenyl group, a C₂-C₆₀ alkynyl group, a C₁-C₆₀ alkoxy group, or a C₁-C₆₀ alkylthio group, each substituted with at least one of deuterium, -F, -Cl, -Br, -I, -SF₅, -CD₃, -CD₂H, -CDH₂, -CF₃, -CF₂H, - CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₇-C₆₀ alkyl aryl group, a C₆-C₆₀ aryloxy group, a C₆-C₆₀ arylthio group, a C₁-C₆₀ heteroaryl group, a C₂-C₆₀ alkyl heteroaryl group, a C₁-C₆₀ heteroaryloxy group, a C₁-C₆₀ heteroarylthio group, a monovalent non-aromatic condensed polycyclic group, a monovalent non-aromatic condensed heteropolycyclic group, -Si(Q₁₁)(Q₁₂)(Q₁₃), -Ge(Q₁₁)(Q₁₂)(Q₁₃), -C(=O)(Q₁₁), - S(=O)(Q₁₁), -S(=O)₂(Q₁₁), -N(Q₁₄)(Q₁₆), -B(Q₁₆)(Q₁₇), -P(Q₁₈)(Q₁₉), - P(=O)(Q₁₈)(Q₁₉), -P(=S)(Q₁₈)(Q₁₉), or a combination thereof;
a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₇-C₆₀ alkyl aryl group, a C₆-C₆₀ aryloxy group, a C₆-C₆₀ arylthio group, a C₁-C₆₀ heteroaryl group, a C₂-C₆₀ alkyl heteroaryl group, a C₁-C₆₀ heteroaryloxy group, a C₁-C₆₀ heteroarylthio group, a monovalent non-aromatic condensed polycyclic group, or a monovalent non-aromatic condensed heteropolycyclic group, each unsubstituted or substituted with at least one of deuterium, -F, -Cl, -Br, -I, -SF₅, -CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, a C₁-C₆₀ alkoxy group, a C₁-C₆₀ alkylthio group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₇-C₆₀ alkyl aryl group, a C₇-C₆₀ aryl alkyl group, a C₆-C₆₀ aryloxy group, a C₆-C₆₀ arylthio group, a C₁-C₆₀ heteroaryl group, a C₂-C₆₀ alkyl heteroaryl group, a C₂-C₆₀ heteroaryl alkyl group, a C₁-C₆₀ heteroaryloxy group, a C₁-C₆₀ heteroarylthio group, a monovalent non-aromatic condensed polycyclic group, a monovalent non-aromatic condensed heteropolycyclic group, -Si(Q₂₁)(Q₂₂)(Q₂₃), - Ge(Q₂₁)(Q₂₂)(Q₂₃), -C(=O)(Q₂₁), -S(=O)(Q₂₁), -S(=O)₂(Q₂₁), -N(Q₂₄)(Q₂₅), - B(Q₂₆)(Q₂₇), -P(Q₂₈)(Q₂₉), -P(=O)(Q₂₈)(Q₂₉), -P(=S)(Q₂₈)(Q₂₉), or a combination thereof;
-Si(Q₃₁)(Q₃₂)(Q₃₃), -Ge(Q₃₁)(Q₃₂)(Q₃₃), -C(=O)(Q₃₁), -S(=O)(Q₃₁), - S(=O)₂(Q₃₁), -N(Q₃₄)(Q₃₅), -B(Q₃₆)(Q₃₇), -P(Q₃₈)(Q₃₉), -P(=O)(Q₃₈)(Q₃₉), or - P(=S)(Q₃₈)(Q₃₉); or
a combination thereof.

Q₁ to Q₉, Q₁₁ to Q₁₉, Q₂₁ to Q₂₉, and Q₃₁ to Q₃₉ may each independently be hydrogen, deuterium, -F, -Cl, -Br, -I, -SF₅, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a substituted or unsubstituted C₁-C₆₀ alkyl group, a substituted or unsubstituted C₂-C₆₀ alkenyl group, a substituted or unsubstituted C₂-C₆₀ alkynyl group, a substituted or unsubstituted C₁-C₆₀ alkoxy group, a substituted or unsubstituted C₁-C₆₀ alkylthio group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₇-C₆₀ alkyl aryl group, a substituted or unsubstituted C₇-C₆₀ aryl alkyl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted C₂-C₆₀ alkyl heteroaryl group, a substituted or unsubstituted C₂-C₆₀ heteroaryl alkyl group, a substituted or unsubstituted C₁-C₆₀ heteroaryloxy group, a substituted or unsubstituted C₁-C₆₀ heteroarylthio group, a substituted or unsubstituted monovalent non-aromatic condensed polycyclic group, or a substituted or unsubstituted monovalent non-aromatic condensed heteropolycyclic group.

For example, Q₁ to Q₉, Q₁₁ to Q₁₉, Q₂₁ to Q₂₉, and Q₃₁ to Q₃₉ may each independently be:
-CH₃, -CD₃, -CD₂H, -CDH₂, -CH₂CH₃, -CH₂CD₃, -CH₂CD₂H, -CH₂CDH₂, -CHDCH₃, -CHDCD₂H, -CHDCDH₂, -CHDCD₃, -CD₂CD₃, -CD₂CD₂H, or - CD₂CDH₂; or
an n-propyl group, an iso-propyl group, an n-butyl group, a sec-butyl group, an isobutyl group, a tert-butyl group, an n-pentyl group, a tert-pentyl group, a neopentyl group, an isopentyl group, a sec-pentyl group, 3-pentyl group, a sec-isopentyl group, a phenyl group, a biphenyl group, or a naphthyl group, each unsubstituted or substituted with at least one of deuterium, a C₁-C₁₀ alkyl group, a phenyl group, or a combination thereof.

In one or more embodiments, the organometallic compound may be at least one of Compounds 1 to 6, but embodiments are not limited thereto:

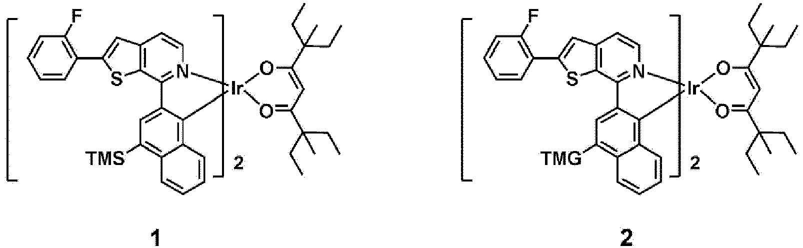

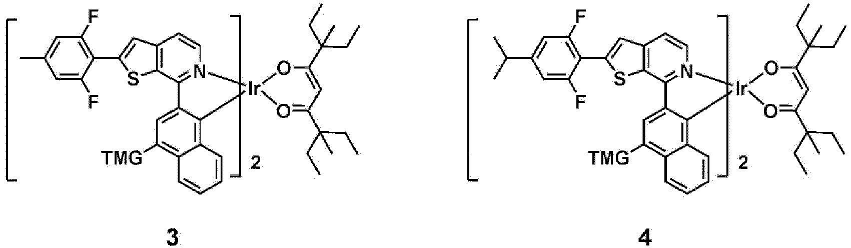

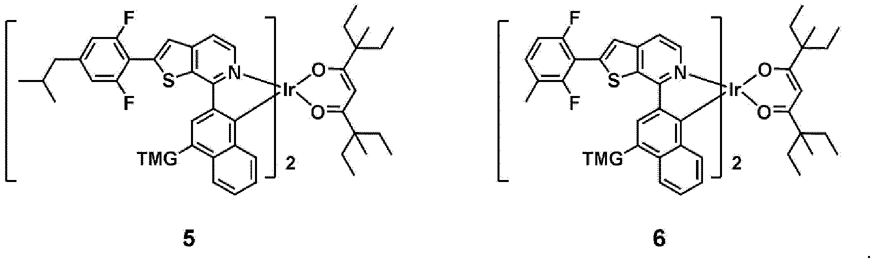

By including at least one silyl group or at least one germyl group in the organometallic compound included in the organic light-emitting device, the organic light-emitting device may have a low deposition temperature, and the emission wavelength thereof may be easily controlled so as to have a target wavelength characteristic (for example, shortening of the wavelength). For example, compared to a compound that does not include a silyl group or a germyl group or a compound having a structure in which an alkyl group such as a methyl group, an ethyl group, a t-butyl group, or the like is substituted instead of a silyl group or a germyl group, the organometallic compound may have a shorter maximum emission wavelength. In other words, the organometallic compound that is substituted with at least one silyl group or at least one germyl group on a ligand thereof, rather than a group such as an alkyl group at the corresponding position(s) of the ligand, may have a shorter maximum emission wavelength.

The term "C₁-C₆₀ alkyl group" as used herein refers to a linear or branched saturated aliphatic hydrocarbon monovalent group having 1 to 60 carbon atoms. The term "C₁-C₆₀ alkylene group" as used herein refers to a divalent group having the same structure as the C₁-C₆₀ alkyl group.

Non-limiting examples of the C₁-C₆₀ alkyl group, the C₁-C₂₀ alkyl group, and/or the C₁-C₁₀ alkyl group include a methyl group, an ethyl group, an n-propyl group, an isopropyl group, an n-butyl group, a sec-butyl group, an isobutyl group, a tert-butyl group, an n-pentyl group, a tert-pentyl group, a neopentyl group, an isopentyl group, a sec-pentyl group, a 3-pentyl group, a sec-isopentyl group, an n-hexyl group, an isohexyl group, a sec-hexyl group, a tert-hexyl group, an n-heptyl group, an isoheptyl group, a sec-heptyl group, a tert-heptyl group, an n-octyl group, an isooctyl group, a sec-octyl group, a tert-octyl group, an n-nonyl group, an isononyl group, a sec-nonyl group, a tert-nonyl group, an n-decyl group, an isodecyl group, a sec-decyl group, a tert-decyl group, or the like, each unsubstituted or substituted with at least one of a methyl group, an ethyl group, an n-propyl group, an isopropyl group, an n-butyl group, a sec-butyl group, an isobutyl group, a tert-butyl group, an n-pentyl group, a tert-pentyl group, a neopentyl group, an isopentyl group, a sec-pentyl group, a 3-pentyl group, a sec-isopentyl group, an n-hexyl group, an isohexyl group, a sec-hexyl group, a tert-hexyl group, an n-heptyl group, an isoheptyl group, a sec-heptyl group, a tert-heptyl group, an n-octyl group, an isooctyl group, a sec-octyl group, a tert-octyl group, an n-nonyl group, an isononyl group, a sec-nonyl group, a tert-nonyl group, an n-decyl group, an isodecyl group, a sec-decyl group, a tert-decyl group, or the like, or a combination thereof. For example, Formula 9-33 is a branched C₆ alkyl group, for example, a tert-butyl group that is substituted with two methyl groups.

The term "C₁-C₆₀ alkoxy group" as used herein refers to a monovalent group represented by -OA₁₀₁ (wherein A₁₀₁ is the C₁-C₆₀ alkyl group). Non-limiting examples of the C₁-C₆₀ alkoxy group, a C₁-C₂₀ alkoxy group or C₁-C₁₀ alkoxy group include a methoxy group, an ethoxy group, a propoxy group, a butoxy group, a pentoxy group, or the like.

The term "C₁-C₆₀ alkylthio group" as used herein refers to a monovalent group represented by -SA_{101'} (wherein A_{101'} is the C₁-C₆₀ alkyl group).

The term "C₂-C₆₀ alkenyl group" as used herein refers to a hydrocarbon group formed by substituting at least one carbon-carbon double bond in the middle or at the terminus of the C₂-C₆₀ alkyl group, and non-limiting examples thereof include an ethenyl group, a propenyl group, a butenyl group, or the like. The term "C₂-C₆₀ alkenylene group" as used herein refers to a divalent group having the same structure as the C₂-C₆₀ alkenyl group.

The term "C₂-C₆₀ alkynyl group" as used herein refers to a hydrocarbon group formed by substituting at least one carbon-carbon triple bond in the middle or at the terminus of the C₂-C₆₀ alkyl group, and non-limiting examples thereof include an ethynyl group, a propynyl group, or the like. The term "C₂-C₆₀ alkynylene group" as used herein refers to a divalent group having the same structure as the C₂-C₆₀ alkynyl group.

The term "C₃-C₁₀ cycloalkyl group" as used herein refers to a monovalent saturated hydrocarbon cyclic group having 3 to 10 carbon atoms. The term "C₃-C₁₀ cycloalkylene group" as used herein refers to a divalent group having the same structure as the C₃-C₁₀ cycloalkyl group.

Non-limiting examples of the C₃-C₁₀ cycloalkyl group include a cyclopropyl group, a cyclobutyl group, a cyclopentyl group, a cyclohexyl group, a cycloheptyl group, a cyclooctyl group, an adamantanyl group, a bicyclo[1.1.1]pentyl group, a bicyclo[2.1.1 ]hexyl group, a bicyclo[2.2.1]heptyl(norbornanyl) group, a bicyclo[2.2.2]octyl group, or the like.

The term "C₁-C₁₀ heterocycloalkyl group" as used herein refers to a monovalent saturated cyclic group having at least one heteroatom selected from N, O, P, Si, S, Se, Ge, and B as a ring-forming atom and 1 to 10 carbon atoms as ring-forming atom(s). The term "C₁-C₁₀ heterocycloalkylene group" as used herein refers to a divalent group having the same structure as the C₁-C₁₀ heterocycloalkyl group.

Non-limiting examples of the C₁-C₁₀ heterocycloalkyl group include a silolanyl group, a silinanyl group, tetrahydrofuranyl group, a tetrahydro-2H-pyranyl group, a tetrahydrothiophenyl group, or the like.

The term "C₃-C₁₀ cycloalkenyl group" as used herein refers to a monovalent cyclic group that has 3 to 10 carbon atoms and at least one carbon-carbon double bond in the ring thereof and no aromaticity, and non-limiting examples thereof include a cyclopentenyl group, a cyclohexenyl group, a cycloheptenyl group, or the like. The term "C₃-C₁₀ cycloalkenylene group" as used herein refers to a divalent group having the same structure as the C₃-C₁₀ cycloalkenyl group.

The term "C₁-C₁₀ heterocycloalkenyl group" as used herein refers to a monovalent cyclic group that has at least one heteroatom selected from N, O, P, Si, S, Se, Ge, and B as a ring-forming atom, 2 to 10 carbon atoms as ring-forming atom(s), and at least one double bond in its ring. Non-limiting examples of the C₁-C₁₀ heterocycloalkenyl group include a 2,3-dihydrofuranyl group, a 2,3-dihydrothiophenyl group, or the like. The term "C₂-C₁₀ heterocycloalkenylene group" as used herein refers to a divalent group having the same structure as the C₁-C₁₀ heterocycloalkenyl group.

The term "C₆-C₆₀ aryl group" as used herein refers to a monovalent group having a carbocyclic aromatic ring system having 6 to 60 carbon atoms, and the term "C₆-C₆₀ arylene group" as used herein refers to a divalent group having a carbocyclic aromatic ring system having 6 to 60 carbon atoms. Non-limiting examples of the C₆-C₆₀ aryl group include a phenyl group, a naphthyl group, an anthracenyl group, a phenanthrenyl group, a pyrenyl group, a chrysenyl group, or the like. When the C₆-C₆₀ aryl group and the C₆-C₆₀ arylene group each include two or more rings, the rings may be fused to each other.

The term "C₇-C₆₀ alkyl aryl group" as used herein refers to a C₆-C₆₀ aryl group substituted with at least one C₁-C₆₀ alkyl group. The term "C₇-C₆₀ aryl alkyl group" as used herein refers to a C₁-C₆₀ alkyl group substituted with at least one C₆-C₆₀ aryl group.

The term "C₁-C₆₀ heteroaryl group" as used herein refers to a monovalent group having a heterocyclic aromatic ring system that has at least one heteroatom selected from N, O, P, Si, S, Se, Ge, and B as a ring-forming atom, and 1 to 60 carbon atoms as ring-forming atom(s). The term "C₁-C₆₀ heteroarylene group" as used herein refers to a divalent group having a heterocyclic aromatic ring system that has at least one heteroatom selected from N, O, P, Si, S, Se, Ge, and B as a ring-forming atom, and 1 to 60 carbon atoms as ring-forming atom(s). Non-limiting examples of the C₁-C₆₀ heteroaryl group include a pyridinyl group, a pyrimidinyl group, a pyrazinyl group, a pyridazinyl group, a triazinyl group, a quinolinyl group, an isoquinolinyl group, or the like. When the C₁-C₆₀ heteroaryl group and the C₁-C₆₀ heteroarylene group each include two or more rings, the rings may be fused to each other.

The term "C₂-C₆₀ alkyl heteroaryl group" as used herein refers to a C₁-C₆₀ heteroaryl group substituted with at least one C₁-C₆₀ alkyl group. The term "C₂-C₆₀ heteroaryl alkyl group" as used herein refers to a C₁-C₆₀ alkyl group substituted with at least one C₁-C₆₀ heteroaryl group.

The term "C₆-C₆₀ aryloxy group" as used herein indicates -OA₁₀₂ (wherein A₁₀₂ is a C₆-C₆₀ aryl group), and the term "C₆-C₆₀ arylthio group" as used herein indicates -SA₁₀₃ (wherein A₁₀₃ is a C₆-C₆₀ aryl group).

The term "C₁-C₆₀ heteroaryloxy group" as used herein indicates -OA₁₀₄ (wherein A₁₀₄ is a C₁-C₆₀ heteroaryl group), and the term "C₁-C₆₀ heteroarylthio group" as used herein indicates -SA₁₀₅ (wherein A₁₀₅ is the C₁-C₆₀ heteroaryl group).

The term "monovalent non-aromatic condensed polycyclic group" as used herein refers to a monovalent group (for example, having 8 to 60 carbon atoms) having two or more rings condensed to each other, only carbon atoms as ring-forming atoms, and no aromaticity in its entire molecular structure. Non-limiting examples of the monovalent non-aromatic condensed polycyclic group include a fluorenyl group or the like. The term "divalent non-aromatic condensed polycyclic group" as used herein refers to a divalent group having the same structure as the monovalent non-aromatic condensed polycyclic group described above.

The term "monovalent non-aromatic condensed heteropolycyclic group" as used herein refers to a monovalent group (for example, having 1 to 60 carbon atoms) having two or more rings condensed with each other, at least one heteroatom selected from **N, O, P,** Si, S, Se, Ge, and **B,** other than carbon atoms, as a ring-forming atom, and no aromaticity in its entire molecular structure. Non-limiting examples of the monovalent non-aromatic condensed heteropolycyclic group include a carbazolyl group or the like. The term "divalent non-aromatic condensed heteropolycyclic group" as used herein refers to a divalent group having the same structure as the monovalent non-aromatic condensed heteropolycyclic group described above.

The term "C₅-C₃₀ carbocyclic group" as used herein refers to a saturated or unsaturated ring group having, as ring-forming atoms, 5 to 30 carbon atoms only. The C₅-C₃₀ carbocyclic group may be a monocyclic group or a polycyclic group. Non-limiting examples of the "C₅-C₃₀ carbocyclic group (unsubstituted or substituted with at least one R₁ₐ)" as used herein may include an adamantane group, a norbornene group, a bicyclo[1.1.1]pentane group, a bicyclo[2.1.1]hexane group, a bicyclo[2.2.1]heptane(norbornane) group, a bicyclo[2.2.2]octane group, a cyclopentane group, a cyclohexane group, a cyclohexene group, a benzene group, a naphthalene group, an anthracene group, a phenanthrene group, a triphenylene group, a pyrene group, a chrysene group, a 1,2,3,4-tetrahydronaphthalene group, a cyclopentadiene group, a silole group, a fluorene group, or the like (each unsubstituted or substituted with at least one R₁ₐ).

The term "C₁-C₃₀ heterocyclic group" as used herein refers to a saturated or unsaturated ring group having, as a ring-forming atom, at least one heteroatom selected from N, O, P, Si, S, Se, Ge, and B, other than 1 to 30 carbon atoms as ring-forming atom(s). The C₁-C₃₀ heterocyclic group may be a monocyclic group or a polycyclic group. Non-limiting examples of the "C₁-C₃₀ heterocyclic group (unsubstituted or substituted with at least one R₁ₐ)" include a thiophene group, a furan group, a pyrrole group, a silole group, borole group, a phosphole group, a selenophene group, a germole group, a benzothiophene group, a benzofuran group, an indole group, an indene group, a benzosilole group, a benzoborole group, a benzophosphole group, a benzoselenophene group, a benzogermole group, a dibenzothiophene group, a dibenzofuran group, a carbazole group, a dibenzosilole group, a dibenzoborole group, a dibenzophosphole group, a dibenzoselenophene group, a dibenzogermole group, a dibenzothiophene 5-oxide group, a 9H-fluoren-9-one group, a dibenzothiophene 5,5-dioxide group, an azabenzothiophene group, an azabenzofuran group, an azaindole group, an azaindene group, an azabenzosilole group, an azabenzoborole group, an azabenzophosphole group, an azabenzoselenophene group, an azabenzogermole group, an azadibenzothiophene group, an azadibenzofuran group, an azacarbazole group, an azafluorene group, an azadibenzosilole group, an azadibenzoborole group, an azadibenzophosphole group, an azadibenzoselenophene group, an azadibenzogermole group, an azadibenzothiophene 5-oxide group, an aza-9H-fluoren-9-one group, an azadibenzothiophene 5,5-dioxide group, a pyridine group, a pyrimidine group, a pyrazine group, a pyridazine group, a triazine group, a quinoline group, an isoquinoline group, a quinoxaline group, a quinazoline group, a phenanthroline group, a pyrazole group, an imidazole group, a triazole group, an oxazole group, an isooxazole group, a thiazole group, an isothiazole group, an oxadiazole group, a thiadiazole group, a benzopyrazole group, a benzimidazole group, a benzoxazole group, a benzothiazole group, a benzoxadiazole group, a benzothiadiazole group, a 5,6,7,8-tetrahydroisoquinoline group, a 5,6,7,8-tetrahydroquinoline group, or the like (each unsubstituted or substituted with at least one R₁ₐ).

As used herein, "TMS" represents * -Si(CH₃)₃, and as used herein "TMG" represents * -Ge(CH₃)₃.

At least one substituent of the substituted C₅-C₃₀ carbocyclic group, the substituted C₁-C₃₀ heterocyclic group, the substituted C₁-C₆₀ alkyl group, the substituted C₂-C₆₀ alkenyl group, the substituted C₂-C₆₀ alkynyl group, the substituted C₁-C₆₀ alkoxy group, the substituted C₁-C₆₀ alkylthio group, the substituted C₃-C₁₀ cycloalkyl group, the substituted C₁-C₁₀ heterocycloalkyl group, the substituted C₃-C₁₀ cycloalkenyl group, the substituted C₁-C₁₀ heterocycloalkenyl group, the substituted C₆-C₆₀ aryl group, the substituted C₇-C₆₀ alkyl aryl group, the substituted C₇-C₆₀ aryl alkyl group, the substituted C₆-C₆₀ aryloxy group, the substituted C₆-C₆₀ arylthio group, the substituted C₁-C₆₀ heteroaryl group, the substituted C₂-C₆₀ alkyl heteroaryl group, the substituted C₂-C₆₀ heteroaryl alkyl group, the substituted C₁-C₆₀ heteroaryloxy group, the substituted C₁-C₆₀ heteroarylthio group, the substituted monovalent non-aromatic condensed polycyclic group, and the substituted monovalent non-aromatic condensed heteropolycyclic group may be:
deuterium, -F, -Cl, -Br, -I, -SF₅, -CD₃, -CD₂H, -CDH₂, -CF₃, -CF₂H, - CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, a C₁-C₆₀ alkoxy group, or a C₁-C₆₀ alkylthio group,
a C₁-C₆₀ alkyl group, a C₂-C₆₀ alkenyl group, a C₂-C₆₀ alkynyl group, a C₁-C₆₀ alkoxy group, or a C₁-C₆₀ alkylthio group, each substituted with at least one of deuterium, -F, -Cl, -Br, -I, -SF₅, -CD₃, -CD₂H, -CDH₂, -CF₃, -CF₂H, - CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₇-C₆₀ alkyl aryl group, a C₆-C₆₀ aryloxy group, a C₆-C₆₀ arylthio group, a C₁-C₆₀ heteroaryl group, a C₂-C₆₀ alkyl heteroaryl group, a C₁-C₆₀ heteroaryloxy group, a C₁-C₆₀ heteroarylthio group, a monovalent non-aromatic condensed polycyclic group, a monovalent non-aromatic condensed heteropolycyclic group, -Si(Q₁₁)(Q₁₂)(Q₁₃), -Ge(Q₁₁)(Q₁₂)(Q₁₃), -C(=O)(Q₁₄), - S(=O)(Q₁₄), -S(=O)₂(Q₁₄), -N(Q₁₄)(Q₁₅), -B(Q₁₆)(Q₁₇), -P(Q₁₈)(Q₁₉), - P(=O)(Q₁₈)(Q₁₉), -P(=S)(Q₁₈)(Q₁₉), or a combination thereof;
a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₇-C₆₀ alkyl aryl group, a C₆-C₆₀ aryloxy group, a C₆-C₆₀ arylthio group, a C₁-C₆₀ heteroaryl group, a C₂-C₆₀ alkyl heteroaryl group, a C₁-C₆₀ heteroaryloxy group, a C₁-C₆₀ heteroarylthio group, a monovalent non-aromatic condensed polycyclic group, or a monovalent non-aromatic condensed heteropolycyclic group;
a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₇-C₆₀ alkyl aryl group, a C₆-C₆₀ aryloxy group, a C₆-C₆₀ arylthio group, a C₁-C₆₀ heteroaryl group, a C₂-C₆₀ alkyl heteroaryl group, a C₁-C₆₀ heteroaryloxy group, a C₁-C₆₀ heteroarylthio group, a monovalent non-aromatic condensed polycyclic group, or a monovalent non-aromatic condensed heteropolycyclic group, each substituted with at least one of deuterium, -F, -Cl, -Br, -I, -SF₅, - CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, a C₁-C₆₀ alkoxy group, a C₁-C₆₀ alkylthio group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₇-C₆₀ alkyl aryl group, a C₇-C₆₀ aryl alkyl group, a C₆-C₆₀ aryloxy group, a C₆-C₆₀ arylthio group, a C₁-C₆₀ heteroaryl group, a C₂-C₆₀ alkyl heteroaryl group, a C₂-C₆₀ heteroaryl alkyl group, a C₁-C₆₀ heteroaryloxy group, a C₁-C₆₀ heteroarylthio group, a monovalent non-aromatic condensed polycyclic group, a monovalent non-aromatic condensed heteropolycyclic group, -Si(Q₂₁)(Q₂₂)(Q₂₃), -Ge(Q₂₁)(Q₂₂)(Q₂₃), -C(=O)(Q₂₄), -S(=O)(Q₂₄), - S(=O)₂(Q₂₄), -N(Q₂₄)(Q₂₆), -B(Q₂₆)(Q₂₇), -P(Q₂₈)(Q₂₉), -P(=O)(Q₂₈)(Q₂₉), - P(=S)(Q₂₈)(Q₂₉), or a combination thereof; or
-Si(Q₃₁)(Q₃₂)(Q₃₃), -Ge(Q₃₁)(Q₃₂)(Q₃₃), -C(=O)(Q₃₄), -S(=O)(Q₃₄), - S(=O)₂(Q₃₄), -N(Q₃₄)(Q₃₆), -B(Q₃₆)(Q₃₇), -P(Q₃₈)(Q₃₉), -P(=O)(Q₃₈)(Q₃₉), or - P(=S)(Q₃₈)(Q3₉),
Q₁ to Q₉, Q₁₁ to Q₁₉, Q₂₁ to Q₂₉, and Q₃₁ to Q₃₉ may each independently be hydrogen, deuterium, -F, -Cl, -Br, -I, -SF₅, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a substituted or unsubstituted C₁-C₆₀ alkyl group, a substituted or unsubstituted C₂-C₆₀ alkenyl group, a substituted or unsubstituted C₂-C₆₀ alkynyl group, a substituted or unsubstituted C₁-C₆₀ alkoxy group, a substituted or unsubstituted C₁-C₆₀ alkylthio group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₇-C₆₀ alkyl aryl group, a substituted or unsubstituted C₇-C₆₀ aryl alkyl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted C₂-C₆₀ alkyl heteroaryl group, a substituted or unsubstituted C₂-C₆₀ heteroaryl alkyl group, a substituted or unsubstituted C₁-C₆₀ heteroaryloxy group, a substituted or unsubstituted C₁-C₆₀ heteroarylthio group, a substituted or unsubstituted monovalent non-aromatic condensed polycyclic group, or a substituted or unsubstituted monovalent non-aromatic condensed heteropolycyclic group.

In one or more embodiments, a full width at half maximum (FWHM) of an emission peak of an emission spectrum or an electroluminescence spectrum of the organometallic compound may be about 60 nanometers (nm) or less. For example, a FWHM of the emission spectrum or the electroluminescence spectrum of the organometallic compound may be about 5 nm to about 50 nm, about 7 nm to about 40 nm, or about 10 nm to about 30 nm.

### n-doped layer

In one or more embodiments, the n-doped layer may include an electron transport compound and an n-dopant.

In one or more embodiments, the electron transport compound may include at least one of a cyano group, a π electron-deficient nitrogen-containing cyclic group, an electron transport moiety, or a combination thereof.

In one or more embodiments, the term "π electron-deficient nitrogen-containing cyclic group" as used herein refers to a ring group having at least one *-N=*' moiety, and for example, may be an imidazole group, a pyrazole group, a thiazole group, an isothiazole group, an oxazole group, an isoxazole group, a pyridine group, a pyrazine group, a pyridazine group, a pyrimidine group, an indazole group, a purine group, a quinoline group, an isoquinoline group, a benzoquinoline group, a phthalazine group, a naphthyridine group, a quinoxaline group, a quinazoline group, a cinnoline group, a phenanthridine group, an acridine group, a phenanthroline group, a phenazine group, a benzimidazole group, an isobenzothiazole group, a benzoxazole group, an isobenzoxazole group, a triazole group, a tetrazole group, an oxadiazole group, a triazine group, a thiadiazole group, an imidazopyridine group, an imidazopyrimidine group, an azacarbazole group, or the like; or a condensed cyclic group wherein two or more π electron-deficient nitrogen-containing cyclic groups are condensed with each other.

**In** one or more embodiments, the electron transport moiety as used herein may be at least one of a cyano group, a π electron-deficient nitrogen-containing cyclic group, or a group including one of the following Formulae: 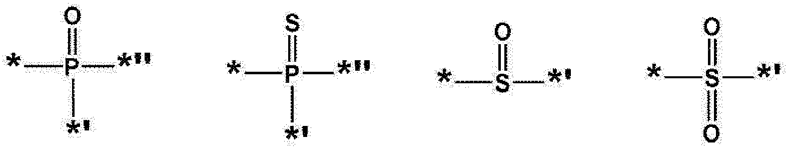 wherein, in the above Formulae, *, *', and *" each indicate a binding site to a neighboring atom.

In one or more embodiments, the electron transport compound may include a cyano group, pyridine group, a pyrimidine group, pyrazine group, a triazine group, a quinoline group, an isoquinoline group, or a combination thereof.

In one or more embodiments, the electron transport compound may be understood by referring to the description of a material for the electron transport region.

In one or more embodiments, the n-dopant may include a metal.

In one or more embodiments, the n-dopant may include at least one of an alkali metal, an alkali metal-containing compound, an alkali metal complex, an alloy of an alkali metal, an alkaline earth metal, an alloy of an alkaline earth metal, an alkaline earth metal-containing compound, an alkaline earth-metal complex, a rare earth metal, an alloy of a rare earth metal, a rare earth metal-containing compound, or a rare earth metal complex, for example, a lanthanide metal, an alloy of a lanthanide metal, a lanthanide metal-containing compound, or a lanthanide metal complex.

In one or more embodiments, the alkali metal may be Li, Na, K, Rb, Cs, or a combination thereof.

In one or more embodiments, the alkaline earth metal may be Mg, Ca, Sr, Ba, or a combination thereof.

In one or more embodiments, the rare earth metal may be Sc, Y, Ce, Tb, Yb, Gd, or a combination thereof.

In one or more embodiments, the lanthanide metal may be lanthanum, cerium, praseodymium, neodymium, promethium, samarium, europium, gadolinium, terbium, dysprosium, holmium, erbium, thulium, ytterbium, lutetium, or a combination thereof.

In one or more embodiments, the alkali metal-containing compound may include an alkali metal oxides, for example Li₂O, Cs₂O, K₂O, or the like; an alkali metal halide, for example LiF, NaF, CsF, KF, Lil, Nal, CsI, KI, or the like; or a combination thereof.

In one or more embodiments, the alkaline earth metal-containing compound may include an alkaline earth metal compound, for example BaO, SrO, CaO, BaₓSr₁₋ₓO (wherein x is a real number satisfying the condition of 0<x<1), BaₓCa₁ₓO (wherein x is a real number satisfying the condition of 0<x<1), or the like.

In one or more embodiments, the rare earth metal-containing compound may include YbF₃, ScF₃, Sc₂O₃, Y₂O₃, Ce₂O₃, GdF₃, TbF₃, Ybl₃, SCl₃, TbI₃, or the like, or a combination thereof. In some embodiments, the rare earth metal-containing compound may include a lanthanide metal telluride.

In one or more embodiments, the lanthanide metal telluride may include LaTe, CeTe, PrTe, NdTe, PmTe, SmTe, EuTe, GdTe, TbTe, DyTe, HoTe, ErTe, TmTe, YbTe, LuTe, La₂Te₃, Ce₂Te₃, Pr₂Te₃, Nd₂Te₃, Pm₂Te₃, Sm₂Te₃, Eu₂Te₃, Gd₂Te₃, Tb₂Te₃, Dy₂Te₃, Ho₂Te₃, Er₂Te₃, Tm₂Te₃, Yb₂Te₃, Lu₂Te₃, or the like, or a combination thereof.

In one or more embodiments, the alkali metal complex, the alkaline earth-metal complex, and the rare earth metal complex may include i) one of ions of the alkali metal, the alkaline earth metal, and the rare earth metal, and ii), as a ligand linked to the metal ion, for example, hydroxyquinoline, hydroxyisoquinoline, hydroxybenzoquinoline, hydroxyacridine, hydroxyphenanthridine, hydroxyphenyloxazole, hydroxyphenylthiazole, hydroxyphenyloxadiazole, hydroxyphenylthiadiazole, hydroxyphenylpyridine, hydroxyphenyl benzimidazole, hydroxyphenylbenzothiazole, bipyridine, phenanthroline, cyclopentadiene, or a combination thereof.

In one or more embodiments, the n-dopant may include an organic dopant.

In one or more embodiments, the organic layer may further include a hole transport region arranged between the anode and the emission layer.

In one or more embodiments, the hole transport region may further include a hole injection layer, a hole transport layer, an electron blocking layer, a buffer layer, or a combination thereof.

In one or more embodiments, the n-doped layer may be arranged between the anode and the hole transport region.

In one or more embodiments, the organic layer may further include a p-doped layer.

In one or more embodiments, the p-doped layer may be arranged between the n-doped layer and the hole transport region.

In one or more embodiments, the p-doped layer may include a hole transport compound and a p-dopant. The hole transport compound may be understood by referring to the description herein of the p-dopant.

In one or more embodiments, the organic layer may further include an electron transport region arranged between the emission layer and the cathode.

In one or more embodiments, the electron transport region may include a hole blocking layer, an electron transport layer, an electron injection layer, or a combination thereof.

In one or more embodiments, the emission layer may include a host and a dopant, and the dopant may include at least one of the organometallic compounds described herein.

In one or more embodiments, based on weight, an amount of the host in the emission layer may be greater than an amount of the at least one organometallic compound in the emission layer.

In one or more embodiments, the emission layer may emit a red light, a green light, or a blue light. For example, the emission layer may emit a red light having a maximum emission wavelength of about 600 nm to about 750 nm, such as about 600 nm to about 650 nm or about 610 nm to about 630 nm. For example, the emission layer may emit a green light having a maximum emission wavelength of about 495 nm to about 580 nm. For example, the emission layer may emit a blue light having a maximum emission wavelength of about 410 nm to about 490 nm.

Since the organic light-emitting device has an emission layer including at least one organometallic compound, for example at least one organometallic compound represented by Formula 1, the organic light-emitting device may have a relatively narrow FWHM in the emission peak of the electroluminescence spectrum and also have excellent efficiency and lifespan characteristics.

In one or more embodiments, the at least one organometallic compound may act as a dopant (for example, an emitter or a sensitizer) in the emission layer, and the emission layer may further include a host (that is, the amount of the at least one organometallic compound in the emission layer may be less than the amount of the host in the emission layer, based on weight). In one or more embodiments, an amount of the host in the emission layer may be greater than an amount of the at least one organometallic compound in the emission layer, based on weight.

The expression "(an emission layer) includes at least one organometallic compound (represented by Formula 1)" as used herein may include a case in which "(an emission layer) includes identical organometallic compounds (represented by Formula 1)" and a case in which "(an emission layer) includes two or more different organometallic compounds (represented by Formula 1)."

For example, the emission layer may include, as the at least one organometallic compound, only Compound 1. In this regard, Compound 1 may be present in the emission layer of the organic light-emitting device. In some embodiments, the emission layer may include, as the at least one organometallic compound, Compound 1 and Compound 2. In this regard, Compound 1 and Compound 2 may be present in the emission layer of the organic light-emitting device.

### Tandem device

In the organic light-emitting device according to one or more embodiments, the organic layer may include n emission units; and n-1 charge generation units arranged between two neighboring emission units. Each of the n emission units may include an emission layer.

In one or more embodiments, n may be an integer of 2 or greater.

That is, the organic light-emitting device may have a tandem structure in which a plurality of emission units are vertically stacked between the anode and the cathode. For example, n may be 2, 3, 4, 5, 6, 7, 8, 9, or 10. In one or more embodiments, n may be 2, 3, 4, 5, or 6.

A light emitted from each of the n emission units may be identical to or different from each other.

In one or more embodiments, a light emitted from each of the n emission units may be a red light.

In one or more embodiments, a light emitted from each of the n emission units may be a green light.

In one or more embodiments, a light emitted from each of the n emission units may be a blue light.

In some embodiments, a light emitted from at least one emission unit among the n emission units may be a red light. In some embodiments, a light emitted from at least one emission unit among the n emission units may be a green light, and a light emitted from at least one emission unit among the remaining emission units may be a blue light.

The organic light-emitting device may further include a substrate including a red subpixel, a green subpixel, and/or a blue subpixel, wherein the anode may be patterned for each red subpixel, green subpixel, and/or blue subpixel, the emission layer may include a red emission layer arranged in the red subpixel area, a green emission layer arranged in the green subpixel area, and/or a blue emission layer arranged in the blue subpixel area, and at least one of the red emission layer, green emission layer, and/or blue emission layer may include the at least one organometallic compound. That is, the organic light-emitting device may be a full color light-emitting device.

### Emission unit of tandem device

In one or more embodiments, at least one of the n emission units may include an emission layer including the at least one organometallic compound.

In one or more embodiments, the n-doped layer may be arranged between the anode and the hole transport region, or at least one of the n-1 charge generation units may include the n-doped layer.

In one or more embodiments, the n emission units may include an m emission unit that is the m^{th} nearest to the anode. Here, m may be an integer from 1 to n. That is, the emission unit that is m^{th} nearest to the anode among the n emission units may be referred to as the m^{th} emission unit.

In one or more embodiments, the at least one organometallic compound may be included in any one of the emission units excluding the first emission unit among the n emission units.

In one or more embodiments, the n emission units may include a k^{th} emission unit which is the k^{th} nearest to the anode, and k may be an integer from 2 to n, and the k^{th} emission unit may include an emission layer including the at least one organometallic compound. That is the emission unit that is k^{th} nearest to the anode among the n emission units may be referred to as the k^{th} emission unit.

In one or more embodiments, the m^{th} emission unit may include an m^{th} emission layer.

In one or more embodiments, the m^{th} emission unit may further include an m^{th} hole transport region arranged between the first electrode and the m^{th} emission layer.

In one or more embodiments, the m^{th} hole transport region may include an m^{th} hole injection layer, an m^{th} hole transport layer, an m^{th} electron blocking layer, an m^{th} buffer layer, or a combination thereof.

In one or more embodiments, the m^{th} emission unit may further include an m^{th} electron transport region arranged between the m^{th} emission layer and the cathode.

In one or more embodiments, the m^{th} electron transport region may include an m^{th} hole blocking layer, an m^{th} electron transport layer, an m^{th} electron injection layer, or a combination thereof.

### Charge generation unit of tandem device

In one or more embodiments, the n-1 charge generation units may include a j^{th} charge generation unit that is the j^{th} nearest to the first electrode. Here, j may be an integer from 1 to n-1. That is, the charge generation unit that is j^{th} nearest to the first electrode among the n-1 charge generation units may be referred to as the j^{th} charge generateion unit.

In one or more embodiments, the j^{th} charge generation unit may include a j^{th} n-type charge generation layer and a j^{th} p-type charge generation layer.

In one or more embodiments, the j^{th} n-type charge generation layer may be arranged nearer to the anode than the j^{th} p-type charge generation layer. For example, the organic light-emitting device may have a structure in which the anode, the j^{th} emission unit, the j^{th} n-type charge generation layer, and the j^{th} p-type charge generation layer are sequentially stacked in the stated order.

In one or more embodiments, the j^{th} n-type charge generation layer may be the n-doped layer.

In one or more embodiments, the j^{th} p-type charge generation layer may be the p-doped layer.

In one or more embodiments, the n-doped layer may be arranged nearer to the anode than to the emission layer.

In one or more embodiments, the k^{th} emission unit may include the emission layer including the at least one organometallic compound, and the (k-1)^{th} charge generation unit may include the n-doped layer, wherein k may be an integer of 2 to n.

Because the organic light-emitting device has a structure as described herein, the cation formed from the anode may be effectively removed by a free electron formed from an n-doped layer, thereby preventing the silyl group and/or the germyl group of the at least one organometallic compound from being decomposed. Accordingly, by including the at least one organometallic compound including the at least one silyl group and/or the at least one germyl group in the emission layer, the organic light-emitting device may achieve a high luminescence efficiency, a high color purity, and/or an excellent processability, and the degradation of the at least one organometallic compound may be prevented to provide a high luminescence efficiency and/or a long lifespan.

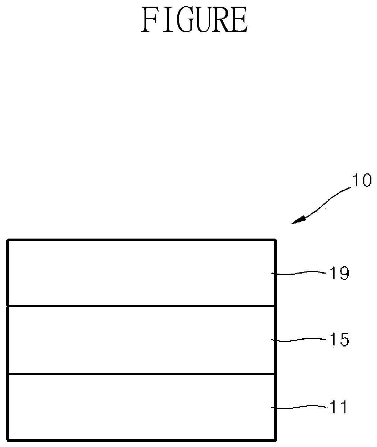

### Description of FIG. 1

The FIGURE is a schematic cross-sectional view of an organic light-emitting device 10 according to one or more embodiments, but embodiments are not limited thereto. Hereinafter, the structure and manufacturing method of the organic light-emitting device 10 according to one or more exemplary embodiments will be described in further detailed with connection to the FIGURE. The organic light-emitting device 10 includes an anode 11, an organic layer 15, and a cathode 19, which are sequentially stacked in the stated order.

A substrate may be additionally disposed under the anode 11 or on the cathode 19. The substrate may be a conventional substrate used in organic light-emitting devices, for example, a glass substrate or a transparent plastic substrate, each having excellent mechanical strength, thermal stability, transparency, surface smoothness, ease of handling, and/or water repellency.

The anode 11 may be produced by depositing or sputtering, onto the substrate, a material for forming the first electrode 11. The material for forming the anode 11 may be selected from materials with a high work function for easy hole injection. The anode 11 may be a reflective electrode, a semi-transmissive electrode, or a transmissive electrode. The material for forming the anode 11 may be indium tin oxide (ITO), indium zinc oxide (IZO), tin oxide (SnO₂), or zinc oxide (ZnO). In some embodiments, the material for forming the anode 11 may be metal, such as magnesium (Mg), aluminum (Al), silver (Ag), aluminum-lithium (Al-Li), calcium (Ca), magnesium-indium (Mg-In), or magnesium-silver (Mg-Ag).

The anode 11 may have a single-layered structure or a multi-layered structure including a plurality of layers. For example, the anode 11 may have a three-layered structure of ITO/Ag/ITO, but the structure of the first electrode 11 is not limited thereto.

The organic layer 15 may be located on the anode 11.

The organic layer 15 may include a hole transport region, an emission layer, and an electron transport region.

The hole transport region may be arranged between the anode 11 and the emission layer.

The hole transport region may include a hole injection layer, a hole transport layer, an electron blocking layer, a buffer layer, or a combination thereof.

The hole transport region may include only either a hole injection layer, or a hole transport layer. In some embodiments, the hole transport region may have a hole injection layer/hole transport layer structure, or a hole injection layer/hole transport layer/electron blocking layer structure, wherein, for each structure, respective layers are sequentially stacked in this stated order from the anode 11.

When the hole transport region includes a hole injection layer, the hole injection layer may be formed on the anode 11 by using one or more suitable methods, for example, vacuum deposition, spin coating, casting, and/or Langmuir-Blodgett (LB) deposition, but embodiments are not limited thereto.

When the hole injection layer is formed by vacuum deposition, the deposition conditions may vary according to a material that is used to form the hole injection layer, and the structure and thermal characteristics of the hole injection layer. For example, the deposition conditions may include a deposition temperature of about 100°C to about 500°C, a vacuum pressure in a range of about 10⁻⁸ torr to about 10⁻³ torr, and a deposition rate of about 0.01 angstroms per second (Å/sec) to about 100 Å/sec. However, the deposition conditions are not limited thereto.

When the hole injection layer is formed by spin coating, the coating conditions may vary according to a material that is used to form the hole injection layer, and the structure and thermal characteristics of the hole injection layer. For example, the coating conditions may include a coating speed of about 2,000 revolutions per minute (rpm) to about 5,000 rpm, and a heat treatment temperature for removing a solvent after coating may be about 80°C to about 200°C. However, the coating conditions are not limited thereto.

The conditions for forming the hole transport layer and the electron blocking layer may be similar to or the same as the conditions for forming the hole injection layer.

The hole transport region may include a hole transport compound.

The hole transport compound may include at least one of 4,4',4"-tris(3-methylphenylphenylamino)triphenylamine (m-MTDATA), 4,4',4"-tris(N,N-diphenylamino)triphenylamine (TDATA), 4,4',4"-tris{N-(2-naphthyl)-N-phenylamino}-triphenylamine (2-TNATA), N,N'-di(1-naphthyl)-N,N'-diphenylbenzidine (NPB), β-NPB, N,N'-bis(3-methylphenyl)-N,N'-diphenyl-[1,1-biphenyl]-4,4'-diamine (TPD), spiro-TPD, spiro-NPB, methylated NPB, 4,4'-cyclohexylidene bis[N,N-bis(4-methylphenyl)benzenamine] (TAPC), 4,4'-bis[N,N'-(3-tolyl)amino]-3,3'-dimethylbiphenyl (HMTPD), 4,4',4"-tris(N-carbazolyl)triphenylamine (TCTA), polyaniline/dodecylbenzenesulfonic acid (PANI/DBSA), poly(3,4-ethylenedioxythiophene)/poly(4-styrenesulfonate) (PEDOT/PSS), polyaniline/camphor sulfonic acid (PANI/CSA), (polyaniline)/poly(4-styrenesulfonate) (PANI/PSS), a compound represented by Formula 201, or a compound represented by Formula 202, but embodiments are not limited thereto:

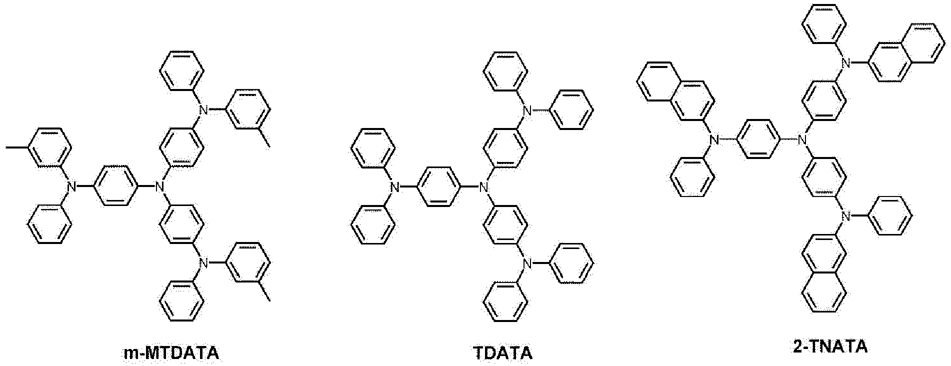

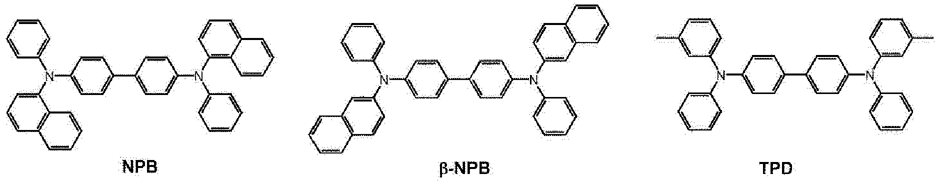

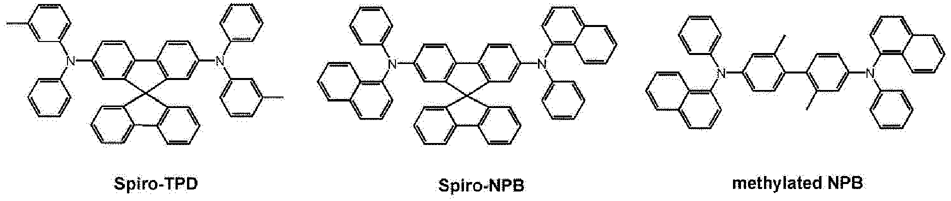

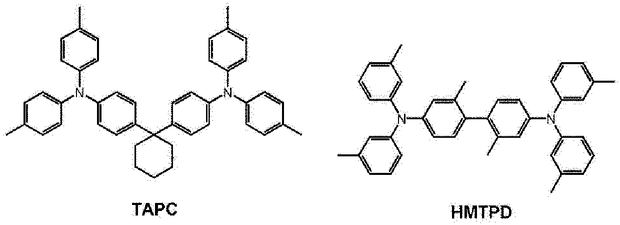

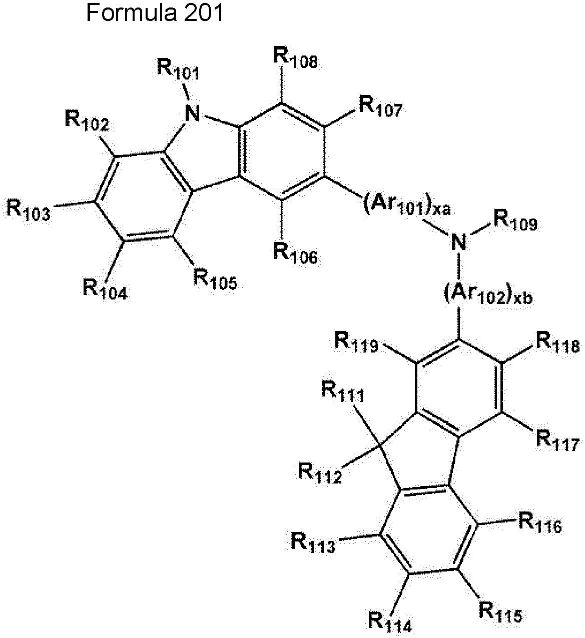

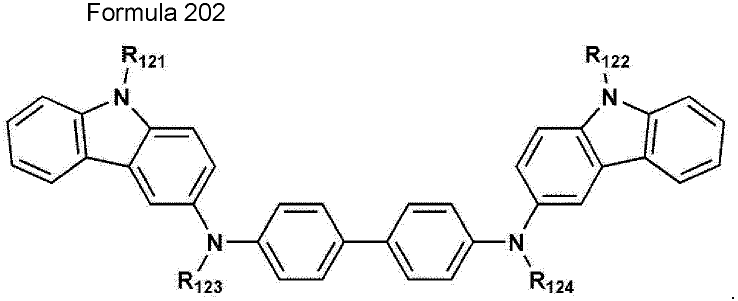

Ar₁₀₁ and Ar₁₀₂ in Formula 201 may each independently be:
a phenylene group, a pentalenylene group, an indenylene group, a naphthylene group, an azulenylene group, a heptalenylene group, an acenaphthylene group, a fluorenylene group, a phenalenylene group, a phenanthrenylene group, an anthracenylene group, a fluoranthenylene group, a triphenylenylene group, a pyrenylene group, a chrysenylenylene group, a naphthacenylene group, a picenylene group, a perylenylene group, or a pentacenylene group; or
a phenylene group, a pentalenylene group, an indenylene group, a naphthylene group, an azulenylene group, a heptalenylene group, an acenaphthylene group, a fluorenylene group, a phenalenylene group, a phenanthrenylene group, an anthracenylene group, a fluoranthenylene group, a triphenylenylene group, a pyrenylene group, a chrysenylenylene group, a naphthacenylene group, a picenylene group, a perylenylene group, or a pentacenylene group, each substituted with at least one of deuterium, -F, -Cl, -Br, -I, -SF₅, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, a C₁-C₆₀ alkoxy group, a C₁-C₆₀ alkylthio group, a C₃-C₁₉ cycloalkyl group, a C₃-C₁₉ cycloalkenyl group, a C₁-C₁₀ heterocycloalkyl group, a C₁-C₁₀ heterocycloalkenyl group, a C₆-C₆₀ aryl group, a C₇-C₆₀ alkyl aryl group, a C₇-C₆₀ aryl alkyl group, a C₆-C₆₀ aryloxy group, a C₆-C₆₀ arylthio group, a C₁-C₆₀ heteroaryl group, a C₂-C₆₀ alkyl heteroaryl group, a C₂-C₆₀ heteroaryl alkyl group, a C₁-C₆₀ heteroaryloxy group, a C₁-C₆₀ heteroarylthio group, a monovalent non-aromatic condensed polycyclic group, a monovalent non-aromatic condensed heteropolycyclic group, or a combination thereof.

xa and xb in Formula 201 may each independently be an integer from 0 to 5, or 0, 1, or 2. For example, xa may be 1 and xb may be 0, but xa and xb are not limited thereto.

R₁₀₁ to R₁₀₈, R₁₁₁ to R₁₁₉ and R₁₂₁ to R₁₂₄ in Formulae 201 and 202 may each independently be:
hydrogen, deuterium, -F, -Cl, -Br, -I, -SF₅, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₁₀ alkyl group (for example, a methyl group, an ethyl group, a propyl group, a butyl group, pentyl group, a hexyl group, or the like), a C₁-C₁₀ alkoxy group (for example, a methoxy group, an ethoxy group, a propoxy group, a butoxy group, a pentoxy group, or the like), or a C₁-C₁₀ alkylthio group;
a C₁-C₁₀ alkyl group, a C₁-C₁₀ alkoxy group, or a C₁-C₁₀ alkylthio group, each substituted with at least one of deuterium, -F, -Cl, -Br, -I, -SF₅, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, or a combination thereof;
a phenyl group, a naphthyl group, an anthracenyl group, a fluorenyl group, or a pyrenyl group; or
a phenyl group, a naphthyl group, an anthracenyl group, a fluorenyl group, or a pyrenyl group, each substituted with at least one of deuterium, -F, -Cl, -Br, -I, -SF₅, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₁₀ alkyl group, a C₁-C₁₀ alkoxy group, a C₁-C₁₀ alkylthio group, or a combination thereof, but embodiments are not limited thereto.

R₁₀₉ in Formula 201 may be:
a phenyl group, a naphthyl group, an anthracenyl group, or a pyridinyl group; or
a phenyl group, a naphthyl group, an anthracenyl group, or a pyridinyl group, each substituted with at least one of deuterium, -F, -Cl, -Br, -I, -SF₅, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₂₀ alkyl group, a C₁-C₂₀ alkoxy group, a C₁-C₂₀ alkylthio group, a phenyl group, a naphthyl group, an anthracenyl group, a pyridinyl group, or a combination thereof.

According to one or more embodiments, the compound represented by Formula 201 may be represented by Formula 201A, but embodiments are not limited thereto:

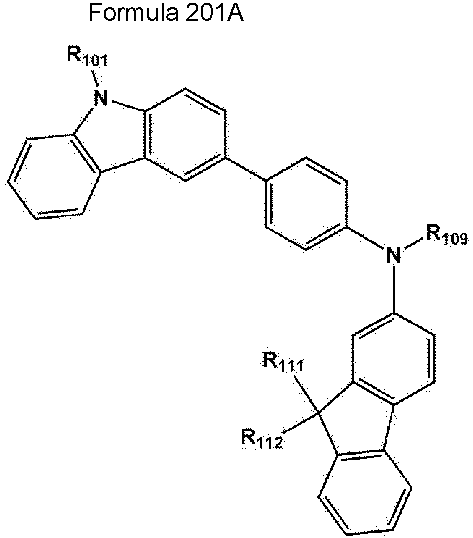

R₁₀₁, R₁₁₁, R₁₁₂, and R₁₀₉ in Formula 201A may each be as described herein.

For example, the compound represented by Formula 201 and the compound represented by Formula 202 may include one or more of Compounds HT1 to HT21, but embodiments are not limited thereto:

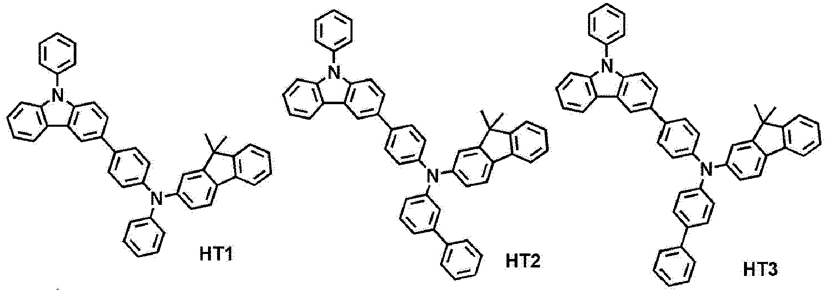

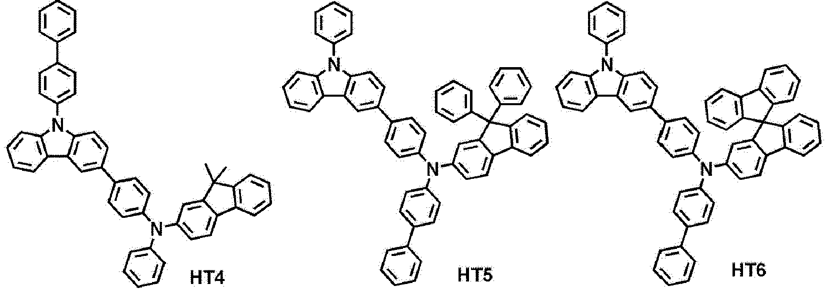

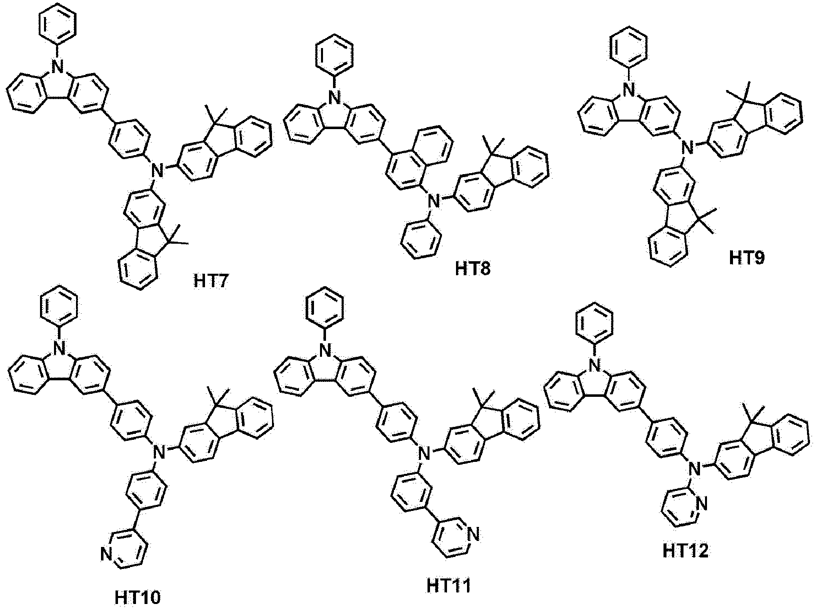

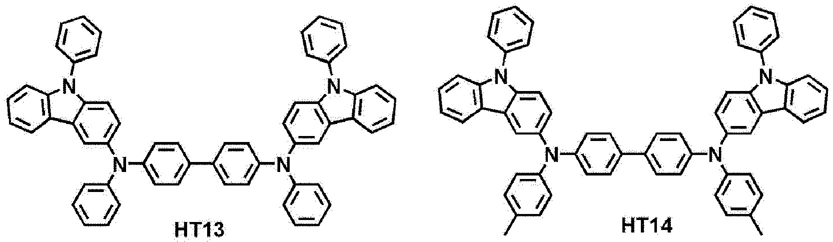

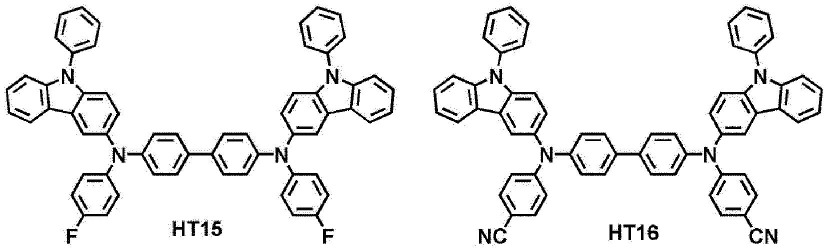

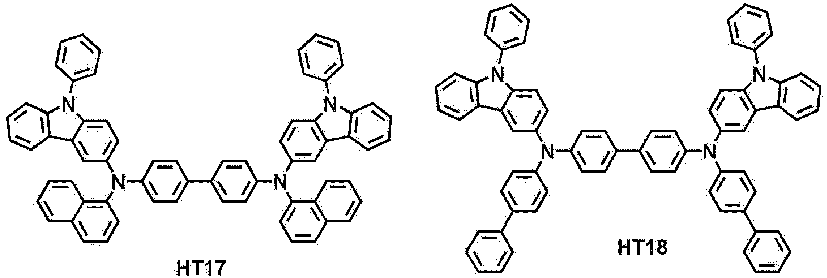

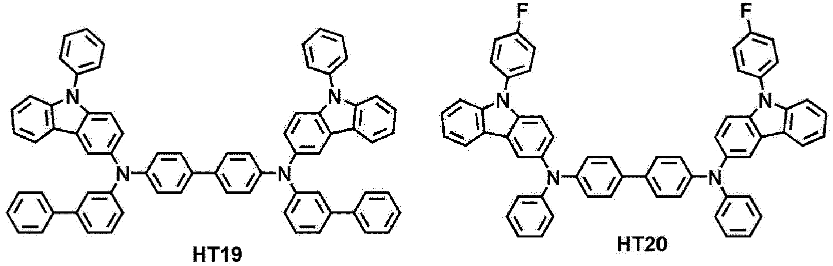

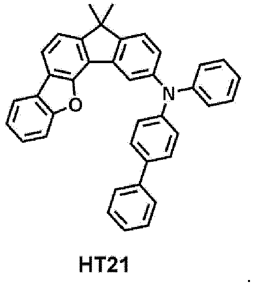

A thickness of the hole transport region may be about 100 Å to about 10,000 Å, for example, about 100 Å to about 1,000 Å. When the hole transport region includes at least one of a hole injection layer and a hole transport layer, a thickness of the hole injection layer may be about 100 Å to about 10,000 Å, for example, about 100 Å to about 1,000 Å, and a thickness of the hole transport layer may be about 50 Å to about 2,000 Å, for example, about 100 Å to about 1,500 Å. Without wishing to be bound to theory, when the thicknesses of the hole transport region, the hole injection layer and the hole transport layer are within these ranges, satisfactory hole transporting characteristics may be obtained without a substantial increase in driving voltage.

The hole transport region may further include, in addition to these materials, a charge-generation material for the improvement of conductive properties. The charge-generation material may be homogeneously or non-homogeneously dispersed in the hole transport region.

The charge-generation material may be, for example, a p-dopant. The p-dopant may be one of a quinone derivative, a metal oxide, or a cyano group-containing compound, but embodiments are not limited thereto. Non-limiting examples of the p-dopant include a quinone derivative, for example tetracyanoquinodimethane (TCNQ), 2,3,5,6-tetrafluoro-tetracyano-1,4-benzoquinonedimethane (F4-TCNQ), 1,3,4,5,7,8-hexafluorotetracyanonaphthoquinodimethane (F6-TCNNQ), or the like; a metal oxide, for example a tungsten oxide, a molybdenum oxide, or the like; or a cyano group-containing compound, such as one of Compounds HT-D1 or F12, but embodiments are not limited thereto:

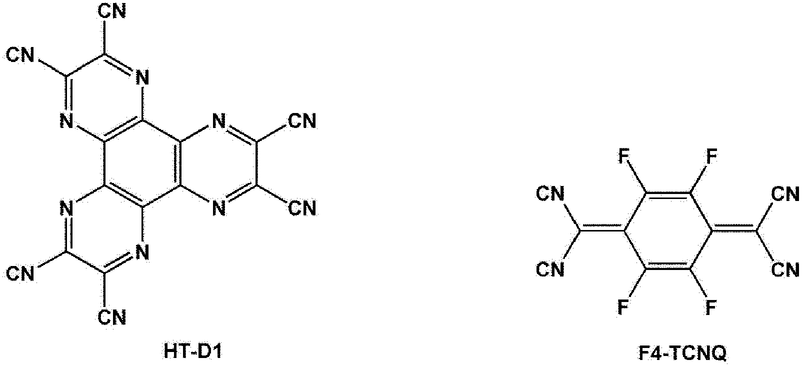

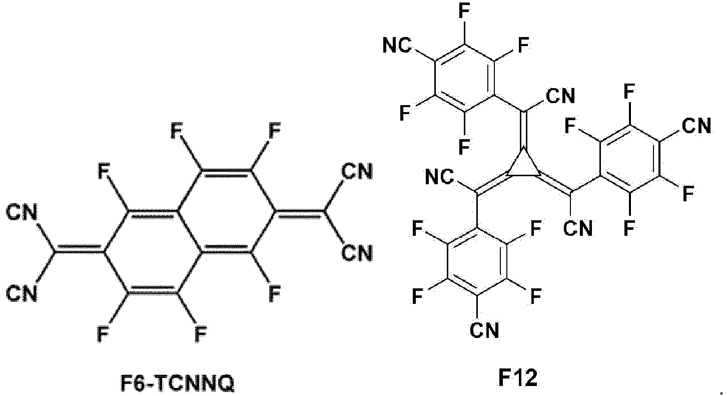

The hole transport region may include a buffer layer.

In one or more embodiments, the buffer layer may compensate for an optical resonance distance according to a wavelength of light emitted from the emission layer, and thus, efficiency of a formed organic light-emitting device may be improved.

Then, an emission layer may be formed on the hole transport region by vacuum deposition, spin coating, casting, LB deposition, or the like. When the emission layer is formed by vacuum deposition or spin coating, the deposition or coating conditions may be similar to those applied in forming the hole injection layer, although the deposition or coating conditions may vary according to a material that is used to form the emission layer.

Meanwhile, when the hole transport region includes an electron blocking layer, a material for the electron blocking layer may be selected from materials for the hole transport region described above and materials for a host to be explained later. However, the material for the electron blocking layer is not limited thereto. For example, when the hole transport region includes an electron blocking layer, a material for the electron blocking layer may be mCP, which will be explained later.

The emission layer may include a host and a dopant, and the dopant may include the at least one organometallic compound including at least one silyl group or at least one germyl group, for example at least one organometallic compound represented by Formula 1.

The host may include at least one of 1,3,5-tri(1-phenyl-1H-benzo[d]imidazol-2-yl)benzene (TPBi), 3-tert-butyl-9,10-di(naphth-2-yl)anthracene (TBADN), 9,10-di(naphthalene-2-yl)anthracene (ADN) (also referred to as "DNA"), 4,4'-bis(N-carbazolyl)-1,1'-biphenyl (CBP), 4,4'-bis(9-carbazolyl)-2,2'-dimethyl-biphenyl (CDBP), 1,3,5-tris(carbazole-9-yl)benzene (TCP), 1,3-bis(N-carbazolyl)benzene (mCP), Compound H50, or Compound H51, but embodiments are not limited thereto:

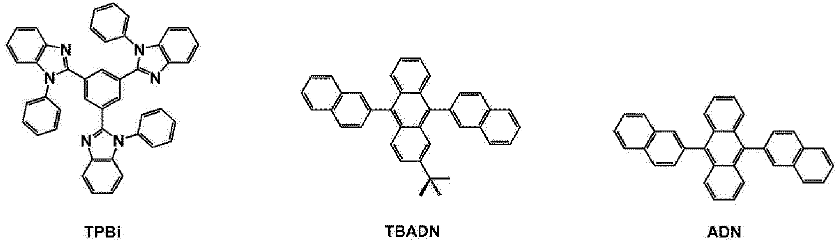

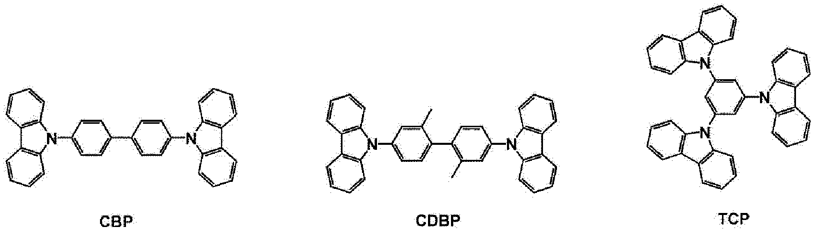

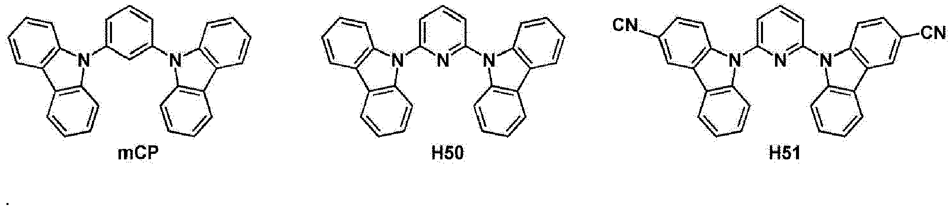

In some embodiments, the host may further include a compound represented by Formula 301, but embodiments are not limited thereto:

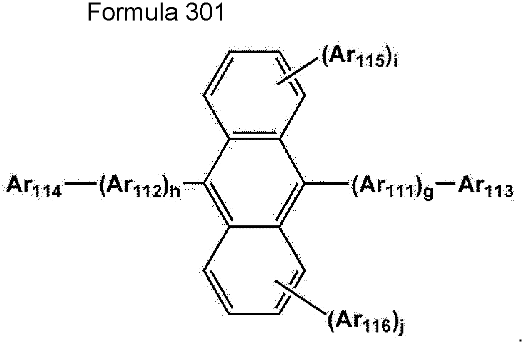

Ar₁₁₁ and Ar₁₁₂ in Formula 301 may each independently be:
a phenylene group, a naphthylene group, a phenanthrenylene group, or a pyrenylene group; or
a phenylene group, a naphthylene group, a phenanthrenylene group, or a pyrenylene group, each substituted with at least one of a phenyl group, a naphthyl group, an anthracenyl group, or a combination thereof.

Ar₁₁₃ to Ar₁₁₆ in Formula 301 may each independently be:
a C₁-C₁₀ alkyl group, a phenyl group, a naphthyl group, a phenanthrenyl group, or a pyrenyl group; or
a phenyl group, a naphthyl group, a phenanthrenyl group, or a pyrenyl group, each substituted with at least one of a phenyl group, a naphthyl group, an anthracenyl group, or a combination thereof.

g, h, i, and j in Formula 301 may each independently be an integer from 0 to 4, and g, h, i, and j may each independently be, for example, 0, 1, or 2.

Ar₁₁₃ to Ar₁₁₆ in Formula 301 may each independently be:
a C₁-C₁₀ alkyl group which is unsubstituted or substituted with at least one of a phenyl group, a naphthyl group, an anthracenyl group, or a combination thereof;
a phenyl group, a naphthyl group, an anthracenyl group, a pyrenyl group, a phenanthrenyl group, or a fluorenyl group;
a phenyl group, a naphthyl group, an anthracenyl group, a pyrenyl group, a phenanthrenyl group, or a fluorenyl group, each substituted with at least one of deuterium, -F, -Cl, -Br, -I, -SF₅, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, a C₁-C₆₀ alkoxy group, a C₁-C₆₀ alkylthio group, a phenyl group, a naphthyl group, an anthracenyl group, a pyrenyl group, a phenanthrenyl group, a fluorenyl group, or a combination thereof; or
a group of formula: 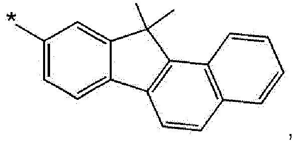 but embodiments are not limited thereto.

In some embodiments, the host may include a compound represented by Formula 302, but embodiments are not limited thereto:

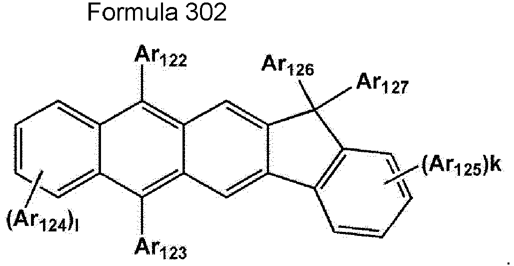

Ar₁₂₂ to Ar₁₂₅ in Formula 302 may be as described for Ar₁₁₃ in Formula 301.

Ar₁₂₆ and Ar₁₂₇ in Formula 302 may each independently be a C₁-C₁₀ alkyl group (for example, a methyl group, an ethyl group, a propyl group, or the like).

k and I in Formula 302 may each independently be an integer from 0 to 4. For example, k and I may each independently be 0, 1, or 2.

When the organic light-emitting device 10 is a full-color organic light-emitting device 10, the emission layer may be patterned into a red emission layer, a green emission layer, and/or a blue emission layer. In some embodiments, due to a stacked structure including a red emission layer, a green emission layer, and/or a blue emission layer, the emission layer may emit a white light.

The dopant in the emission layer may further include a compound including at least one metal, in addition to the at least one organometallic compound described herein.

In one or more embodiments, the compound including a metal may include at least one metal (M₂₁) that is a transition metal, and an organic ligand (L₂₁), and L₂₁ and M₂₁ may form 1, 2, 3, or 4 cyclometallated rings.

In one or more embodiments, the compound including the metal may be represented by Formula 101:

Formula 101 M₂₁(L₂₁)ₙ₂₁(L₂₂)ₙ₂₂

wherein, in Formula 101,
   M₂₁ may be a transition metal,
   L₂₁ may be a ligand represented by one of Formulae 1-1 to 1-4;
   L₂₂ may be a monodentate ligand or a bidentate ligand,
   n21 may be 1, 2, or 3,
   n22 may be 0, 1, or 2, 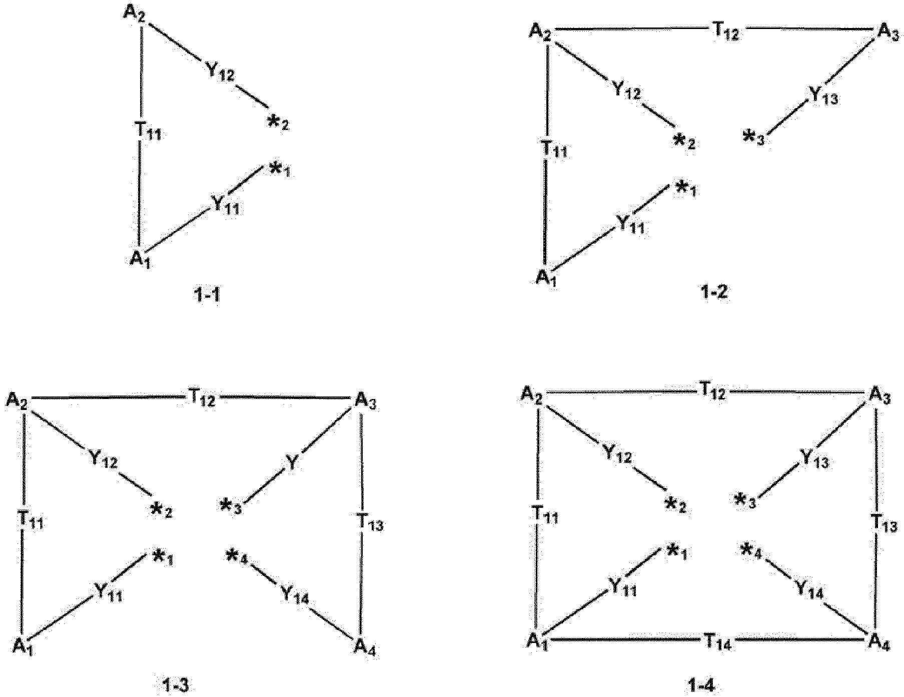
wherein, in Formulae 1-1 to 1-4,
   A₁ to A₄ may each independently be a substituted or unsubstituted C₅-C₃₀ carbocyclic group, a substituted or unsubstituted C₁-C₃₀ heterocyclic group, or a non-cyclic group,
   Y₁₁ to Y₁₄ may each independently be a chemical bond, O, S, N(R₉₁), B(R₉₁), P(R₉₁), or C(R₉₁)(R₉₂),
   T₁₁ to T₁₄ may each independently be a single bond, a double bond, *-N(R₉₃)-*', *-B(R₉₃)-*', *-P(R₉₃)-*', *-C(R₉₃)(R₉₄)-*', *-Si(R₉₃)(R₉₄)-*', *-Ge(R₉₃)(R₉₄)-*', *-S-*', *-Se-*', *-O-*', *-C(=O)-*', *-S(=O)-*', *-S(=O)₂-*', *-C(R₉₃)=*', *=C(R₉₃)-*', *-C(R₉₃)=C(R₉₄)-*', *-C(=S)-*', or *-C≡C-*',
   a substituent of the substituted C₅-C₃₀ carbocyclic group, a substituent of the substituted C₁-C₃₀ heterocyclic group, and R₉₁ to R₉₄ may each independently be hydrogen, deuterium, -F, -Cl, -Br, -I, -SF₅, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a substituted or unsubstituted C₁-C₆₀ alkyl group, a substituted or unsubstituted C₂-C₆₀ alkenyl group, a substituted or unsubstituted C₂-C₆₀ alkynyl group, a substituted or unsubstituted C₁-C₆₀ alkoxy group, a substituted or unsubstituted C₁-C₆₀ alkylthio group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₇-C₆₀ alkyl aryl group, a substituted or unsubstituted C₇-C₆₀ aryl alkyl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted C₂-C₆₀ alkyl heteroaryl group, a substituted or unsubstituted C₂-C₆₀ heteroaryl alkyl group, a substituted or unsubstituted C₁-C₆₀ heteroaryloxy group, a substituted or unsubstituted C₁-C₆₀ heteroarylthio group, a substituted or unsubstituted monovalent aromatic condensed polycyclic group, a substituted or unsubstituted monovalent aromatic condensed heteropolycyclic group, a substituted or unsubstituted monovalent non-aromatic condensed polycyclic group, a substituted or unsubstituted monovalent non-aromatic condensed heteropolycyclic group, -Si(Q₁)(Q₂)(Q₃), -Ge(Q₁)(Q₂)(Q₃), - C(Q₁)(Q₂)(Q₃), -B(Q₁)(Q₂), -N(Q₁)(Q₂), -P(Q₁)(Q₂), -C(=O)(Q₁), -S(=O)(Q₁), - S(=O)₂(Q₁), -P(=O)(Q₁)(Q₂), or -P(=S)(Q₁)(Q₂), provided that the substituent of the substituted C₅-C₃₀ carbocyclic group and the substituent of the substituted C₁-C₃₀ heterocyclic group are not hydrogen,
   *1, *2, *3 and *4 each indicate a binding site to M₂₁, and
   Q₁ to Q₃ may each independently be hydrogen, deuterium, -F, -Cl, -Br, -I, -SF₅, a hydroxyl group, a cyano group, a nitro group, an amino group, an amidino group, a hydrazino group, a hydrazono group, a C₁-C₆₀ alkyl group, a C₂-C₆₀ alkenyl group, a C₂-C₆₀ alkynyl group, a C₁-C₆₀ alkoxy group, a C₁-C₆₀ alkylthio group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₇-C₆₀ alkyl aryl group, a C₇-C₆₀ aryl alkyl group, a C₆-C₆₀ aryloxy group, a C₆-C₆₀ arylthio group, a C₁-C₆₀ heteroaryl group, a C₂-C₆₀ alkyl heteroaryl group, a C₂-C₆₀ heteroaryl alkyl group, a C₁-C₆₀ heteroaryloxy group, a C₁-C₆₀ heteroarylthio group, a monovalent aromatic condensed polycyclic group, a monovalent aromatic condensed heteropolycyclic group, a monovalent non-aromatic condensed polycyclic group, or a monovalent non-aromatic condensed heteropolycyclic group.

In one or more embodiments, M₂₁ may be platinum, palladium, gold, iridium, osmium, titanium, zirconium, hafnium, europium, terbium, thulium, or rhodium.

When the emission layer includes a host and a dopant, an amount of the dopant may be about 0.01 part by weight to about 15 parts by weight, based on 100 parts by weight of the host, but embodiments are not limited thereto.

A thickness of the emission layer may be about 100 Å to about 1,000 Å, for example, about 200 Å to about 600 Å. Without wishing to be bound to theory, when the thickness of the emission layer is within these ranges, excellent light-emission characteristics may be obtained without a substantial increase in driving voltage.

An electron transport region may be located on the emission layer.

The electron transport region may include a hole blocking layer, an electron transport layer, an electron injection layer, or a combination thereof.

For example, the electron transport region may have a hole blocking layer/electron transport layer/electron injection layer structure, or an electron transport layer/electron injection layer structure, but the structure of the electron transport region is not limited thereto. The electron transport layer may have a single-layered structure or a multi-layered structure including two or more different materials.

Conditions for forming the hole blocking layer, the electron transport layer, and the electron injection layer which constitute the electron transport region may be understood by referring to the conditions for forming the hole injection layer.

When the electron transport region includes a hole blocking layer, the hole blocking layer may include, for example, at least one of 2,9-dimethyl-4,7-diphenyl-1,10-phenanthroline (BCP), 4,7-diphenyl-1,10-phenanthroline (Bphen), or bis(2-methyl-8-quinolinolato-N1,O8)-(1,1'-biphenyl-4-olato)aluminum (BAlq), but embodiments are not limited thereto:

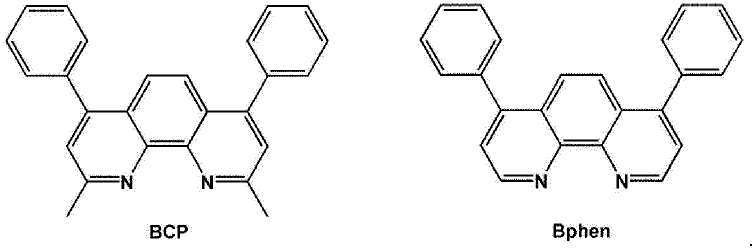

A thickness of the hole blocking layer may be about 20 Å to about 1,000 Å, for example, about 30 Å to about 300 Å. Without wishing to be bound to theory, when the thickness of the hole blocking layer is within these ranges, excellent hole blocking characteristics may be obtained without a substantial increase in driving voltage.

The electron transport layer may further include, for example, at least one of 2,9-dimethyl-4,7-diphenyl-1,10-phenanthroline (BCP), 4,7-diphenyl-1,10-phenanthroline (Bphen), tris(8-hydroxy-quinolinato)aluminum (Alq₃), bis(2-methyl-8-quinolinolato-N1,O8)-(1,1'-biphenyl-4-olato)aluminum (BAlq), 3-(4-biphenylyl)-4-phenyl-5-tert-butylphenyl-1,2,4-triazole (TAZ), or 4-(naphthalen-1-yl)-3,5-diphenyl-4H-1,2,4-triazole (NTAZ), but embodiments are not limited thereto:

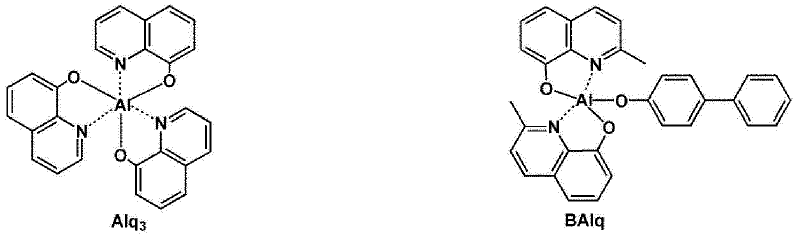

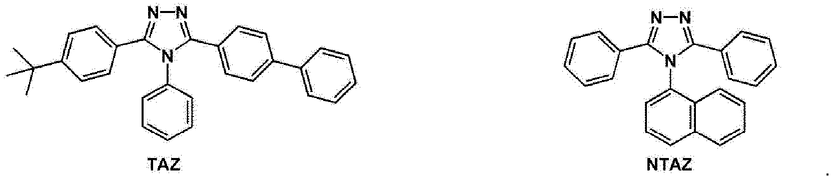

In some embodiments, the electron transport layer may include at least one of ET1 to ET25, but embodiments are not limited thereto:

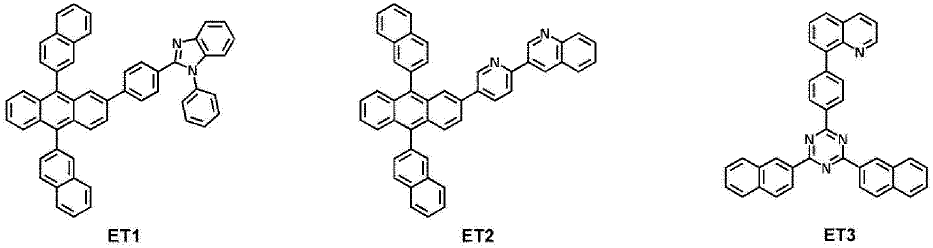

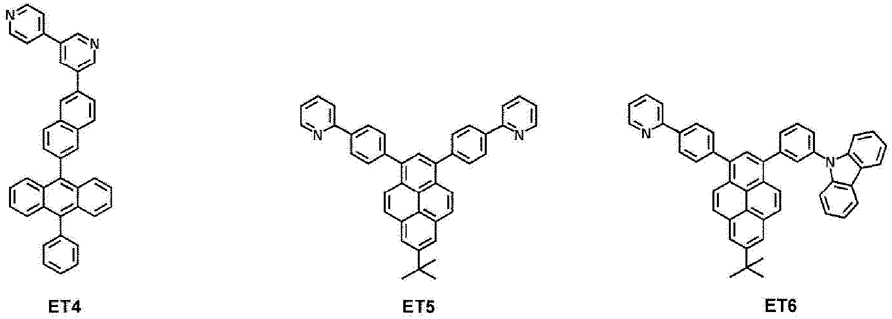

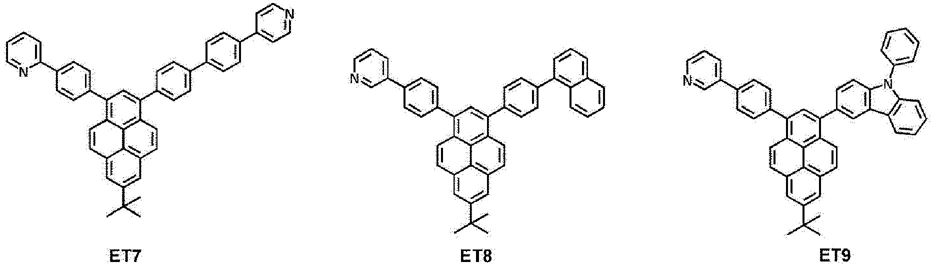

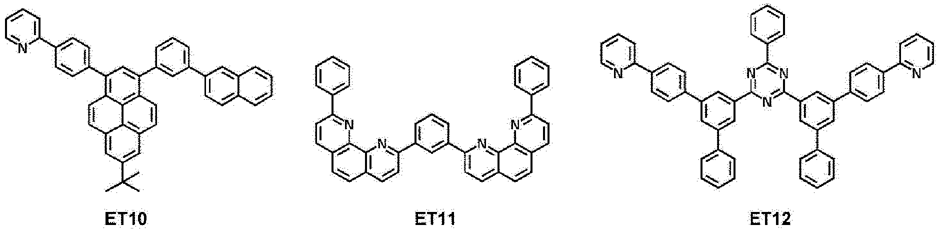

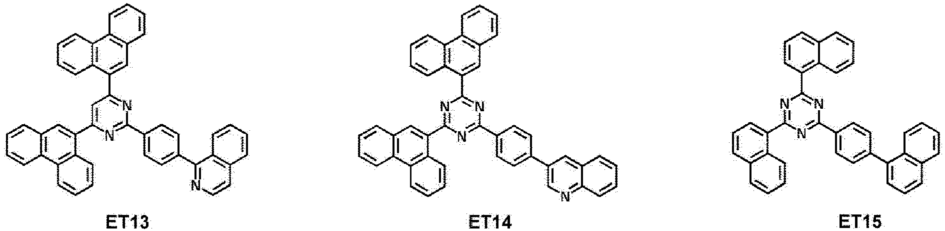

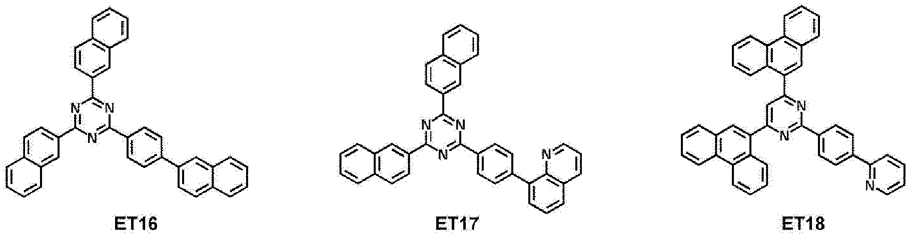

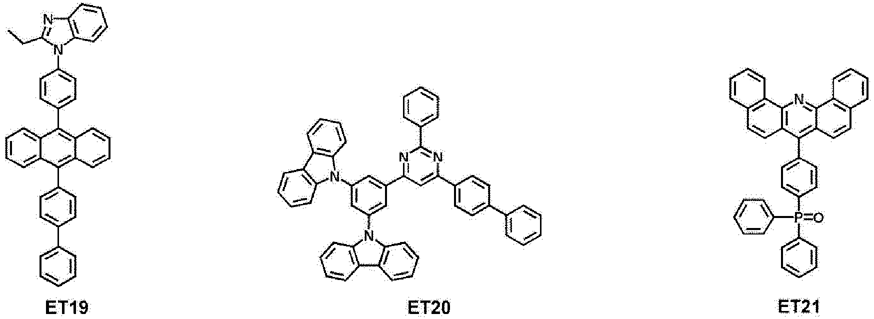

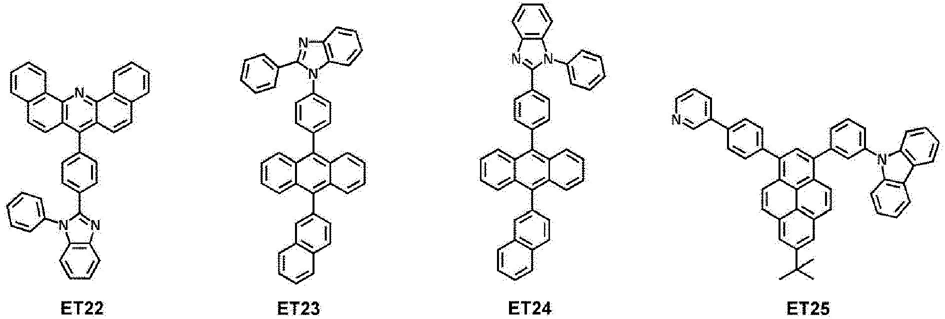

A thickness of the electron transport layer may be about 100 Å to about 1,000 Å, for example, about 150 Å to about 500 Å. Without wishing to be bound to theory, when the thickness of the electron transport layer is within the range described above, the electron transport layer may have satisfactory electron transporting characteristics without a substantial increase in driving voltage.

The electron transport layer may include a metal-containing material in addition to the material as described herein.

The metal-containing material may include a Li complex. The Li complex may include, for example, at least one of Compounds ET-D1 (lithium 8-hydroxyquinolate, LiQ) or ET-D2, but embodiments are not limited thereto:

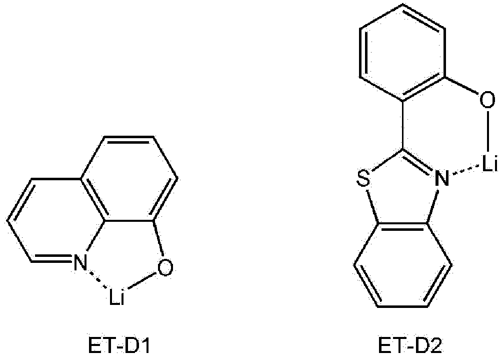

The electron transport region may include an electron injection layer that promotes the flow of electrons from the cathode 19 thereinto.

The electron injection layer may include LiF, NaCl, CsF, Li₂O, BaO, or a combination thereof.

A thickness of the electron injection layer may be about 1 Å to about 100 Å, for example, about 3 Å to about 90 Å. Without wishing to be bound to theory, when the thickness of the electron injection layer is within the ranges described above, satisfactory electron injection characteristics may be obtained without a substantial increase in driving voltage.

The cathode 19 may be located on the organic layer 15. The second electrode 19 may be a cathode. A material for forming the cathode 19 may be a metal, a metal alloy, an electrically conductive compound, or a combination thereof, which have a relatively low work function. For example, lithium (Li), magnesium (Mg), aluminum (Al), silver (Ag), aluminum-lithium (Al-Li), calcium (Ca), magnesium-indium (Mg-In), or magnesium-silver (Mg-Ag) may be used as the material for forming the cathode 19. In some embodiments, to manufacture a top-emission light-emitting device, a transmissive electrode formed using ITO or IZO may be used as the cathode 19.

Hereinbefore, the organic light-emitting device has been described in further detail with reference to the FIGURE, but embodiments are not limited thereto.

In some embodiments, an electronic apparatus may include the organic light-emitting device.

The electronic apparatus may further include a thin-film transistor (TFT) in addition to the organic light-emitting device as described herein. The thin-film transistor may include a source electrode, a drain electrode, and an active layer, wherein any one of the source electrode and the drain electrode may be electrically connected to any one of the anode and the cathode of the organic light-emitting device, but embodiments are not limited thereto.

Hereinafter, an organic light-emitting device according to one or more exemplary embodiments will be described in further detail with reference to Examples. However, it is to be understood that embodiments are not limited to the following examples.

### Examples

### Evaluation Example 1: Comparison of deposition temperature of organometallic compound

10 milligrams (mg) of a compound as specified in Table 1 was subjected to thermal gravimetric analysis (TGA) in a vacuum of 1 Pascal (Pa), and a temperature at which the weight of the compound was reduced by 10% was measured, and results thereof are shown in Table 1.

Referring to Table 1, the organometallic compounds represented by Formula 1 were found to have a reduced deposition temperature as compared with Compounds A to F, which did not include at least one silyl group or at least one germyl group.

**Table 1**

| Compound | Vacuum deposition temperature (°C) |
|---|---|
| Compound 1 | 297 |
| Compound 2 | 300 |
| Compound 3 | 293 |
| Compound 4 | 292 |
| Compound 5 | 305 |
| Compound 6 | 294 |
| Compound A | 320 |
| Compound B | 310 |
| Compound C | 325 |
| Compound D | 304 |
| Compound E | 312 |
| compound F | 310 |

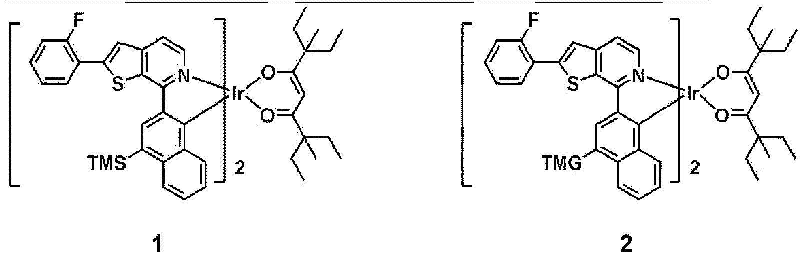

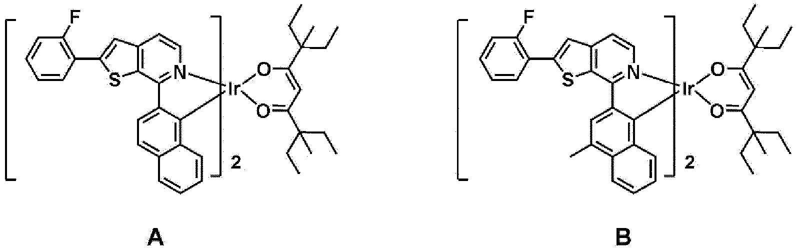

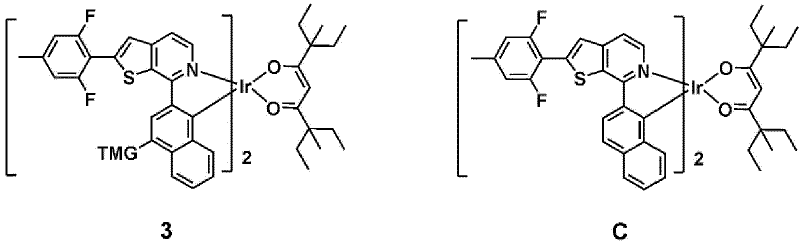

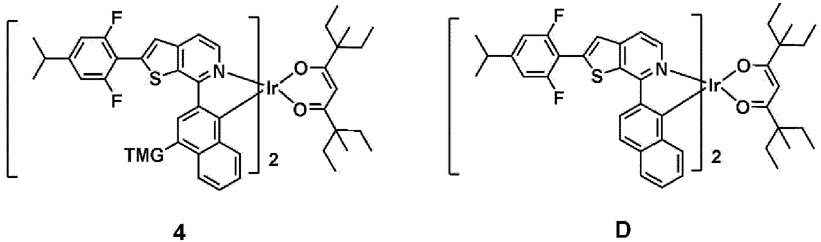

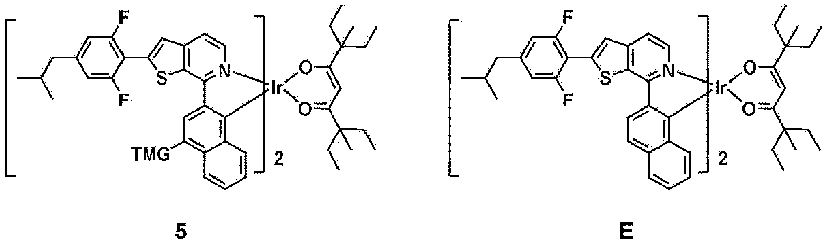

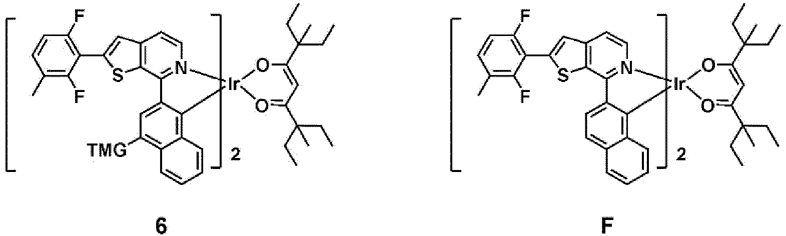

### Evaluation of Example 2: Evaluation of Properties of Organic Light-Emitting Devices Example 1

As an anode, an ITO-patterned glass substrate was cut to a size of 50 millimeters (mm) x 50 mm x 0.5 mm, sonicated with isopropyl alcohol and deionized (DI) water each for 5 minutes, and then cleaned by exposure to ultraviolet rays and ozone for 30 minutes. The resultant glass substrate was subjected to N₂:O₂ plasma processing in a vacuum deposition apparatus for 10 minutes and loaded onto a vacuum organic deposition apparatus.

ET3 and Yb were co-deposited by vacuum on the ITO anode at a weight ratio of 3 weight percent (wt%) to form an n-doped layer having a thickness of 100 Å.

HT3 and F6TCNNQ were vacuum co-deposited on the n-doped layer at a weight ratio of 98:2 to form a hole injection layer having a thickness of 100 Å, and then, HT3 was vacuum-deposited on the hole injection layer to form a hole transport layer having a thickness of 1,350 Å.

Then, H52 (host) and Compound 1 (dopant) were co-deposited by vacuum on the hole transport layer at a weight ratio of 97:3 to form an emission layer having a thickness of 400 Å.

Subsequently, ET3 and ET-D1 were co-deposited by vacuum at a volume ratio of 50:50 on the emission layer to form an electron transport layer having a thickness of 350 Å, and ET-D1 was vacuum-deposited on the electron transport layer to form an electron injection layer having a thickness of 10 Å, and Al was vacuum-deposited on the electron injection layer to form a cathode having a thickness of 1,000 Å, thereby completing the manufacture of an organic light-emitting device.

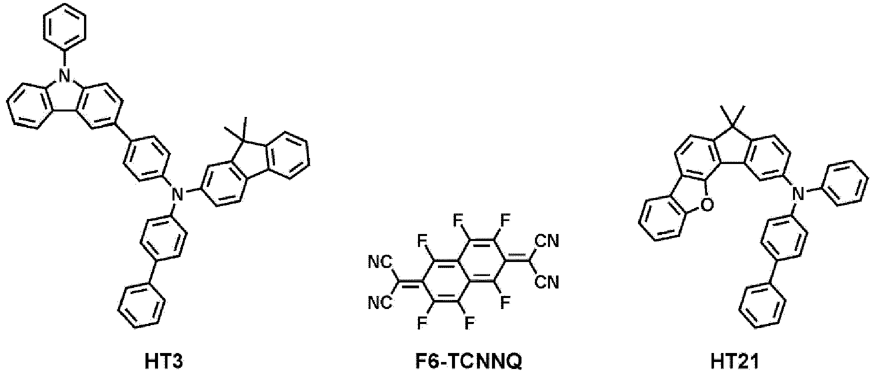

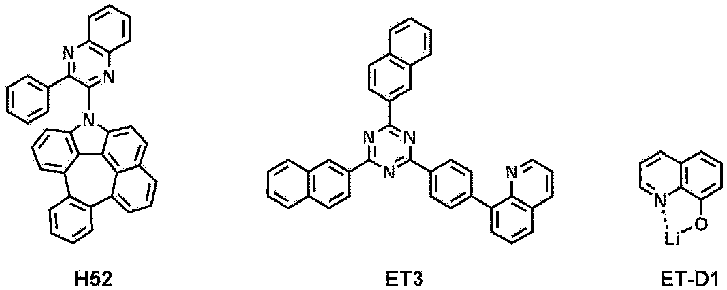

### Example 2 and Comparative Examples 1 to 6

An organic light-emitting device was manufactured in a similar manner as in Example 1, except that the compounds shown in Table 2 were used in forming the dopant and the n-doped layer of the emission layer.

The maximum emission wavelength of the emission spectrum (λₘₐₓ, nm), luminescence efficiency (relative %), and lifespan characteristics (LT₉₇, relative %) of each of the organic light-emitting devices manufactured according to Examples 1 and 2 and Comparative Examples 1 to 6 were evaluated. Results thereof are shown in Table 2. A Keithley 2400 current voltmeter and a luminance meter (Topcon SR3) were used in the evaluations. Lifespan characteristics (LT₉₇) indicates the time taken for the luminance to reach 97 % of the initial luminance of 100 %, and is expressed in Table 2 as a relative value to Example 1.

**Table 2**

| | Dopant in emission layer | n-doped layer | λₘₐₓ (nm) | Luminescence efficiency (relative %) | Lifespan (relative %) |
|---|---|---|---|---|---|
| Example 1 | Compound 1 | ET3 + Yb | 616 | 100 | 100 |
| Example 2 | Compound 2 | ET3 + Yb | 622 | 102 | 100 |
| Comparative Example 1 | Compound 1 | Not formed | 616 | 100 | 30 |
| Comparative Example 2 | Compound 2 | Not formed | 622 | 102 | 10 |
| Comparative Example 3 | Compound A | ET3 + Yb | 624 | 99 | 100 |
| Comparative Example 4 | Compound B | ET3 + Yb | 633 | 98 | 100 |
| Comparative Example 5 | Compound A | Not formed | 624 | 99 | 100 |
| Comparative Example 6 | Compound B | Not formed | 633 | 98 | 100 |

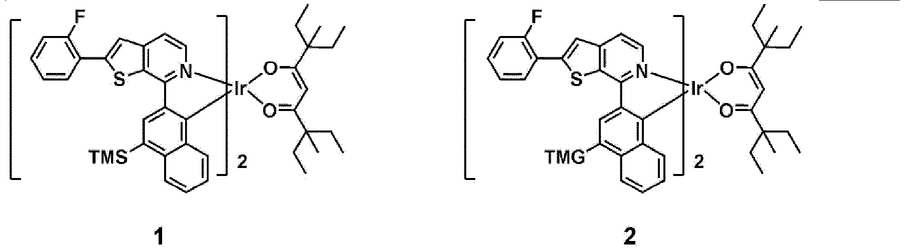

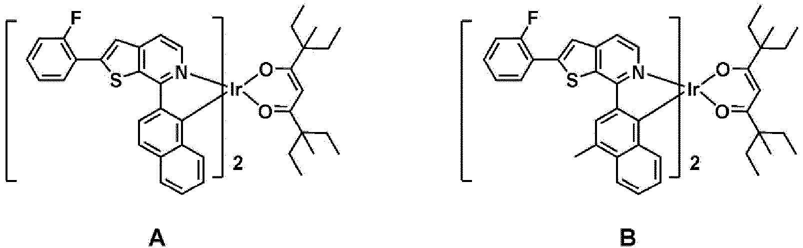

From Table 2, it was confirmed that the organic light-emitting device according to one or more embodiments had excellent luminescence efficiency and lifespan characteristics.

In addition, the organic light-emitting devices of Examples 1 and 2 were found to be significantly better in lifespan characteristics compared to the organic light-emitting devices of Comparative Examples 1 and 2, in which the n-doped layer was not formed.

According to the one or more embodiments, by including the n-doped layer between the emission layer and the anode, and including the at least one organometallic compound including the at least one silyl group and/or the at least one germyl group in the emission layer, the organic light-emitting device may have an excellent luminescence efficiency, a long lifespan, and a high color purity. Particularly, by including at least one silyl group or at least one germyl group in the at least one organometallic compound included in the organic light-emitting device, the organic light-emitting device may have a low deposition temperature, and the emission wavelength thereof may be easily controlled to have a target wavelength characteristic (for example, a shortening of the wavelength). In addition, the cation formed from the anode by the free electron formed from the n-doped layer of the organic light-emitting device may be effectively removed, thereby preventing the at least one silyl group and/or the at last one germyl group of the at least one organometallic compound from being decomposed. In addition, an excellent high-quality electronic apparatus including the organic light-emitting device may be provided.

It should be understood that exemplary embodiments described herein should be considered in a descriptive sense only and not for purposes of limitation. Descriptions of features or aspects within each exemplary embodiment should typically be considered as available for other similar features or aspects in other exemplary embodiments. While one or more exemplary embodiments have been described if further detail and with reference to the figure, it will be understood by those of ordinary skill in the art that various changes in form and details may be made therein without departing from the scope as defined by the following claims.

## Claims

1. An organic light-emitting device (10), comprising:
an anode (11);
a cathode (19); and
an organic layer (15) arranged between the anode and the cathode,
wherein the organic layer comprises an emission layer and an n-doped layer,
the emission layer comprises at least one organometallic compound, and
the at least one organometallic compound comprises at least one silyl group or at least one germyl group,
**characterized in that** the n-doped layer is arranged between the anode and the emission layer.

2. The organic light-emitting device of claim 1, wherein the organometallic compound is represented by Formula 1:
Formula 1 M₁(Ln₁)ₙ₁(Ln₂)ₙ₂
wherein, in Formula 1,
M₁ is a transition metal,
Ln₁ is a ligand represented by Formula 1A,
Ln₂ is an organic ligand,
n1 is 1, 2, or 3,
n2 is 0, 1, or 2, 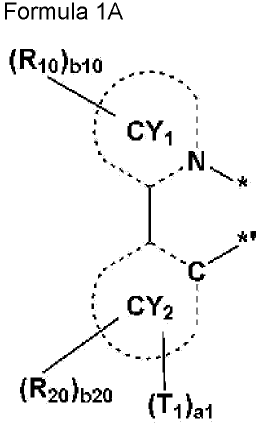
wherein, in Formula 1A,
ring CY₁ and ring CY₂ are each independently a C₅-C₃₀ carbocyclic group or a C₁-C₃₀ heterocyclic group,
T₁ is -Si(Q₁)(Q₂)(Q₃) or -Ge(Q₁)(Q₂)(Q₃),
a1 is 1, 2, 3, 4, or 5,
R₁₀ and R₂₀ are each independently hydrogen, deuterium, -F, -Cl, -Br, -I, -SF₅, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a substituted or unsubstituted C₁-C₆₀ alkyl group, a substituted or unsubstituted C₂-C₆₀ alkenyl group, a substituted or unsubstituted C₂-C₆₀ alkynyl group, a substituted or unsubstituted C₁-C₆₀ alkoxy group, a substituted or unsubstituted C₁-C₆₀ alkylthio group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₇-C₆₀ alkyl aryl group, a substituted or unsubstituted C₇-C₆₀ aryl alkyl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted C₂-C₆₀ alkyl heteroaryl group, a substituted or unsubstituted C₂-C₆₀ heteroaryl alkyl group, a substituted or unsubstituted C₁-C₆₀ heteroaryloxy group, a substituted or unsubstituted C₁-C₆₀ heteroarylthio group, a substituted or unsubstituted monovalent non-aromatic condensed polycyclic group, a substituted or unsubstituted monovalent non-aromatic condensed heteropolycyclic group, -Si(Q₁)(Q₂)(Q₃), - Ge(Q₁)(Q₂)(Q₃), -C(=O)(Q₁), -S(=O)(Q₁), -S(=O)₂(Q₁), -N(Q₄)(Q₅), -B(Q₆)(Q₇), - P(Q₈)(Q₉), -P(=O)(Q₈)(Q₉), or -P(=S)(Q₈)(Q₉),
two or more of a plurality of R₁₀ are optionally linked together to form a substituted or unsubstituted C₅-C₃₀ carbocyclic group or a substituted or unsubstituted C₁-C₃₀ heterocyclic group,
two or more of a plurality of R₂₀ are optionally linked together to form a substituted or unsubstituted C₅-C₃₀ carbocyclic group or a substituted or unsubstituted C₁-C₃₀ heterocyclic group,
neighboring two or more of a plurality of R₁₀ and R₂₀ are optionally linked to each other to form a substituted or unsubstituted C₅-C₃₀ carbocyclic group or a substituted or unsubstituted C₁-C₃₀ heterocyclic group,
b10 and b20 are each independently 1, 2, 3, 4, 5, 6, 7, 8, 9, or 10,
* and *' each indicate a binding site to M₁,
at least one substituent of the substituted C₅-C₃₀ carbocyclic group, the substituted C₁-C₃₀ heterocyclic group, the substituted C₁-C₆₀ alkyl group, the substituted C₂-C₆₀ alkenyl group, the substituted C₂-C₆₀ alkynyl group, the substituted C₁-C₆₀ alkoxy group, the substituted C₁-C₆₀ alkylthio group, the substituted C₃-C₁₀ cycloalkyl group, the substituted C₁-C₁₀ heterocycloalkyl group, the substituted C₃-C₁₀ cycloalkenyl group, the substituted C₁-C₁₀ heterocycloalkenyl group, the substituted C₆-C₆₀ aryl group, the substituted C₇-C₆₀ alkyl aryl group, the substituted C₇-C₆₀ aryl alkyl group, the substituted C₆-C₆₀ aryloxy group, the substituted C₆-C₆₀ arylthio group, the substituted C₁-C₆₀ heteroaryl group, the substituted C₂-C₆₀ alkyl heteroaryl group, the substituted C₂-C₆₀ heteroaryl alkyl group, the substituted C₁-C₆₀ heteroaryloxy group, the substituted C₁-C₆₀ heteroarylthio group, the substituted monovalent non-aromatic condensed polycyclic group, and the substituted monovalent non-aromatic condensed heteropolycyclic group is:
deuterium, -F, -Cl, -Br, -I, -SFs, -CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, a C₁-C₆₀ alkoxy group, or a C₁-C₆₀ alkylthio group;
a C₁-C₆₀ alkyl group, a C₂-C₆₀ alkenyl group, a C₂-C₆₀ alkynyl group, a C₁-C₆₀ alkoxy group, or a C₁-C₆₀ alkylthio group, each substituted with at least one of deuterium, -F, -Cl, -Br, -I, -SF₅, -CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₇-C₆₀ alkyl aryl group, a C₆-C₆₀ aryloxy group, a C₆-C₆₀ arylthio group, a C₁-C₆₀ heteroaryl group, a C₂-C₆₀ alkyl heteroaryl group, a C₁-C₆₀ heteroaryloxy group, a C₁-C₆₀ heteroarylthio group, a monovalent non-aromatic condensed polycyclic group, a monovalent non-aromatic condensed heteropolycyclic group, -Si(Q₁₁)(Q₁₂)(Q₁₃), -Ge(Q₁₁)(Q₁₂)(Q₁₃), - C(=O)(Q₁₁), -S(=O)(Q₁₁), -S(=O)₂(Q₁₁), -N(Q₁₄)(Q₁₅), -B(Q₁₆)(Q₁₇), -P(Q₁₈)(Q₁₉), - P(=O)(Q₁₈)(Q₁₉), -P(=S)(Q₁₈)(Q₁₉), or a combination thereof;
a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₇-C₆₀ alkyl aryl group, a C₆-C₆₀ aryloxy group, a C₆-C₆₀ arylthio group, a C₁-C₆₀ heteroaryl group, a C₂-C₆₀ alkyl heteroaryl group, a C₁-C₆₀ heteroaryloxy group, a C₁-C₆₀ heteroarylthio group, a monovalent non-aromatic condensed polycyclic group, or a monovalent non-aromatic condensed heteropolycyclic group;
a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₇-C₆₀ alkyl aryl group, a C₆-C₆₀ aryloxy group, a C₆-C₆₀ arylthio group, a C₁-C₆₀ heteroaryl group, a C₂-C₆₀ alkyl heteroaryl group, a C₁-C₆₀ heteroaryloxy group, a C₁-C₆₀ heteroarylthio group, a monovalent non-aromatic condensed polycyclic group, or a monovalent non-aromatic condensed heteropolycyclic group, each substituted with at least one of deuterium, -F, -Cl, -Br, -I, -SF₅, -CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, a C₁-C₆₀ alkoxy group, a C₁-C₆₀ alkylthio group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₇-C₆₀ alkyl aryl group, a C₇-C₆₀ aryl alkyl group, a C₆-C₆₀ aryloxy group, a C₆-C₆₀ arylthio group, a C₁-C₆₀ heteroaryl group, a C₂-C₆₀ alkyl heteroaryl group, a C₂-C₆₀ heteroaryl alkyl group, a C₁-C₆₀ heteroaryloxy group, a C₁-C₆₀ heteroarylthio group, a monovalent non-aromatic condensed polycyclic group, a monovalent non-aromatic condensed heteropolycyclic group, -Si(Q₂₁)(Q₂₂)(Q₂₃), -Ge(Q₂₁)(Q₂₂)(Q₂₃), - C(=O)(Q₂₁), -S(=O)(Q₂₁), -S(=O)₂(Q₂₁), -N(Q₂₄)(Q₂₅), -B(Q₂₆)(Q₂₇), -P(Q₂₈)(Q₂₉), - P(=O)(Q₂₈)(Q₂₉), -P(=S)(Q₂₈)(Q₂₉), or a combination thereof; or
-Si(Q₃₁)(Q₃₂)(Q₃₃), -Ge(Q₃₁)(Q₃₂)(Q₃₃), -C(=O)(Q₃₁), -S(=O)(Q₃₁), -S(=O)₂(Q₃₁), -N(Q₃₄)(Q₃₅), -B(Q₃₆)(Q₃₇), -P(Q₃₈)(Q₃₉), -P(=O)(Q₃₈)(Q₃₉), or -P(=S)(Q₃₈)(Q₃₉),
wherein Q₁ to Q₉, Q₁₁ to Q₁₉, Q₂₁ to Q₂₉, and Q₃₁ to Q₃₉ are each independently hydrogen, deuterium, -F, -Cl, -Br, -I, -SF₅, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a substituted or unsubstituted C₁-C₆₀ alkyl group, a substituted or unsubstituted C₂-C₆₀ alkenyl group, a substituted or unsubstituted C₂-C₆₀ alkynyl group, a substituted or unsubstituted C₁-C₆₀ alkoxy group, a substituted or unsubstituted C₁-C₆₀ alkylthio group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₇-C₆₀ alkyl aryl group, a substituted or unsubstituted C₇-C₆₀ aryl alkyl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted C₂-C₆₀ alkyl heteroaryl group, a substituted or unsubstituted C₂-C₆₀ heteroaryl alkyl group, a C₁-C₆₀ heteroaryloxy group, a C₁-C₆₀ heteroarylthio group, a substituted or unsubstituted monovalent non-aromatic condensed polycyclic group, or a substituted or unsubstituted monovalent non-aromatic condensed heteropolycyclic group.

3. The organic light-emitting device of claim 2, wherein M₁ is iridium, platinum, osmium, titanium, zirconium, hafnium, europium, terbium, thulium, or rhodium;
preferably wherein M₁ is iridium, and a sum of n1 and n2 is 3, or M₁ is platinum, and the sum of n1 and n2 is 2.

4. The organic light-emitting device of claims 2 or 3, wherein ring CY₁ and ring CY₂ are each independently a benzene group, a naphthalene group, a 1,2,3,4-tetrahydronaphthalene group, a phenanthrene group, a pyridine group, a pyrimidine group, a pyrazine group, a triazine group, a quinoline group, an isoquinoline group, a benzoquinoline group, a benzoisoquinoline group, a furopyridine group, a benzofuropyridine group, a thienopyridine group, a benzothienopyridine group, a quinoxaline group, a quinazoline group, a phenanthroline group, a benzofuran group, a benzothiophene group, a fluorene group, a carbazole group, a dibenzofuran group, a dibenzothiophene group, a dibenzosilole group, an azafluorene group, an azacarbazole group, an azadibenzofuran group, an azadibenzothiophene group, or an azadibenzosilole group; and/or
wherein R₁₀ and R₂₀ are each independently hydrogen, deuterium, -F, a substituted or unsubstituted C₁-C₂₀ alkyl group, a substituted or unsubstituted C₃-C₁₀ cycloalkyl group, a substituted or unsubstituted C₁-C₁₀ heterocycloalkyl group, a substituted or unsubstituted C₆-C₁₀ aryl group, -Si(Q₁)(Q₂)(Q₃), or -Ge(Q₁)(Q₂)(Q₃).

5. The organic light-emitting device of any of claims 2-4, wherein Ln₁ is represented by one of Formulae 4-1 to 4-20: 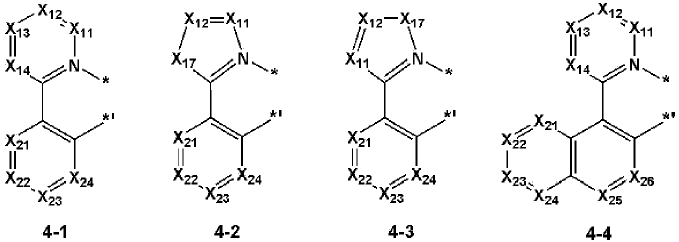 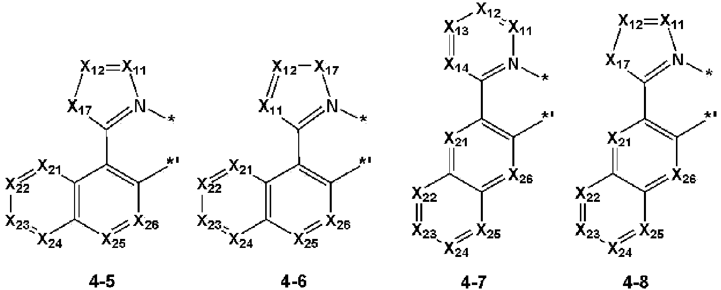 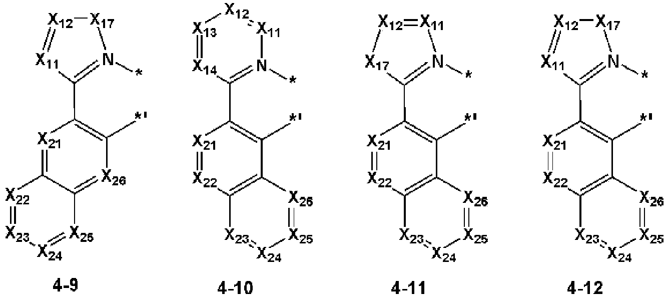 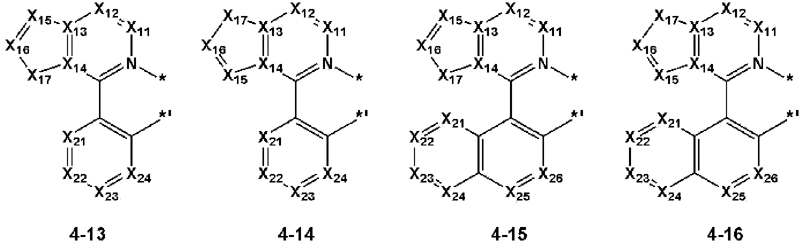 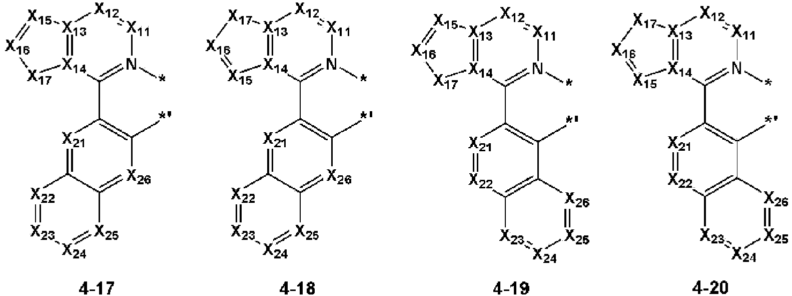 wherein, in Formulae 4-1 to 4-20,
X11 is C(R₁₁) or N,
X₁₂ is C(R₁₂) or N,
X₁₃ in Formulae 4-1 to 4-12 is C(R₁₃) or N, and X₁₃ in Formulae 4-13 to 4-20 is C,
X₁₄ in Formulae 4-1 to 4-12 is C(R₁₄) or N, and X₁₄ in Formulae 4-13 to 4-20 is C,
X₁₅ is C(R₁₅) or N,
X₁₆ is C(R₁₆) or N,
X₁₇ is O, S, C(R₁₇)(R₁₈), or N(R₁₇),
X₂₁ is C(T₁), C(R₂₁), or N, X₂₂ is C(T₁), C(R₂₂), or N, X₂₃ is C(T₁), C(R₂₃), or N, X₂₄ is C(T₁), C(R₂₄), or N, X₂₅ is C(T₁), C(R₂₅), or N, and X₂₆ is C(T₁), C(R₂₆), or N,
R₁₁ to R₁₈ are each defined as for R₁₀ in claim 2,
R₂₁ to R₂₆ are each defined as for R₂₀ in claim 2,
at least one of X₂₁ to X₂₄ in Formulae 4-1 to 4-3, 4-13, and 4-14 is C(T₁),
at least one of X₂₁ to X₂₆ in Formulae 4-4 to 4-12 and 4-15 to 4-20 is C(T₁),
at least two of R₁₁ to R₁₈, at least two of R₂₁ to R₂₆, or at least two of R₁₁ to R₁₈ and R₂₁ to R₂₆ are optionally linked together to form a C₅-C₃₀ carbocyclic group that is unsubstituted or substituted with at least one R₁₀ₐ, or a C₁-C₃₀ heterocyclic group that is unsubstituted or substituted with at least one R₁₀ₐ,
R₁₀ₐ is defined as for R₁₀ in claim 2, and
* and *' each indicate a binding site to M₁.

6. The organic light-emitting device of any of claims 2-5, wherein Ln₂ is represented by at least one of Formulae 2A to 2C: 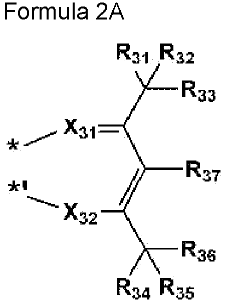 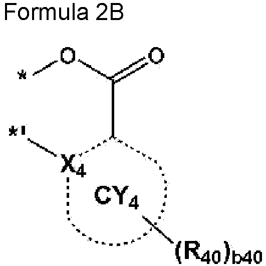 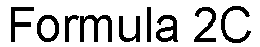 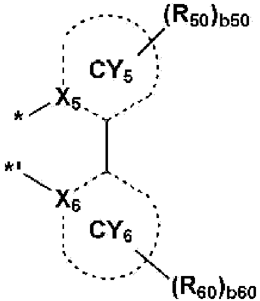 wherein, in Formulae 2A to 2C,
X₃₁ and X₃₂ are each independently O or S,
X₄ to X₆ are each independently C or N,
ring CY₄ to ring CY₆ are each independently a C₅-C₃₀ carbocyclic group or a C₁-C₃₀ heterocyclic group,
R₃₁ to R₃₇, R₄₀, R₅₀, and R₆₀ are each independently hydrogen, deuterium, -F, -Cl, -Br, -I, -SF₅, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a substituted or unsubstituted C₁-C₆₀ alkyl group, a substituted or unsubstituted C₂-C₆₀ alkenyl group, a substituted or unsubstituted C₂-C₆₀ alkynyl group, a substituted or unsubstituted C₁-C₆₀ alkoxy group, a substituted or unsubstituted C₁-C₆₀ alkylthio group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₇-C₆₀ alkyl aryl group, a substituted or unsubstituted C₇-C₆₀ aryl alkyl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted C₂-C₆₀ alkyl heteroaryl group, a substituted or unsubstituted C₂-C₆₀ heteroaryl alkyl group, a substituted or unsubstituted C₁-C₆₀ heteroaryloxy group, a substituted or unsubstituted C₁-C₆₀ heteroarylthio group, a substituted or unsubstituted monovalent non-aromatic condensed polycyclic group, a substituted or unsubstituted monovalent non-aromatic condensed heteropolycyclic group, -Si(Q₁)(Q₂)(Q₃), -Ge(Q₁)(Q₂)(Q₃), -C(=O)(Q₁), -S(=O)(Q₁), -S(=O)₂(Q₁), - N(Q₄)(Q₅), -B(Q₆)(Q₇), -P(Q₈)(Q₉), -P(=O)(Q₈)(Q₉), or -P(=S)(Q₈)(Q₉),
two or more of R₃₁ to R₃₇; two or more of a plurality of R₄₀; two or more of a plurality of R₅₀; two or more of a plurality of R₆₀; or two or more of R₅₀ and R₆₀ are optionally linked together to form a C₅-C₃₀ carbocyclic group that is unsubstituted or substituted with at least one R₁₀ₐ, or a C₁-C₃₀ heterocyclic group that is unsubstituted or substituted with at least one R₁₀ₐ,
R₁₀ₐ is defined as for R₁₀ in claim 2, and
* and *' each indicate a binding site to M₁.

7. The organic light-emitting device of any of claims 1-6, wherein the emission layer emits a red light, a green light, or a blue light.

8. The organic light-emitting device of any of claims 1-7, wherein
the emission layer comprises a host and a dopant, and
the dopant comprises the at least one organometallic compound.

9. The organic light-emitting device of any of claims 1-8, wherein the n-doped layer comprises an electron transport compound and an n-dopant.

10. The organic light-emitting device of claim 9, wherein the electron transport compound comprises a cyano group, a π electron-deficient nitrogen-containing ring group, an electron transport moiety, or a combination thereof; and/or
wherein the n-dopant comprises a metal.

11. The organic light-emitting device of any of claims 1-10, wherein
the organic layer further comprises a hole transport region arranged between the anode and the emission layer, and
the hole transport region comprises a hole injection layer, a hole transport layer, an electron blocking layer, a buffer layer, or a combination thereof.

12. The organic light-emitting device of any of claims 1-11, wherein the n-doped layer is arranged between the anode and the hole transport region.

13. The organic light-emitting device of any of claims 1-12, wherein
the organic layer further comprises an electron transport region arranged between the emission layer and the cathode, and
the electron transport region comprises a hole blocking layer, an electron transport layer, an electron injection layer, or a combination thereof.

14. The organic light-emitting device of any of claims 1-13, wherein the organic layer further comprises:
n emission units; and
n-1 charge generation units arranged between two neighboring emission units,
wherein n is an integer of 2 or greater, and
at least one of the n emission units comprises the at least one organometallic compound;
preferably wherein
the organic layer further comprises a hole transport region arranged between the anode and the emission layer,
the hole transport region comprises a hole injection layer, a hole transport layer, an electron blocking layer, a buffer layer, or a combination thereof, and
the n-doped layer is arranged between the anode and the hole transport region, or
at least one of the n-1 charge generation units comprises the n-doped layer;
preferably wherein
the n emission units comprise a k^{th} emission unit which is k^{th} nearest to the anode, wherein k is an integer from 2 to n, and
the k^{th} emission unit comprises the emission layer comprising the at least one organometallic compound.

15. An electronic apparatus, comprising the organic light-emitting device of any of claims 1-14.

## Patentansprüche

1. Organische lichtemittierende Vorrichtung (10), umfassend:
eine Anode (11);
eine Kathode (19); und
eine organische Schicht (15), die zwischen der Anode und der Kathode angeordnet ist,
wobei die organische Schicht eine Emissionsschicht und eine n-dotierte Schicht umfasst,
die Emissionsschicht mindestens eine metallorganische Verbindung umfasst und
die mindestens eine metallorganische Verbindung mindestens eine Silylgruppe oder mindestens eine Germylgruppe umfasst,
**dadurch gekennzeichnet, dass** die n-dotierte Schicht zwischen der Anode und der Emissionsschicht angeordnet ist.

2. Organische lichtemittierende Vorrichtung nach Anspruch 1, wobei die metallorganische Verbindung dargestellt ist durch Formel 1:
Formel 1 M₁(Ln₁)ₙ₁(Ln₂)ₙ₂
wobei, in Formel 1,
M₁ ein Übergangsmetall ist,
Ln₁ ein Ligand, dargestellt durch Formel 1A, ist,
Ln₂ ein organischer Ligand ist,
n1 1, 2 oder 3 ist,
n2 0, 1 oder 2 ist, 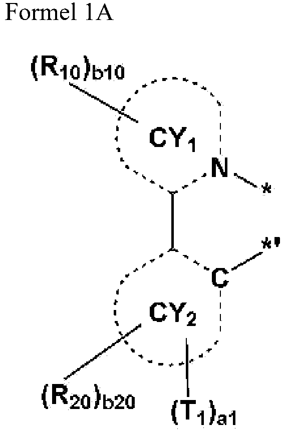
wobei, in Formel 1A,
Ring CY₁ und Ring CY₂ jeweils unabhängig eine carbocyclische C₅-C₃₀-Gruppe oder eine heterocyclische C₁-C₃₀-Gruppe sind,
T₁ -Si(Q₁)(Q₂)(Q₃) oder -Ge(Q₁)(Q₂)(Q₃) ist,
a1 2, 3, 4 oder 5 ist,
R₁₀ und R₂₀ jeweils unabhängig Wasserstoff, Deuterium, -F, -Cl, -Br, -I, -SF₅, eine Hydroxylgruppe, eine Cyanogruppe, eine Nitrogruppe, eine Aminogruppe, eine Amidinogruppe, eine Hydrazingruppe, eine Hydrazongruppe, eine Carboxylsäuregruppe oder ein Salz davon, eine Sulfonsäuregruppe oder ein Salz davon, eine Phosphorsäuregruppe oder ein Salz davon, eine substituierte oder unsubstituierte C₁-C₆₀-Alkylgruppe, eine substituierte oder unsubstituierte C₂-C₆₀-Alkenylgruppe, eine substituierte oder unsubstituierte C₂-C₆₀-Alkinylgruppe, eine substituierte oder unsubstituierte C₁-C₆₀-Alkoxygruppe, eine substituierte oder unsubstituierte C₁-C₆₀-Alkylthiogruppe, eine substituierte oder unsubstituierte C₃-C₁₀-Cycloalkylgruppe, eine substituierte oder unsubstituierte C₁-C₁₀-Heterocycloalkylgruppe, eine substituierte oder unsubstituierte C₃-C₁₀-Cycloalkenylgruppe, eine substituierte oder unsubstituierte C₁-C₁₀-Heterocycloalkenylgruppe, eine substituierte oder unsubstituierte C₆-C₆₀-Arylgruppe, eine substituierte oder unsubstituierte C₇-C₆₀-Alkylarylgruppe, eine substituierte oder unsubstituierte C₇-C₆₀-Arylalkylgruppe, eine substituierte oder unsubstituierte C₆-C₆₀-Aryloxygruppe, eine substituierte oder unsubstituierte C₆-C₆₀-Arylthiogruppe, eine substituierte oder unsubstituierte C₁-C₆₀-Heteroarylgruppe, eine substituierte oder unsubstituierte C₂-C₆₀-Alkylheteroarylgruppe, eine substituierte oder unsubstituierte C₂-C₆₀-Heteroarylalkylgruppe, eine substituierte oder unsubstituierte C₁-C₆₀-Heteroaryloxygruppe, eine substituierte oder unsubstituierte C₁-C₆₀-Heteroarylthiogruppe, eine substituierte oder unsubstituierte monovalente nicht-aromatische kondensierte polycyclische Gruppe, eine substituierte oder unsubstituierte monovalente nicht-aromatische kondensierte heteropolycyclische Gruppe, -Si(Q₁)(Q₂)(Q₃), -Ge(Q₁)(Q₂)(Q₃), - C(=O)(Q₁), -S(=O)(Q₁), -S(=O)₂(Q₁), -N(Q₄)(Q₅), -B(Q₆)(Q₇), -P(Q₈)(Q₉), -P(=O)(Q₈)(Q₉) oder - P(=S)(Q₈)(Q₉) sind,
zwei oder mehr einer Vielzahl von R₁₀ optional miteinander verbunden sind, um eine substituierte oder unsubstituierte carbocyclische C₅-C₃₀-Gruppe oder eine substituierte oder unsubstituierte heterocyclische C₁-C₃₀-Gruppe zu bilden,
zwei oder mehr einer Vielzahl von R₂₀ optional miteinander verbunden sind, um eine substituierte oder unsubstituierte carbocyclische C₅-C₃₀-Gruppe oder eine substituierte oder unsubstituierte heterocyclische C₁-C₃₀-Gruppe zu bilden,
benachbarte zwei oder mehr einer Vielzahl von R₁₀ und R₂₀ optional miteinander verbunden sind, um eine substituierte oder unsubstituierte carbocyclische C₅-C₃₀-Gruppe oder eine substituierte oder unsubstituierte heterocyclische C₁-C₃₀-Gruppe zu bilden,
b10 und b20 jeweils unabhängig 1, 2, 3, 4, 5, 6, 7, 8, 9 oder 10 sind,
* und *' jeweils eine Bindungsstelle zu M₁ angeben,
mindestens ein Substituent der substituierten carbocyclischen C₅-C₃₀-Gruppe, der substituierten heterocyclischen C₁-C₃₀-Gruppe, der substituierten C₁-C₆₀-Alkylgruppe, der substituierten C₂-C₆₀-Alkenylgruppe, der substituierten C₂-C₆₀-Alkinylgruppe, der substituierten C₁-C₆₀-Alkoxygruppe, der substituierten C₁-C₆₀-Alkylthiogruppe, der substituierten C₃-C₁₀-Cycloalkylgruppe, der substituierten C₁-C₁₀-Heterocycloalkylgruppe, der substituierten C₃-C₁₀-Cycloalkenylgruppe, der substituierten C₁-C₁₀-Heterocycloalkenylgruppe, der substituierten C₆-C₆₀-Arylgruppe, der substituierten C₇-C₆₀-Alkylarylgruppe, der substituierten C₇-C₆₀-Arylalkylgruppe, der substituierten C₆-C₆₀-Aryloxygruppe, der substituierten C₆-C₆₀-Arylthiogruppe, der substituierten C₁-C₆₀-Heteroarylgruppe, der substituierten C₂-C₆₀-Alkylheteroarylgruppe, der substituierten C₂-C₆₀-Heteroarylalkylgruppe, der substituierten C₁-C₆₀-Heteroaryloxygruppe, der substituierten C₁-C₆₀-Heteroarylthiogruppe, der substituierten monovalenten nicht-aromatischen kondensierten polycyclischen Gruppe und der substituierten monovalenten nicht-aromatischen kondensierten heteropolycyclischen Gruppe Folgendes ist:
Deuterium, -F, -Cl, -Br, -I, -SF₅, -CD₃, -CD₂H, -CDH₂, -CF₃, -CF₂H, -CFH₂, eine Hydroxylgruppe, eine Cyanogruppe, eine Nitrogruppe, eine Aminogruppe, eine Amidinogruppe, eine Hydrazingruppe, eine Hydrazongruppe, eine Carboxylsäuregruppe oder ein Salz davon, eine Sulfonsäuregruppe oder ein Salz davon, eine Phosphorsäuregruppe oder ein Salz davon, eine C₁-C₆₀-Alkylgruppe, eine C₂-C₆₀-Alkenylgruppe, eine C₂-C₆₀-Alkinylgruppe, eine C₁-C₆₀-Alkoxygruppe oder eine C₁-C₆₀-Alkylthiogruppe;
eine C₁-C₆₀-Alkylgruppe, eine C₂-C₆₀-Alkenylgruppe, eine C₂-C₆₀-Alkinylgruppe, eine C₁-C₆₀-Alkoxygruppe oder eine C₁-C₆₀-Alkylthiogruppe, jeweils substituiert mit mindestens einem von Deuterium, -F, -Cl, -Br, -I, -SF₅, -CD₃, -CD₂H, -CDH₂, -CF₃, -CF₂H, -CFH₂, eine Hydroxylgruppe, eine Cyanogruppe, eine Nitrogruppe, eine Aminogruppe, eine Amidinogruppe, eine Hydrazingruppe, eine Hydrazongruppe, eine Carboxylsäuregruppe oder ein Salz davon, eine Sulfonsäuregruppe oder ein Salz davon, eine Phosphorsäuregruppe oder ein Salz davon, eine C₃-C₁₀-Cycloalkylgruppe, eine C₁-C₁₀-Heterocycloalkylgruppe, eine C₃-C₁₀-Cycloalkenylgruppe, eine C₁-C₁₀-Heterocycloalkenylgruppe, eine C₆-C₆₀-Arylgruppe, eine C₇-C₆₀-Alkylarylgruppe, eine C₆-C₆₀-Aryloxygruppe, eine C₆-C₆₀-Arylthiogruppe, eine C₁-C₆₀-Heteroarylgruppe, eine C₂-C₆₀-Alkylheteroarylgruppe, eine C₁-C₆₀-Heteroaryloxygruppe, eine C₁-C₆₀-Heteroarylthiogruppe, eine monovalente nicht-aromatische kondensierte polycyclische Gruppe, eine monovalente nicht-aromatische kondensierte heteropolycyclische Gruppe, -Si(Q₁₁)(Q₁₂)(Q₁₃), -Ge(Q₁₁)(Q₁₂)(Q₁₃), - C(=O)(Q₁₁), -S(=O)(Q₁₁), -S(=O)₂(Q₁₁), -N(Q₁₄)(Q₁₅), -B(Q₁₆)(Q₁₇), -P(Q₁₈)(Q₁₉), - P(=O)(Q₁₈)(Q₁₉), -P(=S)(Q₁₈)(Q₁₉), oder eine Kombination davon;
eine C₃-C₁₀-Cycloalkylgruppe, eine C₁-C₁₀-Heterocycloalkylgruppe, eine C₃-C₁₀-Cycloalkenylgruppe, eine C₁-C₁₀-Heterocycloalkenylgruppe, eine C₆-C₆₀-Arylgruppe, eine C₇-C₆₀-Alkylarylgruppe, eine C₆-C₆₀-Aryloxygruppe, eine C₆-C₆₀-Arylthiogruppe, eine C₁-C₆₀-Heteroarylgruppe, eine C₂-C₆₀-Alkylheteroarylgruppe, eine C₁-C₆₀-Heteroaryloxygruppe, eine C₁-C₆₀-Heteroarylthiogruppe, eine monovalente nicht-aromatische kondensierte polycyclische Gruppe oder eine monovalente nicht-aromatische kondensierte heteropolycyclische Gruppe;
eine C₃-C₁₀-Cycloalkylgruppe, eine C₁-C₁₀-Heterocycloalkylgruppe, eine C₃-C₁₀-Cycloalkenylgruppe, eine C₁-C₁₀-Heterocycloalkenylgruppe, eine C₆-C₆₀-Arylgruppe, eine C₇-C₆₀-Alkylarylgruppe, eine C₆-C₆₀-Aryloxygruppe, eine C₆-C₆₀-Arylthiogruppe, eine C₁-C₆₀-Heteroarylgruppe, eine C₂-C₆₀-Alkylheteroarylgruppe, eine C₁-C₆₀-Heteroaryloxygruppe, eine C₁-C₆₀-Heteroarylthiogruppe, eine monovalente nicht-aromatische kondensierte polycyclische Gruppe oder eine monovalente nicht-aromatische kondensierte heteropolycyclische Gruppe, jeweils substituiert mit mindestens einem von Deuterium, -F, -Cl, -Br, -I, -SF₅, -CD₃, -CD₂H, - CDH₂, -CF₃, -CF₂H, -CFH₂, eine Hydroxylgruppe, eine Cyanogruppe, eine Nitrogruppe, eine Aminogruppe, eine Amidinogruppe, eine Hydrazingruppe, eine Hydrazongruppe, eine Carboxylsäuregruppe oder ein Salz davon, eine Sulfonsäuregruppe oder ein Salz davon, eine Phosphorsäuregruppe oder ein Salz davon, eine C₁-C₆₀-Alkylgruppe, eine C₂-C₆₀-Alkenylgruppe, eine C₂-C₆₀-Alkinylgruppe, eine C₁-C₆₀-Alkoxygruppe, eine C₁-C₆₀-Alkylthiogruppe, eine C₃-C₁₀-Cycloalkylgruppe, eine C₁-C₁₀-Heterocycloalkylgruppe, eine C₃-C₁₀-Cycloalkenylgruppe, eine C₁-C₁₀-Heterocycloalkenylgruppe, eine C₆-C₆₀-Arylgruppe, eine C₇-C₆₀-Alkylarylgruppe, eine C₇-C₆₀-Arylalkylgruppe, eine C₆-C₆₀-Aryloxygruppe, eine C₆-C₆₀-Arylthiogruppe, eine C₁-C₆₀-Heteroarylgruppe, eine C₂-C₆₀-Alkylheteroarylgruppe, eine C₂-C₆₀-Heteroarylalkylgruppe, eine C₁-C₆₀-Heteroaryloxygruppe, eine C₁-C₆₀-Heteroarylthiogruppe, eine monovalente nicht-aromatische kondensierte polycyclische Gruppe, eine monovalente nicht-aromatische kondensierte heteropolycyclische Gruppe, -Si(Q₂₁)(Q₂₂)(Q₂₃), -Ge(Q₂₁)(Q₂₂)(Q₂₃), -C(=O)(Q₂₁), - S(=O)(Q₂₁), -S(=O)₂(Q₂₁), -N(Q₂₄)(Q₂₅), -B(Q₂₆)(Q₂₇), -P(Q₂₈)(Q₂₉), -P(=O)(Q₂₈)(Q₂₉), - P(=S)(Q₂₈)(Q₂₉) oder eine Kombination davon; oder
-Si(Q₃₁)(Q₃₂)(Q₃₃), -Ge(Q₃₁)(Q₃₂)(Q₃₃), -C(=O)(Q₃₁), -S(=O)(Q₃₁), -S(=O)₂(Q₃₁), - N(Q₃₄)(Q₃₅), -B(Q₃₆)(Q₃₇), -P(Q₃₈)(Q₃₉), -P(=O)(Q₃₈)(Q₃₉) oder -P(=S)(Q₃₈)(Q₃₉),
wobei Q₁ bis Q₉, Q₁₁ bis Q₁₉, Q₂₁ bis Q₂₉ und Q₃₁ bis Q₃₉ jeweils unabhängig Wasserstoff, Deuterium, -F, -Cl, -Br, -I, -SF₅, eine Hydroxylgruppe, eine Cyanogruppe, eine Nitrogruppe, eine Aminogruppe, eine Amidinogruppe, eine Hydrazingruppe, eine Hydrazongruppe, eine Carboxylsäuregruppe oder ein Salz davon, eine Sulfonsäuregruppe oder ein Salz davon, eine Phosphorsäuregruppe oder ein Salz davon, eine substituierte oder unsubstituierte C₁-C₆₀-Alkylgruppe, eine substituierte oder unsubstituierte C₂-C₆₀-Alkenylgruppe, eine substituierte oder unsubstituierte C₂-C₆₀-Alkinylgruppe, eine substituierte oder unsubstituierte C₁-C₆₀-Alkoxygruppe, eine substituierte oder unsubstituierte C₁-C₆₀-Alkylthiogruppe, eine substituierte oder unsubstituierte C₃-C₁₀-Cycloalkylgruppe, eine substituierte oder unsubstituierte C₁-C₁₀-Heterocycloalkylgruppe, eine substituierte oder unsubstituierte C₃-C₁₀-Cycloalkenylgruppe, eine substituierte oder unsubstituierte C₁-C₁₀-Heterocycloalkenylgruppe, eine substituierte oder unsubstituierte C₆-C₆₀-Arylgruppe, eine substituierte oder unsubstituierte C₇-C₆₀-Alkylarylgruppe, eine substituierte oder unsubstituierte C₇-C₆₀-Arylalkylgruppe, eine substituierte oder unsubstituierte C₆-C₆₀-Aryloxygruppe, eine substituierte oder unsubstituierte C₆-C₆₀-Arylthiogruppe, eine substituierte oder unsubstituierte C₁-C₆₀-Heteroarylgruppe, eine substituierte oder unsubstituierte C₂-C₆₀-Alkylheteroarylgruppe, eine substituierte oder unsubstituierte C₂-C₆₀-Heteroarylalkylgruppe, eine C₁-C₆₀-Heteroaryloxygruppe, eine C₁-C₆₀-Heteroarylthiogruppe, eine substituierte oder unsubstituierte monovalente nicht-aromatische kondensierte polycyclische Gruppe oder eine substituierte oder unsubstituierte monovalente nicht-aromatische kondensierte heteropolycyclische Gruppe sind.

3. Organische lichtemittierende Vorrichtung nach Anspruch 2, wobei M₁ Iridium, Platin, Osmium, Titan, Zirkonium, Hafnium, Europium, Terbium, Thulium oder Rhodium ist;
vorzugsweise, wobei M₁ Iridium ist und eine Summe von n1 und n2 3 ist oder M₁ Platin ist und die Summe von n1 und n2 2 ist.

4. Organische lichtemittierende Vorrichtung nach Anspruch 2 oder 3, wobei Ring CY₁ und Ring CY₂ jeweils unabhängig eine Benzolgruppe, eine Naphthalingruppe, eine 1,2,3,4-Tetrahydronaphthalingruppe, eine Phenanthrengruppe, eine Pyridingruppe, eine Pyrimidingruppe, eine Pyrazingruppe, eine Triazingruppe, eine Chinolingruppe, eine Isochinolingruppe, eine Benzochinolingruppe, eine Benzoisochinolingruppe, eine Furopyridingruppe, eine Benzofuropyridingruppe, eine Thienopyridingruppe, eine Benzothienopyridingruppe, eine Chinoxalingruppe, eine Chinazolingruppe, eine Phenanthrolingruppe, eine Benzofurangruppe, eine Benzothiophengruppe, eine Fluorengruppe, eine Carbazolgruppe, eine Dibenzofurangruppe, eine Dibenzothiophengruppe, eine Dibenzosilolgruppe, eine Azafluorengruppe, eine Azacarbazolgruppe, eine Azadibenzofurangruppe, eine Azadibenzothiophengruppe oder eine Azadibenzosilolgruppe sind; und/oder
wobei R₁₀ und R₂₀ jeweils unabhängig Wasserstoff, Deuterium, -F, eine substituierte oder unsubstituierte C₁-C₂₀-Alkylgruppe, eine substituierte oder unsubstituierte C₃-C₁₀-Cycloalkylgruppe, eine substituierte oder unsubstituierte C₁-C₁₀-Heterocycloalkylgruppe, eine substituierte oder unsubstituierte C₆-C₁₀-Arylgruppe, -Si(Q₁)(Q₂)(Q₃) oder -Ge(Q₁)(Q₂)(Q₃) sind.

5. Organische lichtemittierende Vorrichtung nach einem der Ansprüche 2-4, wobei Ln₁ dargestellt ist durch eine der Formeln 4-1 bis 4-20: 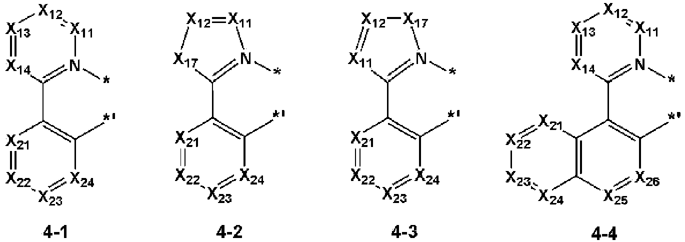 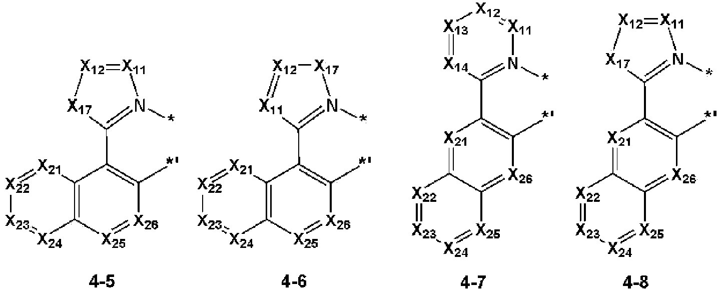 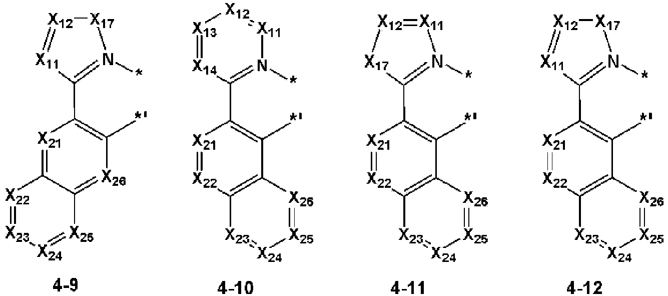 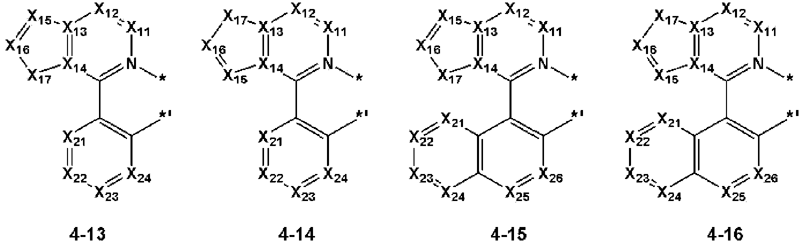 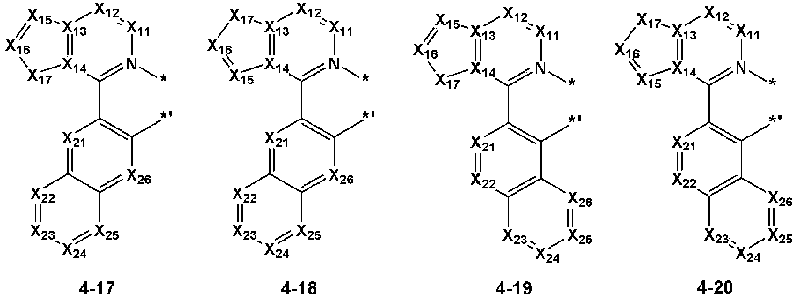
wobei, in Formel 4-1 bis 4-20,
X₁₁ C(R₁₁) oder N ist,
X₁₂ C(R₁₂) oder N ist,
X₁₃ in Formel 4-1 bis 4-12 C(R₁₃) oder N ist und X₁₃ in Formel 4-13 bis 4-20 C ist,
X₁₄ in Formel 4-1 bis 4-12 C(R₁₄) oder N ist und X₁₄ in Formel 4-13 bis 4-20 C ist,
X₁₅ C(R₁₅) oder N ist,
X₁₆ C(R₁₆) oder N ist,
X₁₇ O, S, C(R₁₇)(R₁₈) oder N(R₁₇) ist,
X₂₁ C(T₁), C(R₂₁) oder N ist, X₂₂ C(T₁), C(R₂₂) oder N ist, X₂₃ C(T₁), C(R₂₃) oder N ist,
X₂₄ C(T₁), C(R₂₄) oder N ist, X₂₅ C(T₁), C(R₂₅) oder N ist und X₂₆ C(T₁), C(R₂₆) oder N ist,
R₁₁ bis R₁₈ jeweils wie für R₁₀ in Anspruch 2 definiert sind,
R₂₁ bis R₂₆ jeweils wie für R₂₀ in Anspruch 2 definiert sind,
mindestens eines von X₂₁ bis X₂₄ in Formel 4-1 bis 4-3, 4-13 und 4-14 C(T₁) ist,
mindestens eines von X₂₁ bis X₂₆ in Formel 4-4 bis 4-12 und 4-15 bis 4-20 C(T₁) ist,
mindestens zwei von R₁₁ bis R₁₈, mindestens zwei von R₂₁ bis R₂₆ oder mindestens zwei von R₁₁ bis R₁₈ und R₂₁ bis R₂₆ optional miteinander verbunden sind, um eine carbocyclische C₅₋₃₀-Gruppe, die unsubstituiert oder substituiert ist mit mindestens einem R₁₀ₐ, oder eine heterocyclische C₁-C₃₀-Gruppe, die unsubstituiert oder substituiert ist mit mindestens einem R₁₀ₐ, zu bilden,
R₁₀ₐ wie für R₁₀ in Anspruch 2 definiert ist, und
* und *' jeweils eine Bindungsstelle zu M₁ angeben.

6. Organische lichtemittierende Vorrichtung nach einem der Ansprüche 2-5, wobei Ln₂ dargestellt ist durch mindestens eine der Formeln 2A bis 2C: 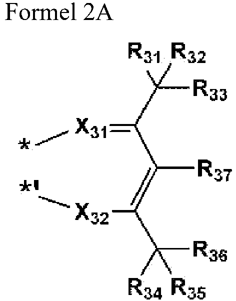 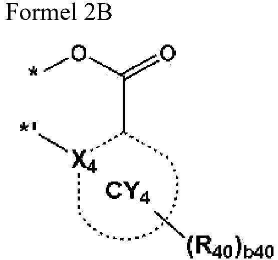 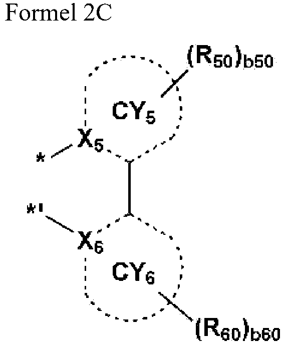
wobei, in Formel 2A bis 2C,
X₃₁ und X₃₂ jeweils unabhängig O oder S sind,
X₄ bis X₆ jeweils unabhängig C oder N sind,
Ring CY₄ bis Ring CY₆ jeweils unabhängig eine carbocyclische C₅-C₃₀-Gruppe oder eine heterocyclische C₁-C₃₀-Gruppe sind,
R₃₁ bis R₃₇, R₄₀, R₅₀ und R₆₀ jeweils unabhängig Wasserstoff, Deuterium, -F, -Cl, -Br, -I, - SF₅, eine Hydroxylgruppe, eine Cyanogruppe, eine Nitrogruppe, eine Aminogruppe, eine Amidinogruppe, eine Hydrazingruppe, eine Hydrazongruppe, eine Carboxylsäuregruppe oder ein Salz davon, eine Sulfonsäuregruppe oder ein Salz davon, eine Phosphorsäuregruppe oder ein Salz davon, eine substituierte oder unsubstituierte C₁-C₆₀-Alkylgruppe, eine substituierte oder unsubstituierte C₂-C₆₀-Alkenylgruppe, eine substituierte oder unsubstituierte C₂-C₆₀-Alkinylgruppe, eine substituierte oder unsubstituierte C₁-C₆₀-Alkoxygruppe, eine substituierte oder unsubstituierte C₁-C₆₀-Alkylthiogruppe, eine substituierte oder unsubstituierte C₃-C₁₀-Cycloalkylgruppe, eine substituierte oder unsubstituierte C₁-C₁₀-Heterocycloalkylgruppe, eine substituierte oder unsubstituierte C₃-C₁₀-Cycloalkenylgruppe, eine substituierte oder unsubstituierte C₁-C₁₀-Heterocycloalkenylgruppe, eine substituierte oder unsubstituierte C₆-C₆₀-Arylgruppe, eine substituierte oder unsubstituierte C₇-C₆₀-Alkylarylgruppe, eine substituierte oder unsubstituierte C₇-C₆₀-Arylalkylgruppe, eine substituierte oder unsubstituierte C₆-C₆₀-Aryloxygruppe, eine substituierte oder unsubstituierte C₆-C₆₀-Arylthiogruppe, eine substituierte oder unsubstituierte C₁-C₆₀-Heteroarylgruppe, eine substituierte oder unsubstituierte C₂-C₆₀-Alkylheteroarylgruppe, eine substituierte oder unsubstituierte C₂-C₆₀-Heteroarylalkylgruppe, eine substituierte oder unsubstituierte C₁-C₆₀-Heteroaryloxygruppe, eine substituierte oder unsubstituierte C₁-C₆₀-Heteroarylthiogruppe, eine substituierte oder unsubstituierte monovalente nicht-aromatische kondensierte polycyclische Gruppe, eine substituierte oder unsubstituierte monovalente nicht-aromatische kondensierte heteropolycyclische Gruppe, -Si(Q₁)(Q₂)(Q₃), - Ge(Q₁)(Q₂)(Q₃), -C(=O)(Q₁), -S(=O)(Q₁), -S(=O)₂(Q₁), -N(Q₄)(Q₅), -B(Q₆)(Q₇), -P(Q₈)(Q₉), - P(=O)(Q₈)(Q₉) oder -P(=S)(Q₈)(Q₉) sind,
zwei oder mehr von R₃₁ bis R₃₇; zwei oder mehr einer Vielzahl von R₄₀; zwei oder mehr einer Vielzahl von R₅₀; zwei oder mehr einer Vielzahl von R₆₀; oder zwei oder mehr von R₅₀ und R₆₀ optional miteinander verbunden sind, um eine carbocyclische C₅-C₃₀-Gruppe, die unsubstituiert oder substituiert ist mit mindestens einem R₁₀ₐ, oder eine heterocyclische C₁-C₃₀-Gruppe, die unsubstituiert oder substituiert ist mit mindestens einem R₁₀ₐ, zu bilden,
R₁₀ₐ wie für R₁₀ in Anspruch 2 definiert ist, und
* und *' jeweils eine Bindungsstelle zu M₁ angeben.

7. Organische lichtemittierende Vorrichtung nach einem der Ansprüche 1-6, wobei die Emissionsschicht ein rotes Licht, ein grünes Licht oder ein blaues Licht emittiert.

8. Organische lichtemittierende Vorrichtung nach einem der Ansprüche 1-7, wobei
die Emissionsschicht einen Wirt und ein Dotierungsmittel umfasst,
das Dotierungsmittel die mindestens eine metallorganische Verbindung umfasst.

9. Organische lichtemittierende Vorrichtung nach einem der Ansprüche 1-8, wobei die n-dotierte Schicht eine Elektronentransportverbindung und ein n-Dotierungsmittel umfasst.

10. Organische lichtemittierende Vorrichtung nach Anspruch 9, wobei die Elektronentransportverbindung eine Cyanogruppe, eine π-Elektronen-arme stickstoffhaltige Ringgruppe, eine Elektronentransporteinheit oder eine Kombination davon umfasst; und/oder
wobei das n-Dotierungsmittel ein Metall umfasst.

11. Organische lichtemittierende Vorrichtung nach einem der Ansprüche 1-10, wobei
die organische Schicht ferner eine Lochtransportregion umfasst, die zwischen der Anode und der Emissionsschicht angeordnet ist, und
die Lochtransportregion eine Locheinspritzschicht, eine Lochtransportschicht, eine Elektronenblockierschicht, eine Pufferschicht oder eine Kombination davon umfasst.

12. Organische lichtemittierende Vorrichtung nach einem der Ansprüche 1-11, wobei die n-dotierte Schicht zwischen der Anode und der Lochtransportregion angeordnet ist.

13. Organische lichtemittierende Vorrichtung nach einem der Ansprüche 1-12, wobei
die organische Schicht ferner eine Elektronentransportregion umfasst, die zwischen der Emissionsschicht und der Kathode angeordnet ist, und
die Elektronentransportregion eine Lochblockierschicht, eine Elektronentransportschicht, eine Elektroneneinspritzschicht oder eine Kombination davon umfasst.

14. Organische lichtemittierende Vorrichtung nach einem der Ansprüche 1-13, wobei die organische Schicht ferner umfasst:
n Emissionseinheiten; und
n-1 Ladungserzeugungseinheiten, die zwischen zwei benachbarten Emissionseinheiten angeordnet sind,
wobei n eine ganze Zahl von 2 oder größer ist, und
mindestens eine der n Emissionseinheiten die mindestens eine metallorganische Verbindung umfasst;
vorzugsweise, wobei
die organische Schicht ferner eine Lochtransportregion umfasst, die zwischen der Anode und der Emissionsschicht angeordnet ist,
die Lochtransportregion eine Locheinspritzschicht, eine Lochtransportschicht, eine Elektronenblockierschicht, eine Pufferschicht oder eine Kombination davon umfasst, und
die n-dotierte Schicht zwischen der Anode und der Lochtransportregion angeordnet ist, oder
mindestens eine der n-1 Ladungserzeugungseinheiten die n-dotierte Schicht umfasst;
vorzugsweise, wobei
die n Emissionseinheiten eine k^{te} Emissionseinheit umfassen, welche die der Anode nächste k^{te} ist, wobei k eine ganze Zahl von 2 bis n ist, und
die k^{te} Emissionseinheit die Emissionsschicht umfasst, die die mindestens eine metallorganische Verbindung umfasst.

15. Elektronische Vorrichtung, umfassend die organische lichtemittierende Vorrichtung nach einem der Ansprüche 1-14.

## Revendications

1. Dispositif électroluminescent organique (10), comprenant :
une anode (11) ;
une cathode (19) ; et
une couche organique (15) agencée entre l'anode et la cathode,
dans lequel la couche organique comprend une couche d'émission et une couche dopée n,
la couche d'émission comprend au moins un composé organométallique, et
l'au moins un composé organométallique comprend au moins un groupe silyle ou au moins un groupe germyle,
**caractérisé en ce que** la couche dopée n est agencée entre l'anode et la couche d'émission.

2. Dispositif électroluminescent organique de la revendication 1, dans lequel le composé organométallique est représenté par la Formule 1 :
Formule 1 M₁(Ln₁)ₙ₁(Ln₂)ₙ₂
où, dans la Formule 1,
M₁ est un métal de transition,
Ln₁ est un ligand représenté par la Formule 1A,
Ln₂ est un ligand organique,
n1 vaut 1, 2 ou 3,
n2 vaut 0, 1 ou 2, 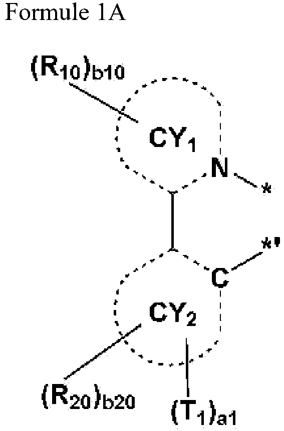
où, dans la Formule 1A,
le cycle CY₁ et le cycle CY₂ sont chacun indépendamment un groupe carbocyclique en C₅-C₃₀ ou un groupe hétérocyclique en C₁-C₃₀,
T₁ est -Si(Q₁)(Q₂)(Q₃) ou -Ge(Q₁)(Q₂)(Q₃),
a1 vaut 1, 2, 3, 4 ou 5,
R₁₀ et R₂₀ sont chacun indépendamment un hydrogène, un deutérium, -F, -Cl, -Br, -I, -SF₅, un groupe hydroxyle, un groupe cyano, un groupe nitro, un groupe amino, un groupe amidino, un groupe hydrazine, un groupe hydrazone, un groupe acide carboxylique ou un sel de celui-ci, un groupe acide sulfonique ou un sel de celui-ci, un groupe acide phosphorique ou un sel de celui-ci, un groupe alkyle en C₁-C₆₀ substitué ou non substitué, un groupe alcényle en C₂-C₆₀ substitué ou non substitué, un groupe alcynyle en C₂-C₆₀ substitué ou non substitué, un groupe alcoxy en C₁-C₆₀ substitué ou non substitué, un groupe alkylthio en C₁-C₆₀ substitué ou non substitué, un groupe cycloalkyle en C₃-C₁₀ substitué ou non substitué, un groupe hétérocycloalkyle en C₁-C₁₀ substitué ou non substitué, un groupe cycloalcényle en C₃-C₁₀ substitué ou non substitué, un groupe hétérocycloalcényle en C₁-C₁₀ substitué ou non substitué, un groupe aryle en C₆-C₆₀ substitué ou non substitué, un groupe alkylaryle en C₇-C₆₀ substitué ou non substitué, un groupe arylalkyle en C₇-C₆₀ substitué ou non substitué, un groupe aryloxy en C₆-C₆₀ substitué ou non substitué, un groupe arylthio en C₆-C₆₀ substitué ou non substitué, un groupe hétéroaryle en C₁-C₆₀ substitué ou non substitué, un groupe alkylhétéroaryle en C₂-C₆₀ substitué ou non substitué, un groupe hétéroarylalkyle en C₂-C₆₀ substitué ou non substitué, un groupe hétéroaryloxy en C₁-C₆₀ substitué ou non substitué, un groupe hétéroarylthio en C₁-C₆₀ substitué ou non substitué, un groupe polycyclique condensé non aromatique monovalent substitué ou non substitué, un groupe hétéropolycyclique condensé non aromatique monovalent substitué ou non substitué, - Si(Q₁)(Q₂)(Q₃), -Ge(Q₁)(Q₂)(Q₃), -C(=O)(Q₁), -S(=O)(Q₁), -S(=O)₂(Q₁), -N(Q₄)(Q₅), -B(Q₆)(Q₇), -P(Q₈)(Q₉), -P(=O)(Q₈)(Q₉) ou -P(=S)(Q₈)(Q₉),
deux d'une pluralité de R₁₀ ou plus sont éventuellement liés ensemble pour former un groupe carbocyclique en C₅-C₃₀ substitué ou non substitué ou un groupe hétérocyclique en C₁-C₃₀ substitué ou non substitué,
deux d'une pluralité de R₂₀ ou plus sont éventuellement liés ensemble pour former un groupe carbocyclique en C₅-C₃₀ substitué ou non substitué ou un groupe hétérocyclique en C₁-C₃₀ substitué ou non substitué,
deux d'une pluralité de R₁₀ et R₂₀ voisins ou plus sont éventuellement liés ensemble pour former un groupe carbocyclique en C₅-C₃₀ substitué ou non substitué ou un groupe hétérocyclique en C₁-C₃₀ substitué ou non substitué,
b10 et b20 valent chacun indépendamment 1, 2, 3, 4, 5, 6, 7, 8, 9 ou 10,
* et *' indiquent chacun un site de liaison à M₁,
au moins un substituant du groupe carbocyclique en C₅-C₃₀ substitué, du groupe hétérocyclique en C₁-C₃₀ substitué, du groupe alkyle en C₁-C₆₀ substitué, du groupe alcényle en C₂-C₆₀ substitué, du groupe alcynyle en C₂-C₆₀ substitué, du groupe alcoxy en C₁-C₆₀ substitué, du groupe alkylthio en C₁-C₆₀ substitué, du groupe cycloalkyle en C₃-C₁₀ substitué, du groupe hétérocycloalkyle en C₁-C₁₀ substitué, du groupe cycloalcényle en C₃-C₁₀ substitué, du groupe hétérocycloalcényle en C₁-C₁₀ substitué, du groupe aryle en C₆-C₆₀ substitué, du groupe alkylaryle en C₇-C₆₀ substitué, du groupe arylalkyle en C₇-C₆₀ substitué, du groupe aryloxy en C₆-C₆₀ substitué, du groupe arylthio en C₆-C₆₀ substitué, du groupe hétéroaryle en C₁-C₆₀ substitué, du groupe alkylhétéroaryle en C₂-C₆₀ substitué, du groupe hétéroarylalkyle en C₂-C₆₀ substitué, du groupe hétéroaryloxy en C₁-C₆₀ substitué, du groupe hétéroarylthio en C₁-C₆₀ substitué, du groupe polycyclique condensé non aromatique monovalent substitué et du groupe hétéropolycyclique condensé non aromatique monovalent substitué est :
un deutérium, -F, -Cl, -Br, -I, -SF₅, -CD₃, -CD₂H, -CDH₂, -CF₃, -CF₂H, -CFH₂, un groupe hydroxyle, un groupe cyano, un groupe nitro, un groupe amino, un groupe amidino, un groupe hydrazine, un groupe hydrazone, un groupe acide carboxylique ou un sel de celui-ci, un groupe acide sulfonique ou un sel de celui-ci, un groupe acide phosphorique ou un sel de celui-ci, un groupe alkyle en C₁-C₆₀, un groupe alcényle en C₂-C₆₀, un groupe alcynyle en C₂-C₆₀, un groupe alcoxy en C₁-C₆₀ ou un groupe alkylthio en C₁-C₆₀ ;
un groupe alkyle en C₁-C₆₀, un groupe alcényle en C₂-C₆₀, un groupe alcynyle en C₂-C₆₀, un groupe alcoxy en C₁-C₆₀, ou un groupe alkylthio en C₁-C₆₀, chacun étant substitué par au moins l'un parmi un deutérium, -F, -Cl, -Br, -I, -SF₅, -CD₃, -CD₂H, -CDH₂, -CF₃, -CF₂H, -CFH₂, un groupe hydroxyle, un groupe cyano, un groupe nitro, un groupe amino, un groupe amidino, un groupe hydrazine, un groupe hydrazone, un groupe acide carboxylique ou un sel de celui-ci, un groupe acide sulfonique ou un sel de celui-ci, un groupe acide phosphorique ou un sel de celui-ci, un groupe cycloalkyle en C₃-C₁₀, un groupe hétérocycloalkyle en C₁-C₁₀, un groupe cycloalcényle en C₃-C₁₀, un groupe hétérocycloalcényle en C₁-C₁₀, un groupe aryle en C₆-C₆₀, un groupe alkylaryle en C₇-C₆₀, un groupe aryloxy en C₆-C₆₀, un groupe arylthio en C₆-C₆₀, un groupe hétéroaryle en C₁-C₆₀, un groupe alkylhétéroaryle en C₂-C₆₀, un groupe hétéroaryloxy en C₁-C₆₀, un groupe hétéroarylthio en C₁-C₆₀, un groupe polycyclique condensé non aromatique monovalent, un groupe hétéropolycyclique condensé non aromatique monovalent, -Si(Q₁₁)(Q₁₂)(Q₁₃), - Ge(Q₁₁)(Q₁₂)(Q₁₃), -C(=O)(Q₁₁), -S(=O)(Q₁₁), -S(=O)₂(Q₁₁), -N(Q₁₄)(Q₁₅), -B(Q₁₆)(Q₁₇), - P(Q₁₈)(Q₁₉), -P(=O)(Q₁₈)(Q₁₉), -P(=S)(Q₁₈)(Q₁₉) ou une combinaison de ceux-ci ;
un groupe cycloalkyle en C₃-C₁₀, un groupe hétérocycloalkyle en C₁-C₁₀, un groupe cycloalcényle en C₃-C₁₀, un groupe hétérocycloalcényle en C₁-C₁₀, un groupe aryle en C₆-C₆₀, un groupe alkylaryle en C₇-C₆₀, un groupe aryloxy en C₆-C₆₀, un groupe arylthio en C₆-C₆₀, un groupe hétéroaryle en C₁-C₆₀, un groupe alkylhétéroaryle en C₂-C₆₀, un groupe hétéroaryloxy en C₁-C₆₀, un groupe hétéroarylthio en C₁-C₆₀, un groupe polycyclique condensé non aromatique monovalent ou un groupe hétéropolycyclique condensé non aromatique monovalent ;
un groupe cycloalkyle en C₃-C₁₀, un groupe hétérocycloalkyle en C₁-C₁₀, un groupe cycloalcényle en C₃-C₁₀, un groupe hétérocycloalcényle en C₁-C₁₀, un groupe aryle en C₆-C₆₀, un groupe alkylaryle en C₇-C₆₀, un groupe aryloxy en C₆-C₆₀, un groupe arylthio en C₆-C₆₀, un groupe hétéroaryle en C₁-C₆₀, un groupe alkylhétéroaryle en C₂-C₆₀, un groupe hétéroaryloxy en C₁-C₆₀, un groupe hétéroarylthio en C₁-C₆₀, un groupe polycyclique condensé non aromatique monovalent ou un groupe hétéropolycyclique condensé non aromatique monovalent, chacun étant substitué par au moins l'un parmi un deutérium, -F, -Cl, -Br, -I, -SF₅, -CD₃, -CD₂H, -CDH₂, -CF₃, -CF₂H, - CFH₂, un groupe hydroxyle, un groupe cyano, un groupe nitro, un groupe amino, un groupe amidino, un groupe hydrazine, un groupe hydrazone, un groupe acide carboxylique ou un sel de celui-ci, un groupe acide sulfonique ou un sel de celui-ci, un groupe acide phosphorique ou un sel de celui-ci, un groupe alkyle en C₁-C₆₀, un groupe alcényle en C₂-C₆₀, un groupe alcynyle en C₂-C₆₀, un groupe alcoxy en C₁-C₆₀, un groupe alkylthio en C₁-C₆₀, un groupe cycloalkyle en C₃-C₁₀, un groupe hétérocycloalkyle en C₁-C₁₀, un groupe cycloalcényle en C₃-C₁₀, un groupe hétérocycloalcényle en C₁-C₁₀, un groupe aryle en C₆-C₆₀, un groupe alkylaryle en C₇-C₆₀, un groupe arylalkyle en C₇-C₆₀, un groupe aryloxy en C₆-C₆₀, un groupe arylthio en C₆-C₆₀, un groupe hétéroaryle en C₁-C₆₀, un groupe alkylhétéroaryle en C₂-C₆₀, un groupe hétéroarylalkyle en C₂-C₆₀, un groupe hétéroaryloxy en C₁-C₆₀, un groupe hétéroarylthio en C₁-C₆₀, un groupe polycyclique condensé non aromatique monovalent, un groupe hétéropolycyclique condensé non aromatique monovalent, -Si(Q₂₁)(Q₂₂)(Q₂₃), -Ge(Q₂₁)(Q₂₂)(Q₂₃), -C(=O)(Q₂₁), -S(=O)(Q₂₁), - S(=O)₂(Q₂₁), -N(Q₂₄)(Q₂₅), -B(Q₂₆)(Q₂₇), -P(Q₂₈)(Q₂₉), -P(=O)(Q₂₈)(Q₂₉), -P(=S)(Q₂₈)(Q₂₉) ou une combinaison de ceux-ci ; ou
-Si(Q₃₁)(Q₃₂)(Q₃₃), -Ge(Q₃₁)(Q₃₂)(Q₃₃), -C(=O)(Q₃₁), -S(=O)(Q₃₁), -S(=O)₂(Q₃₁), - N(Q₃₄)(Q₃₅), -B(Q₃₆)(Q₃₇), -P(Q₃₈)(Q₃₉), -P(=O)(Q₃₈)(Q₃₉) ou -P(=S)(Q₃₈)(Q₃₉),
où Q₁ à Q₉, Q₁₁ à Q₁₉, Q₂₁ à Q₂₉ et Q₃₁ à Q₃₉ sont chacun indépendamment un hydrogène, un deutérium, -F, -Cl, -Br, -I, -SF₅, un groupe hydroxyle, un groupe cyano, un groupe nitro, un groupe amino, un groupe amidino, un groupe hydrazine, un groupe hydrazone, un groupe acide carboxylique ou un sel de celui-ci, un groupe acide sulfonique ou un sel de celui-ci, un groupe acide phosphorique ou un sel de celui-ci, un groupe alkyle en C₁-C₆₀ substitué ou non substitué, un groupe alcényle en C₂-C₆₀ substitué ou non substitué, un groupe alcynyle en C₂-C₆₀ substitué ou non substitué, un groupe alcoxy en C₁-C₆₀ substitué ou non substitué, un groupe alkylthio en C₁-C₆₀ substitué ou non substitué, un groupe cycloalkyle en C₃-C₁₀ substitué ou non substitué, un groupe hétérocycloalkyle en C₁-C₁₀ substitué ou non substitué, un groupe cycloalcényle en C₃-C₁₀ substitué ou non substitué, un groupe hétérocycloalcényle en C₁-C₁₀ substitué ou non substitué, un groupe aryle en C₆-C₆₀ substitué ou non substitué, un groupe alkylaryle en C₇-C₆₀ substitué ou non substitué, un groupe arylalkyle en C₇-C₆₀ substitué ou non substitué, un groupe aryloxy en C₆-C₆₀ substitué ou non substitué, un groupe arylthio en C₆-C₆₀ substitué ou non substitué, un groupe hétéroaryle en C₁-C₆₀ substitué ou non substitué, un groupe alkylhétéroaryle en C₂-C₆₀ substitué ou non substitué, un groupe hétéroarylalkyle en C₂-C₆₀ substitué ou non substitué, un groupe hétéroaryloxy en C₁-C₆₀, un groupe hétéroarylthio en C₁-C₆₀, un groupe polycyclique condensé non aromatique monovalent substitué ou non substitué ou un groupe hétéropolycyclique condensé non aromatique monovalent substitué ou non substitué.

3. Dispositif électroluminescent organique de la revendication 2, dans lequel M₁ est l'iridium, le platine, l'osmium, le titane, le zirconium, le hafnium, l'europium, le terbium, le thulium ou le rhodium ;
de préférence, dans lequel M₁ est l'iridium, et une somme de n1 et n2 vaut 3, ou M₁ est le platine, et la somme de n1 et n2 vaut 2.

4. Dispositif électroluminescent organique des revendications 2 ou 3, dans lequel le cycle CY₁ et le cycle CY₂ sont chacun indépendamment un groupe benzène, un groupe naphtalène, un groupe 1,2,3,4-tétrahydronaphtalène, un groupe phénanthrène, un groupe pyridine, un groupe pyrimidine, un groupe pyrazine, un groupe triazine, un groupe quinoléine, un groupe isoquinoléine, un groupe benzoquinoléine, un groupe benzoisoquinoléine, un groupe furopyridine, un groupe benzofuropyridine, un groupe thiénopyridine, un groupe benzothiénopyridine, un groupe quinoxaline, un groupe quinazoline, un groupe phénanthroline, un groupe benzofurane, un groupe benzothiophène, un groupe fluorène, un groupe carbazole, un groupe dibenzofurane, un groupe dibenzothiophène, un groupe dibenzosilole, un groupe azafluorène, un groupe azacarbazole, un groupe azadibenzofurane, un groupe azadibenzothiophène ou un groupe azadibenzosilole ; et/ou
où R₁₀ et R₂₀ sont chacun indépendamment un hydrogène, un deutérium, -F, un groupe alkyle en C₁-C₂₀ substitué ou non substitué, un groupe cycloalkyle en C₃-C₁₀ substitué ou non substitué, un groupe hétérocycloalkyle en C₁-C₁₀ substitué ou non substitué, un groupe aryle en C₆-C₁₀ substitué ou non substitué, -Si(Q₁)(Q₂)(Q₃) ou -Ge(Q₁)(Q₂)(Q₃).

5. Dispositif électroluminescent organique de l'une quelconque des revendications 2 à 4, dans lequel Ln₁ est représenté par l'une des Formules 4-1 à 4-20 : 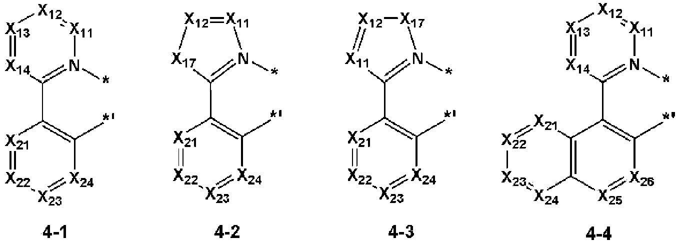 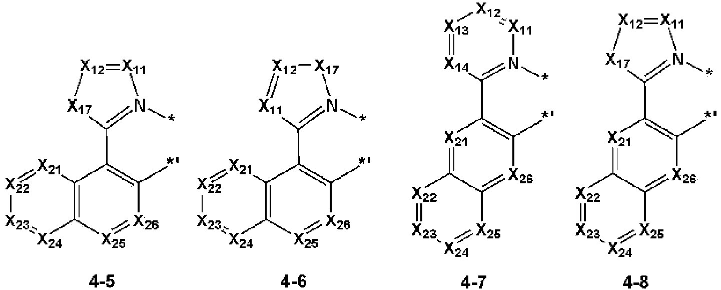 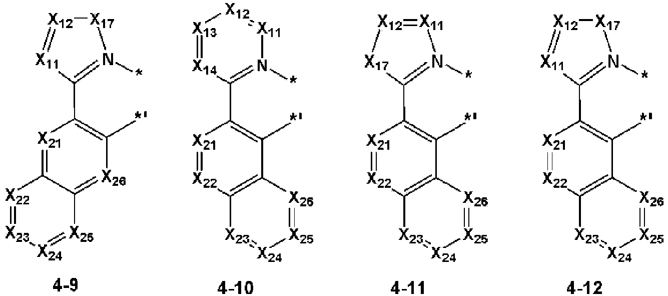 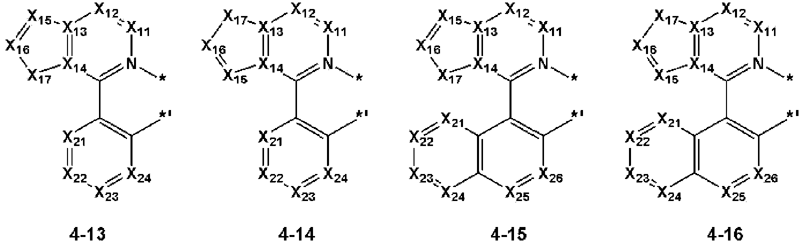 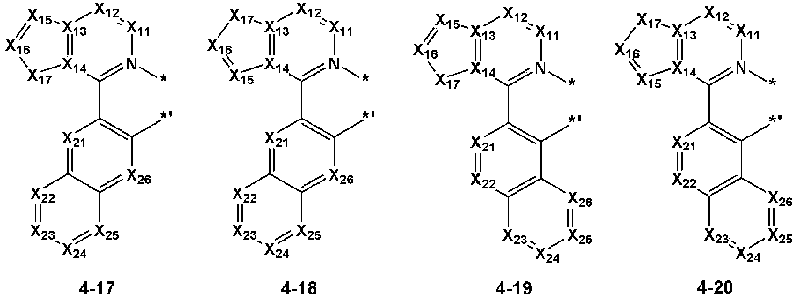 où, dans les Formules 4-1 à 4-20,
X₁₁ est C(R₁₁) ou N,
X₁₂ est C(R₁₂) ou N,
X₁₃ dans les Formules 4-1 à 4-12 est C(R₁₃) ou N, et X₁₃ dans les Formules 4-13 à 4-20 est C,
X₁₄ dans les Formules 4-1 à 4-12 est C(R₁₄) ou N, et X₁₄ dans les Formules 4-13 à 4-20 est C,
X₁₅ est C(R₁₅) ou N,
X₁₆ est C(R₁₆) ou N,
X₁₇ est O, S, C(R₁₇)(R₁₈), ou N(R₁₇),
X₂₁ est C(T₁), C(R₂₁), ou N, X₂₂ est C(T₁), C(R₂₂), ou N, X₂₃ est C(T₁), C(R₂₃), ou N, X₂₄ est C(T₁), C(R₂₄), ou N, X₂₅ est C(T₁), C(R₂₅), ou N, et X₂₆ est C(T₁), C(R₂₆), ou N,
R₁₁ à R₁₈ sont chacun définis comme pour R₁₀ dans la revendication 2,
R₂₁ à R₂₆ sont chacun définis comme pour R₂₀ dans la revendication 2,
au moins l'un de X₂₁ à X₂₄ dans les Formules 4-1 à 4-3, 4-13 et 4-14 est C(T₁),
au moins l'un de X₂₁ à X₂₆ dans les Formules 4-4 à 4-12 et 4-15 à 4-20 est C(T₁),
au moins deux de R₁₁ à R₁₃, au moins deux de R₂₁ à R₂₆ ou au moins deux de R₁₁ à R₁₈ et R₂₁ à R₂₆ sont éventuellement liés ensemble pour former un groupe carbocyclique en C₅-C₃₀ qui est non substitué ou substitué par au moins un R₁₀ₐ ou un groupe hétérocyclique en C₁-C₃₀ qui est non substitué ou substitué par au moins un R₁₀ₐ,
R₁₀ₐ est défini comme pour R₁₀ dans la revendication 2, et
* et *' indiquent chacun un site de liaison à M₁.

6. Dispositif électroluminescent organique de l'une quelconque des revendications 2 à 5, dans lequel Ln₂ est représenté par au moins l'une des Formules 2A à 2C : 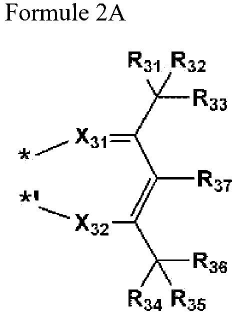 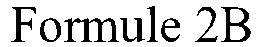 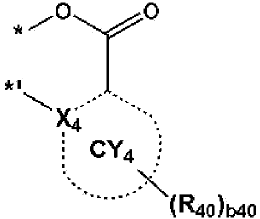 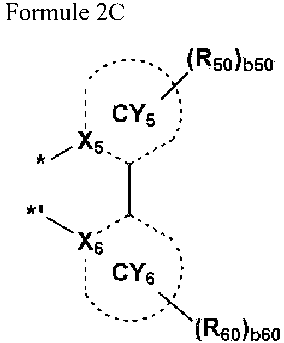 où, dans les Formules 2A à 2C,
X₃₁ et X₃₂ sont chacun indépendamment O ou S,
X₄ à X₆ sont chacun indépendamment C ou N,
les cycles CY₄ à CY₆ sont chacun indépendamment un groupe carbocyclique en C₅-C₃₀ ou un groupe hétérocyclique en C₁-C₃₀,
R₃₁ à R₃₇, R₄₀, R₅₀ et R₆₀ sont chacun indépendamment un hydrogène, un deutérium, -F, - Cl, -Br, -I, -SF₅, un groupe hydroxyle, un groupe cyano, un groupe nitro, un groupe amino, un groupe amidino, un groupe hydrazine, un groupe hydrazone, un groupe acide carboxylique ou un sel de celui-ci, un groupe acide sulfonique ou un sel de celui-ci, un groupe acide phosphorique ou un sel de celui-ci, un groupe alkyle en C₁-C₆₀ substitué ou non substitué, un groupe alcényle en C₂-C₆₀ substitué ou non substitué, un groupe alcynyle en C₂-C₆₀ substitué ou non substitué, un groupe alcoxy en C₁-C₆₀ substitué ou non substitué, un groupe alkylthio en C₁-C₆₀ substitué ou non substitué, un groupe cycloalkyle en C₃-C₁₀ substitué ou non substitué, un groupe hétérocycloalkyle en C₁-C₁₀ substitué ou non substitué, un groupe cycloalcényle en C₃-C₁₀ substitué ou non substitué, un groupe hétérocycloalcényle en C₁-C₁₀ substitué ou non substitué, un groupe aryle en C₆-C₆₀ substitué ou non substitué, un groupe alkylaryle en C₇-C₆₀ substitué ou non substitué, un groupe arylalkyle en C₇-C₆₀ substitué ou non substitué, un groupe aryloxy en C₆-C₆₀ substitué ou non substitué, un groupe arylthio en C₆-C₆₀ substitué ou non substitué, un groupe hétéroaryle en C₁-C₆₀ substitué ou non substitué, un groupe alkylhétéroaryle en C₂-C₆₀ substitué ou non substitué, un groupe hétéroarylalkyle en C₂-C₆₀ substitué ou non substitué, un groupe hétéroaryloxy en C₁-C₆₀ substitué ou non substitué, un groupe hétéroarylthio en C₁-C₆₀ substitué ou non substitué, un groupe polycyclique condensé non aromatique monovalent substitué ou non substitué, un groupe hétéropolycyclique condensé non aromatique monovalent substitué ou non substitué, -Si(Q₁)(Q₂)(Q₃), -Ge(Q₁)(Q₂)(Q₃), -C(=O)(Q₁), -S(=O)(Q₁), -S(=O)₂(Q₁), -N(Q₄)(Q₅), - B(Q₆)(Q₇), -P(Q₈)(Q₉), -P(=O)(Q₈)(Q₉) ou -P(=S)(Q₈)(Q₉),
deux de R₃₁ à R₃₇ ou plus ; deux d'une pluralité de R₄₀ ou plus ; deux d'une pluralité de R₅₀ ou plus ; deux d'une pluralité de R₆₀ ou plus ; ou deux de R₅₀ et R₆₀ ou plus sont éventuellement liés ensemble pour former un groupe carbocyclique en C₅-C₃₀ qui est non substitué ou substitué par au moins un R₁₀ₐ ou un groupe hétérocyclique en C₁-C₃₀ qui est non substitué ou substitué par au moins un R₁₀ₐ,
R₁₀ₐ est défini comme pour R₁₀ dans la revendication 2, et
* et *' indiquent chacun un site de liaison à M₁.

7. Dispositif électroluminescent organique de l'une quelconque des revendications 1 à 6, dans lequel la couche d'émission émet une lumière rouge, une lumière verte ou une lumière bleue.

8. Dispositif électroluminescent organique de l'une quelconque des revendications 1 à 7, dans
lequel la couche d'émission comprend un hôte et un dopant, et
le dopant comprend l'au moins un composé organométallique.

9. Dispositif électroluminescent organique de l'une quelconque des revendications 1 à 8, dans lequel la couche dopée n comprend un composé de transport d'électrons et un dopant n.

10. Dispositif électroluminescent organique de la revendication 9, dans lequel le composé de transport d'électrons comprend un groupe cyano, un groupe cyclique contenant de l'azote déficient en électrons π, un fragment de transport d'électrons, ou une combinaison de ceux-ci ; et/ou dans lequel le dopant n comprend un métal.

11. Dispositif électroluminescent organique de l'une quelconque des revendications 1 à 10, dans lequel
la couche organique comprend en outre une région de transport de trous agencée entre l'anode et la couche d'émission, et
la région de transport de trous comprend une couche d'injection de trous, une couche de transport de trous, une couche de blocage d'électrons, une couche tampon ou une combinaison de celles-ci.

12. Dispositif électroluminescent organique de l'une quelconque des revendications 1 à 11, dans lequel la couche dopée n est agencée entre l'anode et la région de transport de trous.

13. Dispositif électroluminescent organique de l'une quelconque des revendications 1 à 12, dans lequel
la couche organique comprend en outre une région de transport d'électrons agencée entre la couche d'émission et la cathode, et
la région de transport d'électrons comprend une couche de blocage de trous, une couche de transport d'électrons, une couche d'injection d'électrons ou une combinaison de celles-ci.

14. Dispositif électroluminescent organique de l'une quelconque des revendications 1 à 13, dans lequel la couche organique comprend en outre :
n unités d'émission ; et
n-1 unités de génération de charge agencées entre deux unités d'émission voisines,
dans lequel n est un nombre entier de 2 ou plus, et
au moins l'une des n unités d'émission comprend l'au moins un composé organométallique ;
de préférence dans lequel
la couche organique comprend en outre une région de transport de trous agencée entre l'anode et la couche d'émission,
la région de transport de trous comprend une couche d'injection de trous, une couche de transport de trous, une couche de blocage d'électrons, une couche tampon, ou une combinaison de celles-ci, et
la couche dopée n est agencée entre l'anode et la région de transport de trous, ou
au moins l'une des n-1 unités de génération de charge comprend la couche dopée n ;
de préférence, dans lequel
les n unités d'émission comprennent une k^{ième} unité d'émission qui est la k^{ième} la plus proche de l'anode, où k est un nombre entier de 2 à n, et
la k^{ième} unité d'émission comprend la couche d'émission comprenant l'au moins un composé organométallique.

15. Appareil électronique, comprenant le dispositif électroluminescent organique de l'une quelconque des revendications 1 à 14.
